# EUROPEAN PATENT APPLICATION

(11) **EP 4 716 439 A1**
(43) Date of publication of application: **25.03.2026**
(21) Application number: 25200813.1
(22) Date of filing: 08.09.2025
(51) Int. Cl.: H10K 77/10

(54) **DISPLAY DEVICE, ELECTRONIC DEVICE INCLUDING THE SAME AND METHOD OF MANUFACTURING DISPLAY DEVICE**

(30) Priority: 20.09.2024 KR 20240127127
(71) Applicant: Samsung Display Co., Ltd., Yongin-si, Gyeonggi-do 17113 (KR)
(72) Inventor: KIM, Myung Hwan, 17113 Giheung-gu, Yongin-si, Gyeonggi-do (KR); SHIN, Se Joong, 17113 Giheung-gu, Yongin-si, Gyeonggi-do (KR); CHO, Se Hyung, 17113 Giheung-gu, Yongin-si, Gyeonggi-do (KR)
(74) Representative: Dr. Weitzel & Partner

(57) **Abstract**

A display device includes a display panel (100) including a first area (A1), a second area (A2), and a third area (A3) disposed between the first area (A1) and the second area (A2), a pixel disposed (PX) on a second surface (102) of the display panel (100) in a display area (DA) included in the first area (A1), a pad (PD) disposed on the second surface (102) of the display panel (100) in the second area (A2), a first circuit board (FPCB) connected to the pad (PD), a first hole (H1) penetrating through the display panel (100) in the display area (DA), and a support layer (400) disposed on a first surface (101) of the display panel (100). The support layer (400) is exclusively disposed on the first surface (101) of the display panel (100) in the second area (A2) of the first to third areas.

## Description

The invention relates to a display device, and more particularly, to a display device advantageous for bending work of a display panel and capable of being slimmed, an electronic device, and a method of manufacturing a display device.

As the information society develops, the demand for display devices for displaying images is being increased and diversified. For example, display devices are being applied to various electronic devices such as smartphones, digital cameras, laptop computers, navigation devices, and smart televisions.

As the display devices, various types of display devices such as liquid crystal displays ("LCDs") and organic light-emitting displays ("OLEDs") are being used. Among the display devices, an organic light-emitting display displays an image using organic light-emitting diodes generating light by recombination of electrons and holes. The organic light-emitting display includes a plurality of transistors providing driving currents to the organic light-emitting diodes.

Recently, various attempts to minimize a thickness of a display device in order to make the display device lighter are being made.

Features of the invention provide a display device advantageous for bending work of a display panel and capable of being slimmed, an electronic device, and a method of manufacturing a display device. The invention is described by the features of the independent claims. The dependent claims and the description provide preferred embodiments.

In an embodiment of the invention, there is provided a display device including a display panel including a first area, a second area, and a third area disposed between the first area and the second area, a pixel disposed on a second surface of the display panel in a display area included in the first area, a pad disposed on the second surface of the display panel in the second area, a first circuit board connected to the pad, a first hole penetrating through the display panel in the display area, and a support layer disposed on a first surface of the display panel. The support layer is selectively disposed on the first surface of the display panel in the second area of the first to third areas. This means that the support layer is only or exclusively disposed on the first surface of the display panel in the second area of the first to third areas.

According to an embodiment of the invention, a display device comprises a display panel including a first surface, a second surface opposite to the first surface, a display panel side surface extending to the first surface and the second surface, and a base substrate including a first area including a display area, a second area; and a third area disposed between the first area and the second area. The display device further comprises a pixel disposed on the second surface of the display panel in the display area of the first area, a pad disposed on the second surface of the display panel in the second area, a first circuit board connected to the pad, the first circuit board including a first circuit board surface, a support layer disposed on the first surface of the display panel, the support layer including a support layer side surface. The display device further comprises a board cover disposed on the display panel side surface of the display panel, the support layer side surface of the support layer, and the first circuit board surface of the first circuit board, wherein the support layer is disposed on the first surface of the display panel in the second area of the first to third areas, and the board cover extends downward more than the support layer.

A first hole may be defined through the display panel in the display area.

The support layer may not overlap the first area and the third area. If the support layer does not overlap the first area, it consequently does not overlap the display area of the first area, and the first hole of the display area.

In an embodiment of the invention, there is provided an electronic device including a lower cover, a cover window disposed on the lower cover, and a display device disposed between the lower cover and the cover window. The display device may be a display device according to at least one of the embodiments as disclosed herein. The display device includes a display panel including a first area, a second area, and a third area disposed between the first area and the second area, a pixel disposed on a second surface of the display panel in a display area included in the first area, a pad disposed on the second surface of the display panel in the second area, a first circuit board connected to the pad, a first hole penetrating through the display panel in the display area, and a support layer disposed on a first surface of the display panel, and the support layer is selectively, that is exclusively, disposed on the first surface of the display panel in the second area of the first to third areas.

In an embodiment of the invention, there is provided a method of manufacturing a display device, e.g. according to at least one of the embodiments as disclosed herein, the method including preparing a mother substrate including a plurality of display areas and a plurality of pad areas, cutting the mother substrate to prepare a display cell including a first display area, a first pad area, a first area where the first display area is disposed, a second area where the first pad area of the plurality of pad areas is disposed, and a third area disposed between the first area and the second area, performing a driving test of the display cell using a plurality of pads of the first pad area of the display cell, cutting a portion of the second area of the display cell including a pad area of the plurality of pad areas so that connection between the plurality of pads of the first pad area is separated, preparing a reinforcing film including a base layer, a common bonding layer disposed on the base layer, a first support layer and a second support layer disposed to be separated from each other on the common bonding layer and bonded to the common bonding layer with different adhesive strengths from each other, and a first bonding layer and a second bonding layer disposed on the first support layer and the second support layer, respectively, and having different adhesive strengths from each other, attaching the reinforcing film to a first surface of the display cell so that the first bonding layer and the second bonding layer are disposed to correspond to the first area and the second area of the display cell, respectively, forming a first circuit board, a second circuit board, a driving chip, a first reinforcing layer, and a polarizing plate on the display cell, forming a board cover on a side surface of the reinforcing film, a first surface of the base layer of the reinforcing film, a side surface of the display cell, and a first surface of the first circuit board, cutting the display cell along a preset processing line to form a display panel, the display cell including the reinforcing film, the first circuit board, the second circuit board, the driving chip, the first reinforcing layer, the board cover, and the polarizing plate, and separating the reinforcing film from the display panel. In the separating the reinforcing film from the display panel, only the base layer, the common bonding layer, the first support layer, and the first bonding layer of the reinforcing film are separated from the display panel, and the second support layer and the second bonding layer of the reinforcing film are not separated from the display panel and remain in the second area of the display panel.

In an embodiment of the invention, there is provided a method of manufacturing a display device, e.g. according to at least one of the embodiments as disclosed herein, the method including preparing a mother substrate including a plurality of display areas and a plurality of pad areas, preparing a base reinforcing film including a support layer and a first bonding layer, a second bonding layer, and a third bonding layer disposed on the support layer and having different adhesive strengths from each other, attaching the base reinforcing film to a first surface of the mother substrate so that the first bonding layer, the second bonding layer, and the third bonding layer are disposed to correspond to a first area, a second area, and a third area of each display cell of the mother substrate, respectively, cutting the mother substrate including the base reinforcing film to prepare a first display cell including a first display area, a first pad area, the first area where the first display area is disposed, the second area where the first pad area is disposed, and the third area disposed between the first area and the second area and a unit reinforcing film separated from a cut base reinforcing film and attached to a first surface of the first display cell, performing a driving test of the display cell using a plurality of pads of the first pad area of the first display cell, cutting a portion of the second area of the first display cell including the pad area and the unit reinforcing film so that connection between the plurality of pads of the first pad area is separated, forming a first circuit board, a second circuit board, a driving chip, a first reinforcing layer, and a polarizing plate on the display cell, forming a board cover on a side surface of the unit reinforcing film, a first surface of the support layer of the unit reinforcing film, a side surface of the display cell, and a first surface of the first circuit board, cutting the display cell along a preset processing line to form a display panel, the display cell including the unit reinforcing film, the first circuit board, the second circuit board, the driving chip, the first reinforcing layer, the board cover, and the polarizing plate, cutting the unit reinforcing film in a half-cut manner so that the support layer corresponding to an interface between a second area and a third area of the display panel is completely separated and the third bonding layer corresponding to the interface between the second area and the third area of the display panel is partially separated, and separating the unit reinforcing film from the display panel. In the cutting the unit reinforcing film in the half-cut manner, the support layer is separated into a first support layer disposed in the first area and the third area and a second support layer disposed in the second area, based on the interface between the second area and the third area, in the cutting the unit reinforcing film in the half-cut manner, a portion corresponding to a partial thickness of a total thickness of the third bonding layer is removed and a portion corresponding to the remaining thickness of the total thickness of the third bonding layer remains, at the interface between the second area and the third area, and in the separating the unit reinforcing film from the display panel, the first support layer, the first bonding layer, and a portion of the third bonding layer of the unit reinforcing film are selectively (exclusively) separated, and the second support layer and a remaining (the other) portion of the third bonding layer of the unit reinforcing film are not separated from the display panel and remain in the second area of the display panel.

In an embodiment, a display device is advantageous for bending work of a display panel, and may be slimed.

For example, in an embodiment, a support layer and a bonding layer are disposed only in a second area of the display panel. Accordingly, when the display panel is bent, a bending area may have a shape more similar to a curved line by the support layer of the second area. Accordingly, a curvature of the bending area may become smaller by the support layer of the second area, such that it is possible to make the display device slim.

In addition, since the bending area of the display panel is supported by the support layer, the bending work of the display panel may become easier.

Further, since the bending area of the display panel is supported by the support layer, even though the curvature of the bending area becomes small, damage to the display panel may be prevented.

In addition, in an embodiment, the support layer and the bonding layer described above are not disposed in a first area of the display panel. Accordingly, a thickness of the display device in the first area may be reduced. Accordingly, an extra space between the display device and a lower cover may be sufficiently secured. A space in which a battery is to be disposed may be sufficiently secured through such an extra space. In an alternative embodiment, a great battery with a greater capacity may be disposed (e.g., mounted) through such an extra space.

The effects of the invention are not limited to the above-described effects and other effects which are not described herein will become apparent to those skilled in the art from the following description.

The above and other advantages and features of the invention will become more apparent by describing in detail embodiments thereof with reference to the attached drawings, in which:
FIG. 1 is a perspective view of an embodiment of a display device;
FIG. 2 is a plan view of the display device illustrated in FIG. 1;
FIG. 3 is a rear view of the display device illustrated in FIG. 1;
FIG. 4 is a rear view illustrating a display panel in the display device of FIG. 3;
FIG. 5 is a schematic cross-sectional view illustrating a structure of the display panel;
FIG. 6 is an enlarged cross-sectional view of a stacked structure of the display panel of FIG. 5;
FIG. 7 is a cross-sectional view taken along line X1-X1' of FIG. 2;
FIG. 8 is a cross-sectional view taken along line X2-X2' of FIG. 2;
FIG. 9 is an enlarged view of area B1 of FIG. 7;
FIG. 10 is an enlarged view of an embodiment of area B2 of FIG. 7 in the display device;
FIG. 11 is an enlarged view of another embodiment of area B2 of FIG. 7 in a display device;
FIG. 12 is an enlarged view of another embodiment of area B2 of FIG. 7 in a display device;
FIG. 13 is an enlarged view of another embodiment of area B2 of FIG. 7 in a display device;
FIG. 14 is an enlarged view of another embodiment of area B2 of FIG. 7 in a display device;
FIG. 15 is a cross-sectional view illustrating a state in which the display device of FIG. 7 is bent;
FIGS. 16 to 33 are cross-sectional views for describing an embodiment of processes of a method of manufacturing the display device;
FIGS. 34 to 51 are cross-sectional views for describing another embodiment of processes of a method of manufacturing a display device;
FIG. 52 is a view for describing another embodiment of a method of manufacturing a display device;
FIG. 53 is a view for describing an embodiment of a shape of a dummy layer by a peeling process after a process of FIG. 52;
FIG. 54 is a view for describing a shape of another embodiment of a dummy layer by a peeling process after a process of FIG. 52;
FIG. 55 is a view for describing a shape of another embodiment of a dummy layer by a peeling process after a process of FIG. 52;
FIG. 56 is a cross-sectional view of an embodiment of an electronic device;
FIG. 57 is a perspective view illustrating an embodiment of an unfolded state of a display device;
FIG. 58 is a perspective view illustrating an embodiment of a folded state of the display device;
FIG. 59 is a perspective view illustrating another embodiment of an unfolded state of a display device; and
FIG. 60 is a perspective view illustrating another embodiment of a folded state of the display device.
FIG. 61 is a block diagram of an embodiment of an electronic device.
FIGS. 62, 63 and 64 are schematic diagrams of electronic devices according to various embodiments.

The invention will now be described more fully hereinafter with reference to the accompanying drawings, in which preferred embodiments of the invention are shown. This invention may, however, be embodied in different forms and should not be construed as limited to the embodiments set forth herein. Rather, these embodiments are provided so that this disclosure will be thorough and complete, and will fully convey the scope of the invention to those skilled in the art.

It will also be understood that when a layer is referred to as being "on" another layer or substrate, it may be directly on the other layer or substrate, or intervening layers may also be present. The same reference numbers indicate the same components throughout the specification. In the attached drawing figures, the thickness of layers and regions is exaggerated for clarity.

Although the terms "first", "second", etc. may be used herein to describe various elements, these elements, should not be limited by these terms. These terms may be used to distinguish one element from another element. Thus, a first element discussed below may be termed a second element without departing from teachings of embodiments. The description of an element as a "first" element may not require or imply the presence of a second element or other elements. The terms "first", "second", etc. may also be used herein to differentiate different categories or sets of elements. For conciseness, the terms "first", "second", etc. may represent "first-category (or first-set)", "second-category (or second-set)", etc., respectively.

Features of various embodiments of the invention may be combined partially or totally. As will be clearly appreciated by those skilled in the art, technically various interactions and operations are possible. Various embodiments may be practiced individually or in combination.

Hereinafter, predetermined embodiments will be described with reference to the accompanying drawings.

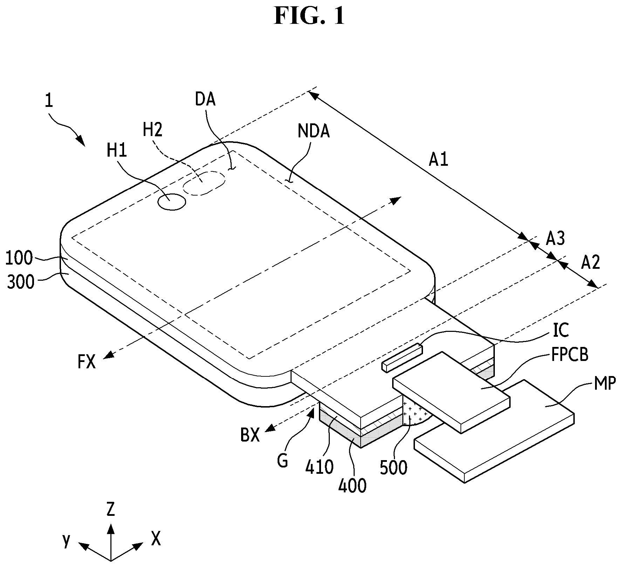

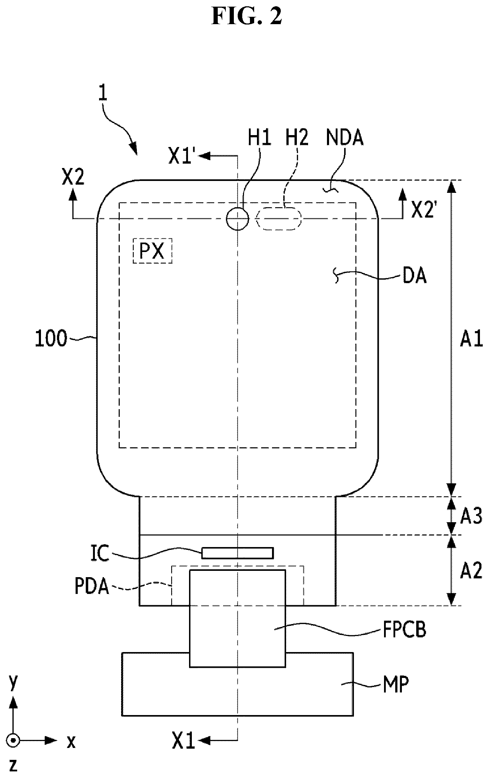

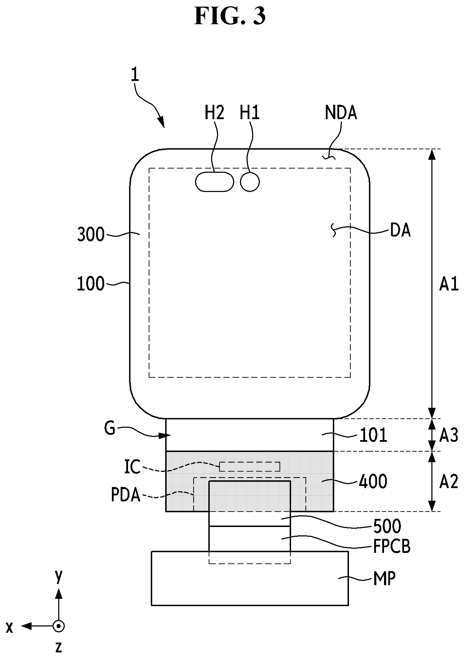

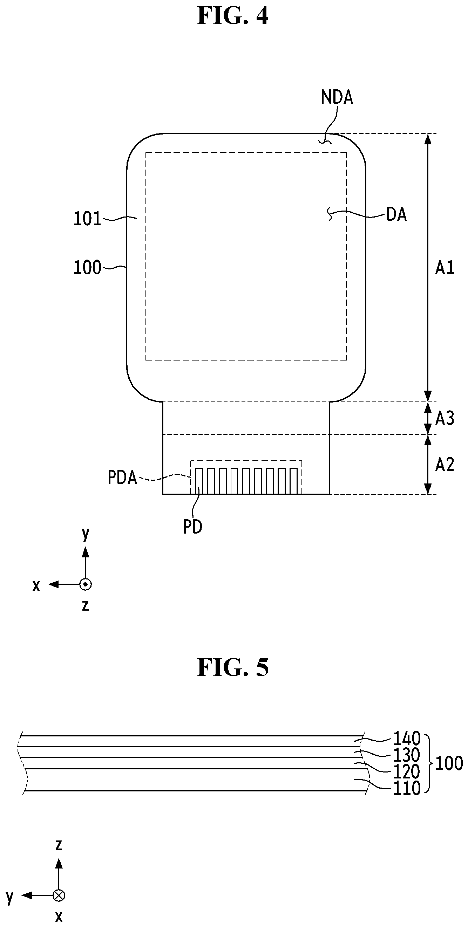

FIG. 1 is a perspective view of an embodiment of a display device, FIG. 2 is a plan view of the display device illustrated in FIG. 1, FIG. 3 is a rear view of the display device illustrated in FIG. 1, and FIG. 4 is a rear view illustrating a display panel in the display device of FIG. 3. Here, the display device before being bent or folded has been illustrated in FIGS. 1 to 4.

A display device 1 may be applied to a portable terminal or the like. The portable terminal may include tablet personal computers, smartphones, personal digital assistants (PDAs), portable multimedia players ("PMPs"), game machines, wrist watch-type electronic devices, or the like. However, the invention is not limited to a predetermined type of the display device 1. In an embodiment, in another embodiment of the invention, the display device 1 may be used in relatively small and medium electronic apparatuses such as personal computers, laptop computers, automobile navigation devices, and cameras as well as relatively large electronic apparatuses such as televisions or external billboards, for example.

The display device 1 may include a display panel 100 having a quadrangular shape, e.g., rectangular shape in an embodiment.

The display panel 100 has a quadrangular shape, e.g., rectangular shape in a plan view, and may include two short sides, two long sides, and a quadrangular, e.g., rectangular plate surface formed by each of the short sides and the long sides.

It has been illustrated that a corner where the long side and the short side of the display panel 100 meet is right-angled and the display panel 100 has the quadrangular shape, e.g., rectangular shape in a plan view, but the invention is not limited thereto. The corner of the display panel 100 may be curved, and the display panel 100 may have various shapes such as a circular shape or other shapes in a plan view.

Hereinafter, based on a state illustrated in FIG. 1, the short side of the display panel 100 will be described as a first direction x, the long side of the display panel 100 will be described as a second direction y, and a direction (e.g., a thickness direction of the display panel 100) perpendicular to a plate direction formed by the plate surface of the display panel 100 will be described as a third direction z. In addition, unless otherwise defined, the terms "above", "top", "second surface", and "upper side" as used herein refer to a direction toward which an arrow of the third direction z is directed based on the display panel 100, and the terms "below", "bottom", "first surface", and "lower side" as used herein refer to a direction opposite to the direction toward which the arrow of the third direction z (hereinafter also referred to as a third reverse direction) is directed based on the display panel 100. A direction opposite to the first direction x described above is defined as a first reverse direction, and a direction opposite to the second direction y described above is defined as a second reverse direction.

The display panel 100 may be a display panel 100 including self-light-emitting elements. In an embodiment, the self-light-emitting element may include at least one of an organic light-emitting diode, a quantum dot light-emitting diode, an inorganic material-based micro light-emitting diode (e.g., a ("micro LED")), and an inorganic material-based light-emitting diode (e.g., a ("nano LED")). Hereinafter, for convenience of explanation, a case where the self-light-emitting element is an organic light-emitting diode will be described as one of the embodiments, and respective components of the display panel 100 will be described in detail later.

When the display panel 100 is divided according to whether or not to display an image, the display panel 100 may include a display area DA where the image is displayed and a non-display area NDA where the image is not displayed. The non-display area NDA may be disposed around the display area DA, and may surround the display area DA.

When the display panel 100 is divided based on a bendable area, a base substrate (e.g., a base substrate 110 of FIG. 5) of the display panel 100 may include a first area A1, a second area A2, and a third area A3. The third area A3 is the bendable area, and may be disposed between the first area A1 and the second area A2. The display area DA may be disposed in the first area A1.

In the first area A1, each corner of the display panel 100 may have a curved shape. In an embodiment, each corner of the first area A1 facing each corner of the display area DA may have a curved shape, for example.

A gap G, which is a spaced space, may be provided between the first area A1 and the second area A2.

The display panel 100 may be foldable. In an embodiment, the display panel 100 may be folded upward or downward based on a folding axis FX extending to traverse the display area DA along the first direction x. In an embodiment, as illustrated in FIG. 1, the display panel 100 may be folded based on the folding axis FX in the direction toward which the arrow of the third direction z is directed, which corresponds to an upward direction, or the direction opposite to the direction toward which the arrow of the third direction z is directed, which corresponds to a downward direction, for example.

In the first area A1, a panel cover 300 may be disposed on the lower side of the display panel 100.

The second area A2 may be another portion of the non-display area NDA.

In the second area A2, a bonding layer 410 and a support layer 400 may be disposed on the lower side of the display panel 100.

The bonding layer 410 and the support layer 400 of the second area A2 may be bonded to the lower side of the display panel 100.

The gap G of the third area A3 is disposed between the bonding layer 410 and the support layer 400 of the second area A2 and the panel cover 300 of the first area A1.

In the second area A2, a driving chip IC and one end area of a first circuit board FPCB (hereinafter also referred to as a flexible printed circuit board FPCB) are disposed on the upper side of the display panel 100. Here, a second circuit board MP (hereinafter also referred to as a main circuit board MP) may be connected to an opposite end area of the flexible printed circuit board FPCB.

In the second area A2, pads connected to the driving chip IC and pads PD connected to a flexible printed circuit board FPCB may be disposed. A board cover 500 in contact with the display panel 100, the bonding layer 410, and the support layer 400 may be disposed on the lower side of the flexible printed circuit board FPCB. The board cover 500 may prevent moisture from penetrating into the flexible printed circuit board FPCB and the driving chip IC connected to the flexible printed circuit board FPCB. The pads PD connected to the flexible printed circuit board FPCB may be disposed in a pad area PDA of the second area A2.

In the second area A2, the driving chip IC and the flexible printed circuit board FPCB may be disposed on the upper side of the display panel 100.

The driving chip IC may include at least one of driving devices such as a data driver applying data signals to data lines, a gate driver applying gate signals to gate lines, and a signal controller controlling operations of the data driver and the gate driver. The number of driving chips IC is not limited to that in an illustrated example.

The driving chip IC may be disposed (e.g., mounted) on the display panel 100 using a chip on plastic method. The driving chip IC may be disposed (e.g., mounted) on the display panel 100 using a pressurizing device or the like. The driving chip IC may be disposed (e.g., mounted) on the display panel 100 through an anisotropic conductive film ("ACF"). In an alternative embodiment, the driving chip IC may be disposed (e.g., mounted) on the display panel 100 using an ultrasonic bonding method or the like without a separate anisotropic conductive film.

The ultrasonic bonding method is a method of bonding two metals to each other by applying a pressure and ultrasonic vibrations. When the driving chip IC is disposed (e.g., mounted) on the display panel 100 using the ultrasonic bonding method, a process of pressurizing the driving chip IC and applying ultrasonic vibrations to the driving chip IC may be performed. However, the invention is not limited to the above-described embodiment, and in another embodiment, the driving chip IC may be disposed (e.g., mounted) on the flexible printed circuit board FPCB in the form of a chip on film.

The flexible printed circuit board FPCB may be connected to the second area A2 of the display panel 100. In an embodiment, the flexible printed circuit board FPCB may be connected to the pads PD of the display panel 100 through an anisotropic conductive film or the like, for example. A process of connecting the flexible printed circuit board FPCB to the display panel 100 may include a pressurizing process of applying a pressure to the flexible printed circuit board FPCB.

The main circuit board MP may be electrically connected to the display panel 100 through the flexible printed circuit board FPCB, and may exchange signals with the driving chip IC. The main circuit board MP may provide image data, a control signal, a source voltage, or the like, to the display panel 100 or the flexible printed circuit board FPCB. The main circuit board MP may include active elements and passive elements.

The third area A3 may be a remaining (the other) portion of the non-display area NDA.

The third area A3 may be disposed between the first area A1 and the second area A2. The third area A3 may include the gap G, which is a spaced space formed by the panel cover 300 of the first area A1 and the support layer 400 of the second area A2.

In the third area A3, the gap G may be defined in a direction traversing the non-display area NDA along the first direction x, which is a short side direction of the display panel 100.

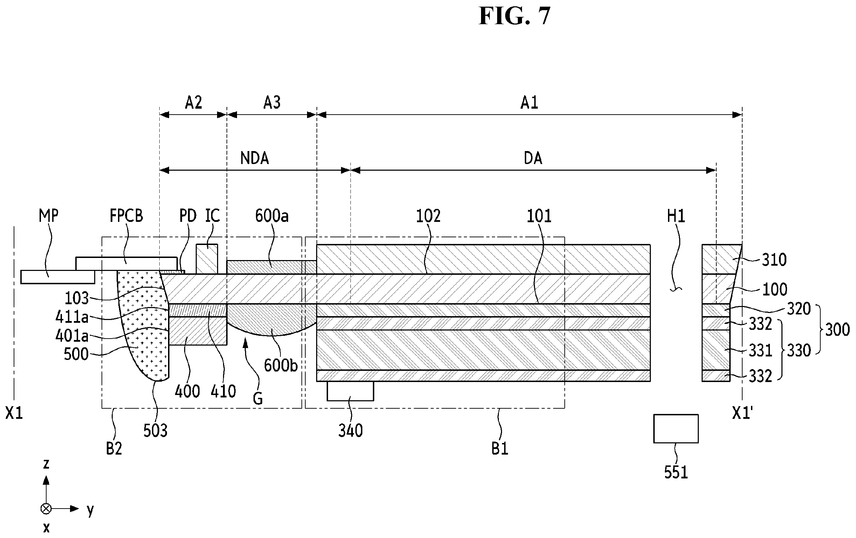

In the third area A3, the display panel 100 may be bent based on a bending axis BX extending along the first direction x, and may be bent downward based on the bending axis BX in the third area A3. As a portion of the non-display area NDA of the display panel 100 is bent in a downward direction of the display panel 100, an advantage that the non-display area NDA of the display device 1 viewed in a plan view may be reduced and an advantage that a bezel width of the display device 1 may be reduced may be realized. Here, the bending axis BX may extend along the first direction x so as to perpendicularly cross long sides of the first area A1 respectively connected to two rounded corners of the lower side of the first area A1. In an embodiment, the display panel 100 may include a first surface 101 of the display panel 100, and a pixel PX may be disposed on a second surface 102 (e.g., refer to FIG. 7) of the display panel 100 opposite to the first surface 101.

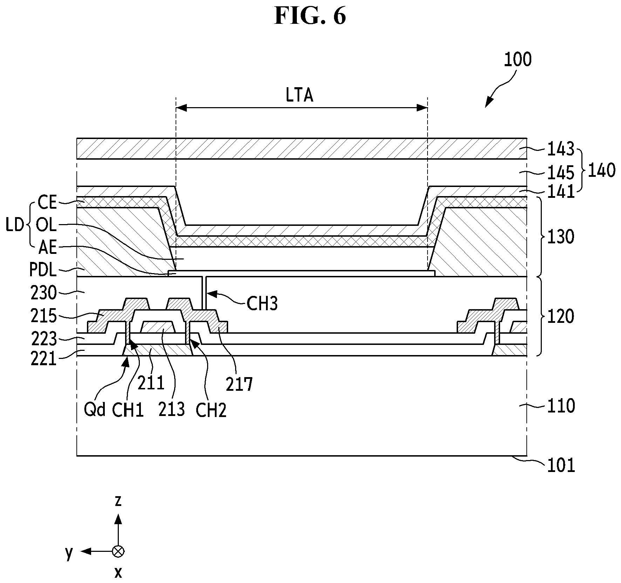

FIG. 5 is a schematic cross-sectional view illustrating a structure of the display panel 100, and FIG. 6 is an enlarged cross-sectional view of a stacked structure of the display panel 100 of FIG. 5.

The display panel 100 may include a base substrate 110, a driving layer 120, an organic light-emitting diode layer 130, and an encapsulation layer 140.

The base substrate 110 may provide the first surface 101 of the display panel 100. The base substrate 110 may be a flexible substrate, and may include or consist of a polymer material having flexibility. In an embodiment, the base substrate 110 may include or consist of plastic having relatively high heat resistance and durability, such as polyethylene ether phthalate, polyethylene naphthalate, polycarbonate, polyarylate, polyetherimide, polyethersulfone, and polyimide. Hereinafter, it will be described as one of embodiments that the base substrate 110 includes polyimide.

The driving layer 120 includes elements for providing signals to the organic light-emitting diode layer 130. The driving layer 120 may include various signal lines such as scan lines (not illustrated), data lines (not illustrated), power lines (not illustrated), and emission lines (not illustrated). The driving layer 120 may include a plurality of transistors and capacitors. The transistors may include a switching transistor (not illustrated) and a driving transistor Qd provided for each pixel PX (refer to FIG. 2).

In FIG. 6, the driving transistor Qd of the driving layer 120 has been illustrated as one of embodiments. The driving transistor Qd includes an active layer 211, a gate electrode 213, a source electrode 215, and a drain electrode 217.

The active layer 211 may be disposed on the base substrate 110. The active layer 211 may include polycrystalline silicon. In another embodiment, the active layer 211 may include single crystal silicon, low-temperature polycrystalline silicon, amorphous silicon, or the like. However, the invention is not limited thereto, and the active layer 211 may include an oxide semiconductor.

The driving layer 120 may further include a first insulating film 221 disposed on the active layer 211, and the gate electrode 213 may be disposed on the first insulating film 221.

The first insulating film 221 may insulate the active layer 211 and the gate electrode 213 from each other. The first insulating film 221 may include an inorganic insulating material such as silicon oxide, silicon nitride, or silicon oxynitride. The first insulating film 221 may be a single film or a multilayer film including stacked films including or consisting of different materials from each other.

The gate electrode 213 may be disposed on the first insulating film 221 and disposed to overlap the active layer 211. The gate electrode 213 may include gold (Au), silver (Ag), copper (Cu), nickel (Ni), platinum (Pt), palladium (Pd), aluminum (Al), molybdenum (Mo), or the like.

The driving layer 120 may further include a second insulating film 223 disposed on the gate electrode 213, and the source electrode 215 and the drain electrode 217 may be disposed on the second insulating film 223.

The second insulating film 223 may include at least one of the insulating materials exemplified in a description of the first insulating film 221.

Each of the source electrode 215 and the drain electrode 217 may be connected to the active layer 211 through each of contact holes CH1 and CH2 defined in the first insulating film 221 and the second insulating film 223. Each of the source electrode 215 and the drain electrode 217 may be formed in a metal multilayer film structure of titanium (Ti)/aluminum (Al)/titanium (Ti), but is not limited thereto.

The driving layer 120 may further include a protective film 230 disposed on the source electrode 215 and the drain electrode 217. In some embodiments, the protective film 230 may be a planarization film. In an embodiment, the protective film 230 may include an organic insulating material or an inorganic insulating material or may be implemented in a composite form of an organic insulating material and an inorganic insulating material.

A structure of the switching transistor has not been illustrated in FIG. 6, but the switching transistor (not illustrated) and the driving transistor Qd may have substantially the same structure or similar structures. However, the invention is not limited thereto, and the switching transistor (not illustrated) and the driving transistor Qd may have different structures. In an embodiment, an active layer (not illustrated) of the switching transistor (not illustrated) and the active layer 211 of the driving transistor Qd may include or consist of different materials or disposed in different layers, for example.

The driving layer 120 may be disposed not only in the display area DA of the display panel 100 but also in the non-display area NDA of the display panel 100. A portion of the driving layer 120 disposed in the non-display area NDA, e.g., a portion of the driving layer 120 disposed in the non-display area NDA of the first area A1 and a portion of the driving layer 120 disposed in the second area A2 and the third area A3 may include lines and pad portions electrically connected to the driving chip IC, and may further include lines and pad portions electrically connected to the flexible printed circuit board FPCB.

The organic light-emitting diode layer 130 may include an organic light-emitting diode LD as a self-light-emitting element. The organic light-emitting diode LD may be provided as a top emission type and may emit light in the thickness direction (e.g., the third direction z) of the display panel 100.

The organic light-emitting diode LD may include a first electrode AE, an organic layer OL, and a second electrode CE.

The first electrode AE is disposed on the protective film 230. The first electrode AE may be connected to the drain electrode 217 through a contact hole CH3 defined in the protective film 230. The first electrode AE may be a pixel electrode or an anode electrode. The first electrode AE may be a semi-transmissive electrode or a reflective electrode. When the organic light-emitting diode LD is provided as the top emission type, the first electrode AE may be the reflective electrode. The first electrode AE may include any one of silver (Ag), magnesium (Mg), aluminum (Al), platinum (Pt), palladium (Pd), gold (Au), nickel (Ni), neodymium (Nd), iridium (Ir), and chromium (Cr), or alloys thereof.

The first electrode AE may have a single-layer structure including or consisting of metal oxide or metal or a multilayer structure having a plurality of layers including or consisting of metal oxide or metal. In an embodiment, the first electrode AE may have a single-layer structure of indium tin oxide ("ITO"), silver (Ag), or a metal mixture (e.g., a combination of silver (Ag) and magnesium (Mg)), a two-layer structure of ITO/magnesium (Mg) or ITO/magnesium fluoride (MgF), or a three-layer structure of ITO/silver (Ag)/ITO, for example, but is not limited thereto.

The organic layer OL may include an organic emission layer ("EML") including or consisting of a low-molecular organic material or a high-molecular organic material. The organic emission layer may emit light. The organic layer OL may optionally include a hole transport layer ("HTL"), a hole injection layer ("HIL"), an electron transport layer ("ETL"), an electron injection layer ("EIL"), or the like, in addition to the organic emission layer.

Holes and electrons are injected into the organic emission layer inside the organic layer OL from the first electrode AE and the second electrode CE, respectively. In the organic emission layer, excitons in which the holes and the electrons are combined with each other are formed, and emit light while dropping from an excited state to a ground state.

The second electrode CE may be provided on the organic layer OL. The second electrode CE may be a common electrode or a cathode electrode. The second electrode CE may be a transmissive electrode or a semi-transmissive electrode. When the second electrode CE is the semi-transmissive electrode, the second electrode CE may include lithium (Li), lithium fluoride (LiF), calcium (Ca), lithium fluoride (LiF)/calcium (Ca), lithium fluoride (LiF)/aluminum (Al), aluminum (Al), magnesium (Mg), barium fluoride (BaF), barium (Ba), silver (Ag), or compounds or combinations thereof (e.g., a combination of silver (Ag) and magnesium ((Mg)).

When the second electrode CE is the transmissive electrode, the second electrode CE may include a transparent metal oxide such as ITO, indium zinc oxide ("IZO"), zinc oxide (ZnO), indium tin zinc oxide ("ITZO"), and may also include molybdenum (Mo), titanium (Ti), silver (Ag), or the like.

The organic light-emitting diode layer 130 may further include a pixel defining film PDL disposed on the protective film 230. The pixel defining film PDL may define an opening exposing the first electrode AE, and may define an emission area LTA in a plan view.

The encapsulation layer 140 may be disposed on the organic light-emitting diode layer 130. The encapsulation layer 140 may block the organic light-emitting diode layer 130 from external moisture and oxygen.

The encapsulation layer 140 may be formed by thin film encapsulation, and may include one or more organic films and one or more inorganic films. In an embodiment, the encapsulation layer 140 may include a first inorganic film 141 disposed on the second electrode CE, an organic film 145 disposed on the first inorganic film 141, and a second inorganic film 143 disposed on the organic film 145.

The first inorganic film 141 may be disposed on the organic light-emitting diode LD. The first inorganic film 141 may prevent moisture, oxygen, or the like, from permeating into the organic light-emitting diode LD. In some embodiments, the first inorganic film 141 may include an inorganic material, and may include at least one of the group consisting of silicon oxide (SiOₓ), silicon nitride (SiNₓ), and silicon oxynitride (SiONₓ) in an embodiment of the inorganic material.

The organic film 145 may be disposed on the first inorganic film 141. The organic film 145 may improve flatness. The organic film 145 may include an organic material, and may include any one selected from the group consisting of epoxy, acrylate, and urethane acrylate in an embodiment of the organic material.

The second inorganic film 143 may be disposed on the organic film 145. The second inorganic film 143 may perform a role that is substantially the same as or similar to that of the first inorganic film 141, and may include or consist of a material that is substantially the same as or similar to that of the first inorganic film 141. The second inorganic film 143 may completely cover the organic film 145. In some embodiments, the second inorganic film 143 and the first inorganic film 141 may contact each other outside the display area DA to form an inorganic-inorganic bond. When the inorganic-inorganic bond is formed, it is possible to effectively prevent moisture or the like from being introduced from the outside of the display device 1 into the display device 1.

It has been illustrated in FIG. 6 that each of the first inorganic film 141, the organic film 145, and the second inorganic film 143 is a single layer, but the invention is not limited thereto. That is, at least one of the first inorganic film 141, the organic film 145, and the second inorganic film 143 may also be formed in a multilayer structure.

The encapsulation layer 140 may not completely cover the non-display area NDA of the display panel 100. In an embodiment, the encapsulation layer 140 may not be disposed in a portion of the first area A1 of the display panel 100 disposed between the third area A3 and the display area DA and in the second area A2 and the third area A3, for example. In an alternative embodiment, the encapsulation layer 140 may be disposed in the portion of the first area A1 of the display panel 100 disposed between the third area A3 and the display area DA, but may not be disposed in the second area A2 and the third area A3. Hereinafter, for convenience of explanation, a case where the encapsulation layer 140 is disposed in the display area DA of the display panel 100 but is not disposed in the portion of the first area A1 disposed between the third area A3 and the display area DA and in the second area A2 and the third area A3 will be described as one of the embodiments.

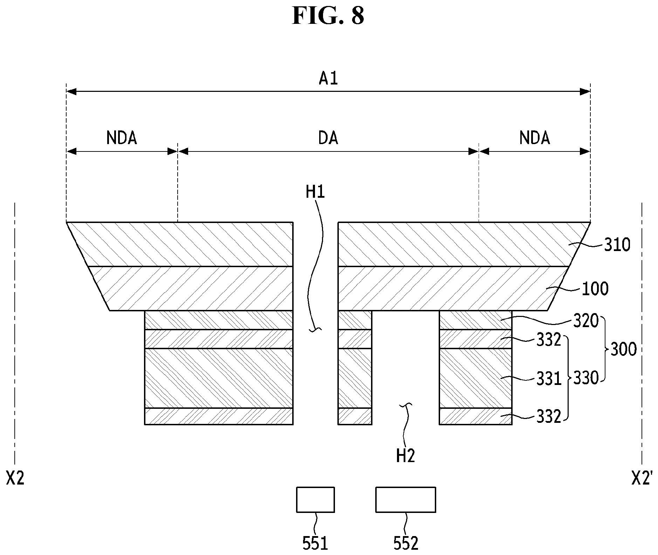

FIG. 7 is a cross-sectional view taken along line X1-X1' of FIG. 2, and FIG. 8 is a cross-sectional view taken along line X2-X2' of FIG. 2.

The display panel 100 may include a side surface extending in an oblique direction (e.g., a surface connecting a second surface 102 and a first surface 101 of the display panel 100 to each other). The side surface of the display panel 100 is also termed as a display panel side surface, e.g. in the claims. An angle defined by the side surface of the display panel 100 and the second surface 102 of the display panel 100 may be an acute angle. In an embodiment, the angle defined by the side surface of the display panel 100 and the second surface 102 of the display panel 100 may be smaller than or equal to 80°, for example, but is not limited thereto.

In the first area A1, a polarizing plate 310 may be disposed in the third direction z on the second surface 102 of the display panel 100. Here, the polarizing plate 310 may be disposed on the second surface 102 of the display panel 100 in order to increase a contrast ratio by expressing true black and secure outdoor visibility. In an embodiment, the polarizing plate 310 may be a structure for preventing deterioration in visibility due to external light reflection, for example. The polarizing plate 310 may include a linear polarizing plate and a phase retardation film. In an embodiment, the phase retardation film may be a λ/4 plate (quarter-wave plate), for example, but is not limited thereto. However, when the visibility due to external light reflection is sufficiently improved by color filters of the display device, the polarizing plate 310 may be omitted. The polarizing plate 310 may include a side surface extending in the oblique direction (e.g., a surface connecting a second surface and a first surface of the polarizing plate 310 to each other). An angle defined by the side surface of the polarizing plate 310 and the second surface of the polarizing plate 310 may be an acute angle. In an embodiment, the angle defined by the side surface of the polarizing plate 310 and the second surface of the polarizing plate 310 may be smaller than or equal to 80°, for example, but is not limited thereto.

The panel cover 300 of the first area A1 may be disposed on the first surface 101 of the display panel 100 in the first area A1 to support the display panel 100.

The panel cover 300 may include an adhesive member 320 attached to the first surface 101 of the display panel 100, a heat dissipation member 330 for efficiently dissipating heat of the display panel 100, and a bending adhesive member 340 fixing a bending position of the display panel 100 when the display panel 100 is bent.

The adhesive member 320 is interposed between the first surface 101 of the display panel 100 and the heat dissipation member 330 to attach the panel cover 300 to the first surface 101 of the display panel 100.

The adhesive member 320 is an adhesive layer including or consisting of a pressure sensitive adhesive ("PSA"), and may attach the panel cover 300 to the first surface 101 of the display panel 100. In an embodiment, the adhesive member 320 may include an acrylic or silicone adhesive, for example, but is not limited thereto.

The adhesive member 320 may be formed as a pressure sensitive adhesive layer further including a light-absorbing material such as a black pigment or a black dye in order to absorb light incident from the outside.

The adhesive member 320 may have a thickness of 5 micrometers (µm) to 25 µm, for example. Here, the thickness may refer to a size in the third direction z.

When a direction (e.g., the first direction x) crossing an arrangement direction (e.g., the second direction y) of the first area A1, the third area A3, and the second area A2 is defined as a horizontal direction, a size of the adhesive member 320 in the horizontal direction in the first area A1 may be smaller than a size of the display panel 100 (or the polarizing plate 310) in the horizontal direction in the first area A1, as illustrated in FIG. 8. In plan view, both edges (or both side surfaces) of the adhesive member 320 opposing each other in the horizontal direction may be disposed between both edges (or both side surfaces) of the display panel 100 (or the polarizing plate 310) opposing each other in the horizontal direction. Accordingly, the display device 1 may have a step along the horizontal direction.

The heat dissipation member 330 may be bonded by the adhesive member 320. The heat dissipation member 330 may include two plating layers 332 disposed along the third direction z and a metal layer 331 disposed between the two plating layers 332.

The metal layer 331 may be formed as a thin film including or consisting of one or more metals selected from copper, nickel, ferrite, and silver having relatively high thermal conductivity, but is not limited thereto.

The plating layer 332 may include or consist of metal that is the same as or different from the metal layer 331. In FIG. 8, any one of the two plating layers 332 may be omitted.

Such a heat dissipation member 330 is a composite layer, and may include a first layer including graphite, carbon nanotubes, or the like, and a second layer formed as a thin film including or consisting of metal such as copper, nickel, ferrite, or silver that may shield electromagnetic waves and has relatively high thermal conductivity, for example, but is not limited thereto.

When the direction (e.g., the first direction x) crossing the arrangement direction (e.g., the second direction y) of the first area A1, the third area A3, and the second area A2 is defined as the horizontal direction, a size of the heat dissipation member 330 in the horizontal direction in the first area A1 may be smaller than the size of the display panel 100 (or the polarizing plate 310) in the horizontal direction in the first area A1, as illustrated in FIG. 8. In plan view, both edges (or both side surfaces) of the heat dissipation member 330 opposing each other in the horizontal direction may be disposed between both edges (or both side surfaces) of the display panel 100 (or the polarizing plate 310) opposing each other in the horizontal direction. Accordingly, the display device 1 may have a step along the horizontal direction.

The bending adhesive member 340 may fix the bending position of the display panel 100 when the display panel 100 is bent. A position of the support layer 400 may be fixed while the support layer 400 is attached to the bending adhesive member 340. The bending adhesive member 340 may include an acrylic or silicone adhesive, but is not limited thereto.

The panel cover 300 may further include a buffer member (not illustrated). The buffer member may be disposed on the heat dissipation member 330 and the bending adhesive member 340. The buffer member (not illustrated) may be formed as a cushion layer to absorb and support an external shock and prevent the display panel 100 from being damaged. In an embodiment, the buffer member (not illustrated) may include or consist of a polymer resin such as polyurethane, polycarbonate, polypropylene, or polyethylene or may include a material having elasticity, such as a sponge formed by foaming rubber, a urethane material, or an acrylic material, for example.

The support layer 400 of the second area A2 may be disposed at a position spaced apart from the heat dissipation member 330 of the panel cover 300 by the gap G in the horizontal direction. The support layer 400 and the heat dissipation member 330 may be disposed in parallel at positions spaced apart from each other.

The support layer 400 may be disposed on the first surface 101 of the display panel 100 at a position corresponding to the driving chip IC in a vertical direction.

The support layer 400 may include or consist of at least one of polyethylene terephthalate ("PET"), polycarbonate ("PC"), and polymethyl methacrylate ("PMMA"), for example. The support layer 400 may be most preferably including or consisting of PET, but is not limited thereto.

The support layer 400 may support the display panel 100 having flexibility, protect the first surface 101 of the display panel 100, and prevent a crack from occurring during a process of mounting the driving chip IC.

When the driving chip IC is disposed (e.g., mounted) on the second area A2 of the display panel 100, a pressure may be applied to the second area A2, and the support layer 400 disposed on the first surface 101 of the display panel 100 corresponding to the second area A2 may prevent a crack from occurring in a conductive layer or the like of the non-display area NDA due to the pressure in the process of mounting the driving chip IC.

In the second area A2 where the support layer 400 is bonded, the driving chip IC may be disposed (e.g., mounted) on the display panel 100 by high-pressure bonding. When the support layer 400 is formed as a film having relatively high transmissivity, it may be easily inspected using an optical microscope or the like whether or not the driving chip IC is accurately disposed (e.g., mounted) on the second area A2. In this case, light transmissivity of the support layer 400 disposed in the second area A2 on which the driving chip IC is disposed (e.g., mounted) is high, and accordingly, an inspection for a mounting state of the driving chip IC may be more smoothly performed. Accordingly, it may be simultaneously confirmed whether or not the driving chip IC is defective due to compression.

In the first area A1, the display panel 100 may be folded along the folding axis FX (refer to FIG. 1). Here, when a component corresponding to reference numeral 400 is disposed in the first area A1 that is foldable, a problem related to environmental reliability may occur. The environmental reliability may refer to characteristics that the display panel 100 does not break by maintaining a neutral surface in a high-temperature environment for bending or folding the display panel 100.

When the component corresponding to reference numeral 400 is disposed in the first area A1, the problem related to the environmental reliability may occur when the display panel 100 is bent or folded, but in the invention, the component corresponding to reference numeral 400 is not disposed in the first area A1, and thus, the problem related to the environmental reliability may be solved.

When the component corresponding to reference numeral 400 is disposed in the first area A1, a stacked structure may increase in the first area A1, which is the display area DA, and accordingly, an entirety of the thickness of the display device 1 may become great. However, in an embodiment, the support layer 400 is disposed in the second area A2, which is the non-display area NDA, and the component corresponding to reference numeral 400 is not disposed in the first area A1, which is the display area DA, and thus, the stacked structure may be reduced in the first area A1, which is the display area DA, such that the entirety of the thickness of the display device 1 may be reduced.

In addition, the component corresponding to reference numeral 400 is not disposed in the first area A1, and thus, the stacked structure may be reduced in the first area A1, which is the display area DA, such that a manufacturing cost may be reduced.

In an embodiment, the component corresponding to reference numeral 400 is not disposed in the first area A1 and the support layer 400 is exclusively disposed only on the first surface 101 of the display panel 100 overlapping the driving chip IC of the second area A2, and thus, the display panel 100 may be protected in the second area A2 and a crack and a defect problem of the driving chip IC may be solved.

The bonding layer 410 of the second area A2 may bond the support layer 400 to the first surface 101 of the display panel 100 in the second area A2.

The bonding layer 410 may be disposed on the same surface (e.g., the first surface 101 of the display panel 100) as the adhesive member 320 of the panel cover 300 in the horizontal direction.

The bonding layer 410 may be disposed on the first surface 101 of the display panel 100 at a position corresponding to the driving chip IC in the vertical direction. In an embodiment, the bonding layer 410 may be disposed between the display panel 100 (e.g., the second area A2 of the display panel 100) and the support layer 400 so as to overlap the driving chip IC, for example.

The bonding layer 410 may have a shape corresponding to that of the support layer 400. The bonding layer 410 may be interposed between the first surface 101 of the display panel 100 and the support layer 400 to attach the support layer 400 to the first surface 101 of the display panel 100 in the second area A2.

The bonding layer 410 may have adhesiveness capable of attaching the support layer 400. The bonding layer 410 may include at least one of a polyester acrylate resin, an unsaturated polyester resin, a polyurethane acrylate resin, an epoxy acrylate resin, an epoxy resin, a polyether acrylate resin, and a polythiol acrylate resin, for example.

The bonding layer 410 may prevent a crack or the like from occurring due to a pressure in the process of mounting the driving chip IC in the second area A2.

The board cover 500 may be disposed on a first surface of the flexible printed circuit board FPCB so as to contact the bonding layer 410, the support layer 400, the display panel 100, and the pad PD of the second area A2. The first surface of the flexible printed circuit board FPCB is also termed as a first circuit board surface, e.g. in the claims.

The board cover 500 may be formed in various organic film forms, and may include at least one of an acrylic resin and a urethane resin, for example. However, the invention is not limited thereto.

The third area A3 may be disposed between the second area A2 where the support layer 400 and the bonding layer 410 are disposed and the first area A1 where the panel cover 300 is disposed.

Since the third area A3 is a bendable area, the third area A3 may include the gap G, which is the spaced space, between the heat dissipation member 330 of the panel cover 300 disposed in the first area A1 and the support layer 400 of the second area A2 in order to form a relatively small radius of curvature.

The first surface 101 of the display panel 100 corresponding to the third area A3 may be exposed through the gap G or a second reinforcing layer 600b (to be described later) covering the first surface 101 of the display panel 100 exposed through the gap G may be exposed through the gap G.

In the third area A3, a first reinforcing layer 600a and the second reinforcing layer 600b may be disposed on the second surface 102 and the first surface 101 of the display panel 100, respectively. In an embodiment, the first reinforcing layer 600a may be disposed in the third direction z on the second surface 102 of the display panel 100, and the second reinforcing layer 600b may be disposed in the third reverse direction on the first surface 101 of the display panel 100, for example.

The first reinforcing layer 600a may be disposed between the polarizing plate 310 of the first area A1 and the driving chip IC of the second area A2 along the horizontal direction, and may be disposed in the third direction z on the second surface 102 of the display panel 100. Such a first reinforcing layer 600a may be disposed as a neutral surface adjustment layer on the non-display area NDA of the display panel 100.

The neutral surface adjustment layer (e.g., 600a) may be disposed to overlap the third area A3 bendable in the non-display area NDA of the display panel 100. The neutral surface adjustment layer 600a has been formed only in the third area A3, but portions of the neutral surface adjustment layer 600a may also be formed to overlap the first area A1 and the second area A2.

The neutral surface adjustment layer 600a may prevent a crack from occurring in a conductive layer in the driving layer 120 by relieving stress applied to the driving layer 120 in the third area A3 that is bendable.

More specifically, the driving layer 120 includes conductive layers passing through the non-display area NDA of the first area A1 and the third area A3, and elements in the driving layer 120 may be electrically connected to the driving chip IC through such conductive layers.

The neutral surface adjustment layer 600a may serve to adjust a position of a neutral surface so that tensile stress does not act on the conductive layers disposed in the third area A3.

Here, the neutral surface refers to a surface on which neither compressive stress nor tensile stress acts when the third area A3 of the display panel 100 is bent. In an embodiment, when the third area A3 is bent, compressive stress acts on the inside of a curvature, and tensile stress acts on the outside of the curvature, for example.

Accordingly, as a direction in which stress acts gradually changes from a compressive direction to a tensile direction from the inside of the curvature toward the outside of the curvature, and a conversion point where neither the compressive stress nor the tensile stress acts exists at a predetermined critical point, which becomes the neutral surface. When the position of such a neutral surface is adjusted by the neutral surface adjustment layer 600a, the compressive stress acts on the conductive layers in the driving layer 120, and thus, a risk of crack occurrence may be reduced.

The neutral surface adjustment layer 600a may include or consist of an organic material, which may be a photosensitive organic material, for example. In an embodiment, the neutral surface adjustment layer 600a may include at least one of an acrylic resin and a urethane resin, for example.

It has been illustrated in FIG. 7 that the neutral surface adjustment layer 600a is spaced apart from the driving chip IC, but the invention is not limited thereto. The neutral surface adjustment layer 600a may also extend to a portion where the driving chip IC is disposed to cover a portion of the driving chip IC. In such a case, bonding reliability between the driving chip IC and the display panel 100 may be improved.

The second reinforcing layer 600b may be disposed between the adhesive member 320 of the first area A1 and the bonding layer 410 of the second area A2, and may be disposed on the first surface 101 of the display panel 100.

The second reinforcing layer 600b may include or consist of the same material as that of the first reinforcing layer 600a, and may include at least one of an acrylic resin and a urethane resin, for example. The second reinforcing layer 600b may also include or consist of a different material from the first reinforcing layer 600a.

The second reinforcing layer 600b may serve to support the first surface 101 of the display panel 100 of the third area A3 exposed through the gap G and protect the first surface 101 of the display panel 100. Both the first and second reinforcing layers 600a and 600b have been formed in FIG. 7, but the invention is not limited thereto, and the second reinforcing layer 600b may also be optionally formed. In another embodiment, the second reinforcing layer 600b may be omitted, for example.

In an embodiment, a first hole H1 and a second hole H2 may be defined in the display device 1 in the display area DA.

The first hole H1 may penetrate through the polarizing plate 310, the display panel 100, the adhesive member 320, and the heat dissipation member 330 in the display area DA, as illustrated in FIGS. 7 and 8. In plan view, the first hole H1 may have a circular shape, but a shape of the first hole H1 is not limited thereto and may be modified into various shapes.

A first electronic component 551 (or a first electronic module) may be disposed below the first hole H1. In an embodiment, the first electronic component 551 may be disposed on the lower side of the heat dissipation member 330 so as to overlap the first hole H1, for example. The first electronic component 551 may include an image sensor (e.g., a camera) capturing an image.

The second hole H2 may penetrate through the adhesive member 320 and the heat dissipation member 330 in the display area DA, as illustrated in FIG. 8. The second hole H2 may be disposed next (adjacent) to the first hole H1. The second hole H2 may have an elliptical shape, but a shape of the second hole H2 is not limited thereto and may be modified into various shapes.

A second electronic component 552 (or a second electronic module) may be disposed below the second hole H2. In an embodiment, the second electronic component 552 may be disposed on the lower side of the heat dissipation member 330 so as to overlap the second hole H2, for example. The second electronic component 552 may include a sensor measuring a distance, such as a proximity sensor, a sensor recognizing a part (e.g., a fingerprint, an iris, a face, etc.) of a user's body, or the like.

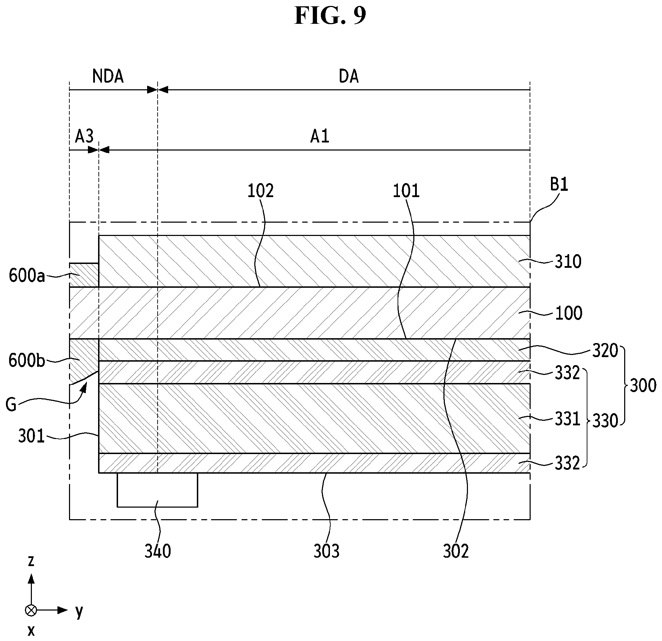

FIG. 9 is an enlarged view of area B1 of FIG. 7.

The panel cover 300 of FIG. 9 may include an inner side surface 301 disposed around the gap G, a second surface 302 facing the display panel 100, and a first surface 303, which is a surface opposite to the second surface 302. The second surface 302 and the first surface 303 of the panel cover 300 may be disposed to oppose each other in the third direction z.

An angle defined by the inner side surface 301 of the panel cover 300 and the first surface 101 of the display panel 100 may be a right angle. In this case, the panel cover 300 may have a quadrangular cross-sectional shape, e.g., rectangular cross-sectional shape as illustrated in FIG. 9, but a shape of the panel cover 300 is not limited thereto.

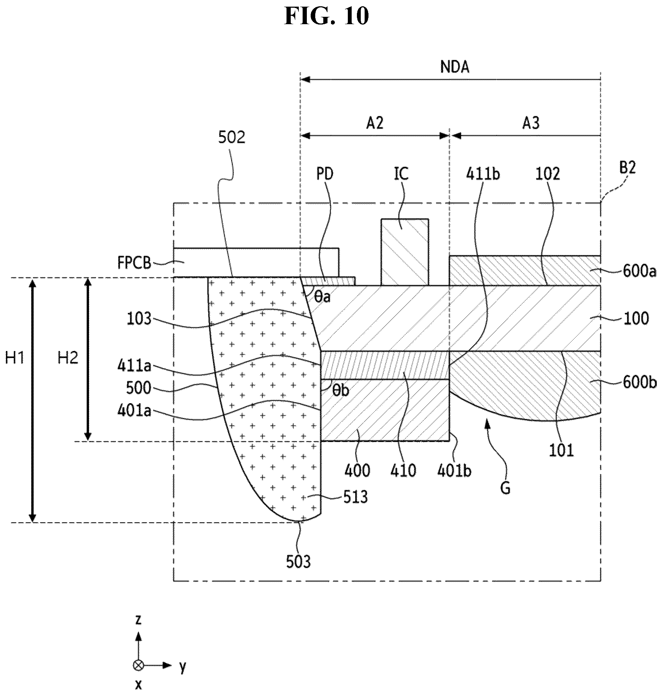

FIG. 10 is an enlarged view of an embodiment of area B2 of FIG. 7 in the display device.

As illustrated in FIG. 10, the board cover 500 of the display device 1 in an embodiment may support the flexible printed circuit board FPCB, the support layer 400, the bonding layer 410, and the display panel 100. In an embodiment, the board cover 500 may support the flexible printed circuit board FPCB on the lower side of the flexible printed circuit board FPCB, for example. In addition, the board cover 500 may support a first side surface 401a of the support layer 400, a first side surface 411a of the bonding layer 410, and a side surface 103 of the display panel 100 on one side of each of the support layer 400, the bonding layer 410, and the display panel 100. The first side surface 401a of the support layer 400 is also termed as a first support layer side surface 401a, e.g. in the claims.

The board cover 500 may be in contact (or direct contact) with the flexible printed circuit board FPCB, the support layer 400, the bonding layer 410, the display panel 100, and the pad PD. In an embodiment, the board cover 500 may be in contact (or direct contact) with the first surface of the flexible printed circuit board FPCB, for example. In addition, the board cover 500 may be in contact (or direct contact) with the first side surface 401a of the support layer 400, the first side surface 411a of the bonding layer 410, the side surface 103 of the display panel 100, and a side surface of the pad PD. A first surface 503 of the board cover 500 may have a curved shape.

The first surface 503 of the board cover 500 may extend downward more than the support layer 400. In an embodiment, the board cover 500 may include an extension portion 513 including the first surface 503 of the board cover 500 and extending downward more than the support layer 400, for example. The extension portion 513 of the board cover 500 is not in contact with the support layer 400. Specifically, when an interface between the first circuit board FPCB and the board cover 500 is defined as a reference surface 502, a height HE1 of the board cover 500 from the reference surface 502 may be greater than a height HE2 of the support layer 400 from the reference surface 502. In other words, when one surface of the board cover 500 disposed farthest from the reference surface 502 in the third reverse direction among surfaces of the board cover 500 is defined as a first outermost surface and a surface of the support layer 400 disposed farthest from the reference surface 502 in the third reverse direction among surfaces of the support layer 400 is defined as a second outermost surface, the height HE1 (or a distance) from the reference surface 502 to the first outermost surface of the board cover 500 may be greater than the height HE2 (or a distance) from the reference surface 502 to the second outermost surface of the support layer 400.

An angle defined by the first side surface 401a of the support layer 400 and the side surface 103 of the display panel 100 may be an obtuse angle.

A second side surface 401b of the support layer 400, which is a surface opposite to the first side surface 401a of the support layer 400, may contact the second reinforcing layer 600b. The second side surface 401b of the support layer 400 is also termed as a second support layer side surface 401b, e.g. in the claims.

A second side surface 411b of the bonding layer 410, which is a surface opposite to the first side surface 411a of the bonding layer 410, may contact the second reinforcing layer 600b.

The second side surface 401b of the support layer 400 may be disposed closer to the third area A3 than the first side surface 401a of the support layer 400 is to the third area A3. Similarly, the second side surface 411b of the bonding layer 410 may be disposed closer to the third area A3 than the first side surface 411a of the bonding layer 410 is to the third area A3. Here, the first side surface 411a of the bonding layer 410 may be disposed close to the first side surface 401a of the support layer 400, and the second side surface 411b of the bonding layer 410 may be disposed close to the second side surface 401b of the support layer 400. In addition, each of the side surface 103 of the display panel and the side surface of the pad PD may be disposed next (adjacent) to the first side surface 401a of the support layer 400 or the first side surface 411a of the bonding layer 410.

An angle θa between the side surface 103 of the display panel 100 and the second surface 102 of the display panel 100 may be smaller than an angle θb between the first side surface 401a of the support layer 400 and the second surface 102 of the display panel 100 (e.g., an interface between the bonding layer 410 and the support layer 400). In an embodiment, the angle θa between the side surface 103 of the display panel 100 and the second surface 102 of the display panel 100 may be smaller than 90°, and the angle θb between the first side surface 401a of the support layer 400 and the second surface 102 of the display panel 100 may be 90°, for example. Here, the second surface 102 of the display panel 100 may be parallel to the interface between the bonding layer 410 and the support layer 400.

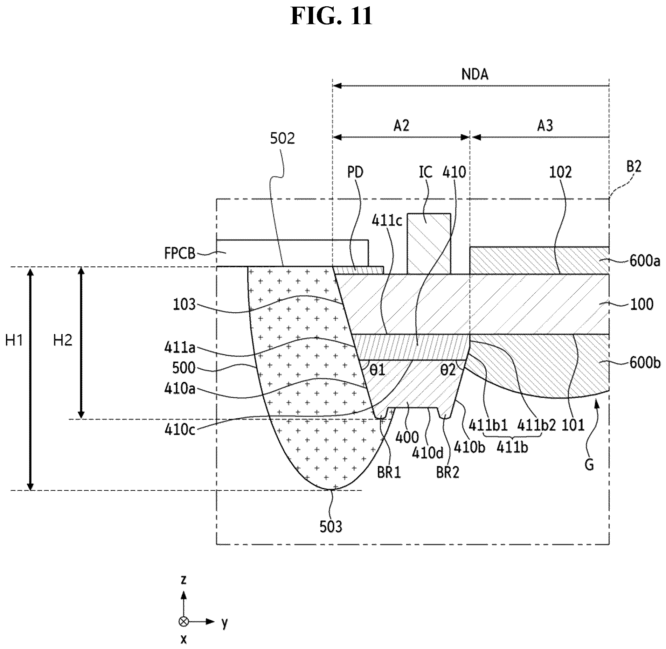

FIG. 11 is an enlarged view of another embodiment of area B2 of FIG. 7 in a display device.

As illustrated in FIG. 11, the support layer 400 may include a first side surface 410a extending in the oblique direction. An angle θ1 defined by the first side surface 410a of the support layer 400 (or first support layer side surface 410a) and a second surface 410c of the support layer 400 (or second support layer surface 410c) may be an acute angle. In an embodiment, the angle θ1 defined by the first side surface 410a of the support layer 400 and the second surface 410c of the support layer 400 may be smaller than or equal to 80°, for example, but is not limited thereto. The second surface 410c of the support layer 400 may be an interface between the support layer 400 and the bonding layer 410. The first side surface 410a of the support layer 400 may be disposed next (adjacent) to an edge of the display panel 100 (or a side surface 103 of the display panel 100) in the second area A2. At least a portion of the first side surface 410a of the support layer 400 may contact the board cover 500.

The support layer 400 may include a second side surface 410b extending along the oblique direction. An angle θ2 defined by the second side surface 410b of the support layer 400 and the second surface 410c of the support layer 400 may be an acute angle. In an embodiment, the angle θ2 defined by the second side surface 410b of the support layer 400 and the second surface 410c of the support layer 400 may be smaller than or equal to 80°, for example, but is not limited thereto. The angle θ2 defined by the second side surface 410b of the support layer 400 and the second surface 410c of the support layer 400 may be the same as or different from the angle θ1 defined by the first side surface 410a of the support layer 400 and the second surface 410c of the support layer 400. The second side surface 410b of the support layer 400 may be a surface opposite to (a surface opposing) the first side surface 410a of the support layer 400. At least a portion of the second side surface 410b may contact the second reinforcing layer 600b. A distance between the first side surface 410a of the support layer 400 and the second side surface 410b of the support layer 400 may gradually increase along a direction from a first surface 410d of the support layer 400 toward the second surface 410c of the support layer 400 (e.g., the third direction z). The first surface 410d of the support layer 400 is also termed as a first support layer surface 410d, e.g. in the claims.

The support layer 400 may include a first protrusion pattern BR1 (or a first burr pattern) and a second protrusion pattern BR2 (or a second burr pattern). The first protrusion pattern BR1 and the second protrusion pattern BR2 may be disposed on the first surface 410d of the support layer 400. In an embodiment, the first protrusion pattern BR1 and the second protrusion pattern BR2 may be disposed along edges of the first surface 410d of the support layer 400, for example. In an embodiment, in a plan view, the first protrusion pattern BR1 and the second protrusion pattern BR2 may be disposed along the edges of the first surface 410d of the support layer 400 so as to surround a central portion of the first surface 410d of the support layer 400, for example. The first protrusion pattern BR1 and the second protrusion pattern BR2 may protrude from the first surface 410d of the support layer 400 in the downward direction (e.g., in the direction opposite to the third direction z (hereinafter also referred to as a third reverse direction)). The first protrusion pattern BR1 may be disposed next (adjacent) to the first side surface 410a of the support layer 400, and the second protrusion pattern BR2 may be disposed next (adjacent) to the second side surface 410b of the support layer 400. Each of the first protrusion pattern BR1 and the second protrusion pattern BR2 may overlap the bonding layer 410. The second protrusion pattern BR2 may be disposed closer to the third area A3 than the first protrusion pattern BR1 is to the third area A3. The support layer 400, the first protrusion pattern BR1, and the second protrusion pattern BR2 may be formed integrally with each other. Each of the support layer 400, the first protrusion pattern BR1, and the second protrusion pattern BR2 may include or consist of the same material as that of the support layer 400 of FIG. 10 described above. The first protrusion pattern BR1 may have a thickness (or a height) of 50 nanometers (nm) or more, for example. The second protrusion pattern BR2 may also have the same thickness as the first protrusion pattern BR1. Here, the thickness may be a size in the third direction z.

The first protrusion pattern BR1 and the second protrusion pattern BR2 of the support layer 400 may be formed in a process of irradiating the support layer 400 with an intense light (e.g., a laser beam) during a manufacturing process, and may be formed by melting portions of the support layer 400 by thermal energy of the laser beam.

The bonding layer 410 may be disposed between the support layer 400 and the second area A2 of the display panel 100. A first side surface 411a of the bonding layer 410 may have an angle inclined along the oblique direction. In an embodiment, an angle defined by the first side surface 411a of the bonding layer 410 and a second surface 411c of the bonding layer 410 may be an acute angle, for example. In an embodiment, the angle defined by the first side surface 411a of the bonding layer 410 and the second surface 411c of the bonding layer 410 may be smaller than or equal to 80°, but is not limited thereto. The second surface 411c of the bonding layer 410 may be an interface between the bonding layer 410 and the display panel 100. The first side surface 411a of the bonding layer 410 may be disposed next (adjacent) to the edge of the display panel 100 (or the side surface 103 of the display panel 100) in the second area A2. At least a portion of the first side surface 411a of the bonding layer 410 may contact the board cover 500. A distance between the first side surface 411a of the bonding layer 410 and a second side surface 411b of the bonding layer 410 may gradually increase along a direction from a first surface (e.g., 410c) of the bonding layer 410 toward the second surface 410c of the support layer 400 (e.g., the third direction z).

The second side surface 411b of the bonding layer 410 may have a bent shape. In an embodiment, the second side surface 411b of the bonding layer 410 may include a first surface 411b1 extending along the oblique direction and a second surface 411b2 bent from the first surface 411b1 and extending in the third direction z, for example. At least a portion of the second side surface 411b of the bonding layer 410 may contact the second reinforcing layer 600b. An angle between the first surface 411b1 and the second surface 411b2 may be an obtuse angle. The bonding layer 410 may include or consist of the same material as that of the bonding layer 410 of FIG. 10 described above.

The board cover 500 may support the flexible printed circuit board FPCB, the support layer 400, the bonding layer 410, and the display panel 100. In an embodiment, the board cover 500 may support the flexible printed circuit board FPCB on the lower side of the flexible printed circuit board FPCB, for example. In addition, the board cover 500 may support the first side surface 410a of the support layer 400, the first side surface 411a of the bonding layer 410, and the side surface 103 of the display panel 100 on one side of each of the support layer 400, the bonding layer 410, and the display panel 100.

The board cover 500 may be in contact (or direct contact) with the flexible printed circuit board FPCB, the support layer 400, the bonding layer 410, the pad PD, and the display panel 100. In an embodiment, the board cover 500 may be in contact (or direct contact) with the first surface of the flexible printed circuit board FPCB, and may be in contact (or direct contact) with the first side surface 410a of the support layer 400, the first side surface 411a of the bonding layer 410, the side surface of the pad PD, and the side surface 103 of the display panel 100, for example.

The board cover 500 may overlap the first protrusion pattern BR1, as illustrated in FIG. 11. In an embodiment, the board cover 500 may be disposed on the first surface 410d of the support layer 400 so as to cover a portion of the first surface 410d of the support layer 400, and in this case, the board cover 500 may cover the first protrusion pattern BR1 so as to overlap the first protrusion pattern BR1, for example. In an embodiment, the first surface 503 of the board cover 500 may overlap the first protrusion pattern BR1, for example.

The first surface 503 of the board cover 500 may extend downward more than the support layer 400. In an embodiment, the board cover 500 may include an extension portion 513 including the first surface 503 of the board cover 500 and extending downward more than the support layer 400, for example. The extension portion 513 of the board cover 500 is not in contact with the support layer 400. Specifically, when an interface between the first circuit board FPCB and the board cover 500 is defined as a reference surface 502, a height HE1 of the board cover 500 from the reference surface 502 may be greater than a height HE2 of the support layer 400 from the reference surface 502. In other words, when one surface of the board cover 500 disposed farthest from the reference surface 502 in the third reverse direction among surfaces of the board cover 500 is defined as a first outermost surface and a surface of the support layer 400 disposed farthest from the reference surface 502 in the third reverse direction among surfaces of the support layer 400 is defined as a second outermost surface, the height HE1 (or a distance) from the reference surface 502 to the first outermost surface of the board cover 500 may be greater than the height HE2 (or a distance) from the reference surface 502 to the second outermost surface of the support layer 400. Here, the second outermost surface of the support layer 400 may be an outermost surface of the first protrusion pattern BR1 included in the support layer 400, for example.

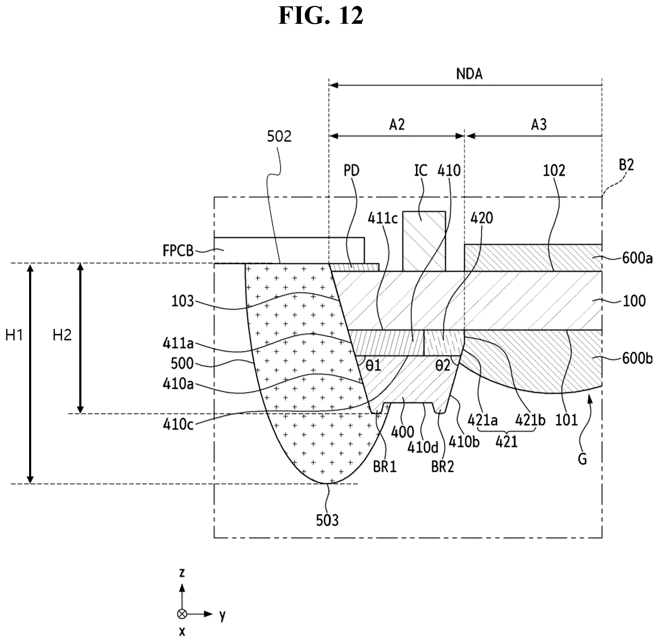

FIG. 12 is an enlarged view of another embodiment of area B2 of FIG. 7 in a display device.

A display device 1 of FIG. 12 is different from the display device 1 of FIG. 11 described above in that it further includes a dummy layer 420, and such a difference will be mainly described below.

As illustrated in FIG. 12, the bonding layer 410 and the dummy layer 420 may be disposed between the support layer 400 and the second area A2 of the display panel 100.

The bonding layer 410 and the dummy layer 420 may be disposed on the support layer 400. In an embodiment, the bonding layer 410 and the dummy layer 420 may be disposed next (adjacent) to each other along the second direction y on the support layer 400, for example.

The bonding layer 410 and the dummy layer 420 may be in contact (or direct contact) with each other.

In plan view, an area of the bonding layer 410 may be greater than an area of the dummy layer 420.

At least a portion of the bonding layer 410 may be in contact (or direct contact) with the board cover 500. In an embodiment, the first side surface 411a of the bonding layer 410 may contact the board cover 500, for example. The bonding layer 410 may overlap the first protrusion pattern BR1 of the support layer 400. The bonding layer 410 may include or consist of the same material as that of the bonding layer 410 of FIG. 10 described above.

At least a portion of the dummy layer 420 may be in contact (or direct contact) with the second reinforcing layer 600b. In an embodiment, a side surface 421 of the dummy layer 420 may contact the second reinforcing layer 600b, for example. The side surface 421 of the dummy layer 420 may be disposed next (adjacent) to the second side surface 410b of the support layer 400. The side surface 421 of the dummy layer 420 may have a bent shape. In an embodiment, the side surface 421 of the dummy layer 420 may include a first surface 421a extending in the oblique direction and a second surface 421b bent from the first surface 421a and extending in the third direction z, for example. An angle between the first surface 421a and the second surface 421b of the dummy layer 420 may be an obtuse angle. The dummy layer 420 may overlap the second protrusion pattern BR2 of the support layer 400. The dummy layer 420 may include at least one of a polyester acrylate resin, an unsaturated polyester resin, a polyurethane acrylate resin, an epoxy acrylate resin, an epoxy resin, a polyether acrylate resin, and a polythiol acrylate resin, for example.

The bonding layer 410 and the dummy layer 420 may have different adhesive strengths from each other. In an embodiment, an adhesive strength of the bonding layer 410 may be greater than an adhesive strength of the dummy layer 420, for example.

The first surface 503 of the board cover 500 may extend downward more than the support layer 400. In an embodiment, the board cover 500 may include an extension portion 513 including the first surface 503 of the board cover 500 and extending downward more than the support layer 400, for example. The extension portion 513 of the board cover 500 is not in contact with the support layer 400. Specifically, when an interface between the first circuit board FPCB and the board cover 500 is defined as a reference surface 502, a height HE1 of the board cover 500 from the reference surface 502 may be greater than a height HE2 of the support layer 400 from the reference surface 502. In other words, when one surface of the board cover 500 disposed farthest from the reference surface 502 in the third reverse direction among surfaces of the board cover 500 is defined as a first outermost surface and a surface of the support layer 400 disposed farthest from the reference surface 502 in the third reverse direction among surfaces of the support layer 400 is defined as a second outermost surface, the height HE1 (or a distance) from the reference surface 502 to the first outermost surface of the board cover 500 may be greater than the height HE2 (or a distance) from the reference surface 502 to the second outermost surface of the support layer 400. Here, the second outermost surface of the support layer 400 may be an outermost surface of the first protrusion pattern BR1 included in the support layer 400, for example.

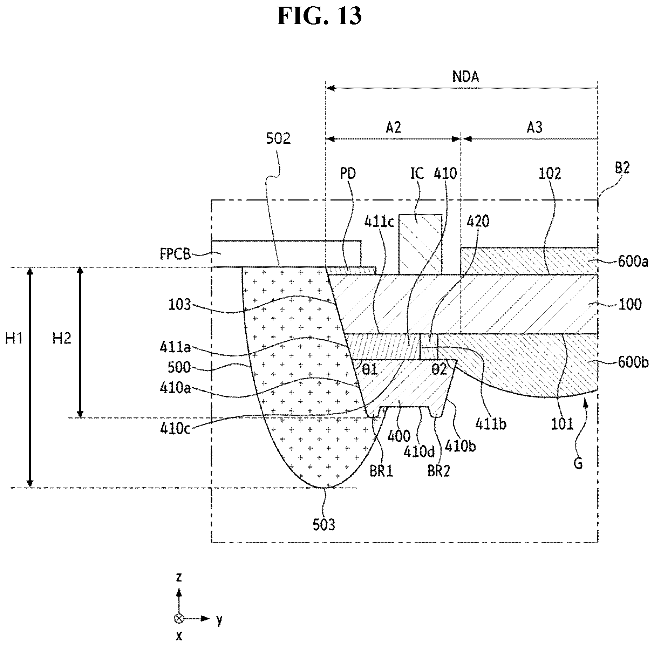

FIG. 13 is an enlarged view of another embodiment of area B2 of FIG. 7 in a display device.

A display device 1 of FIG. 13 is different from the display device 1 of FIG. 12 described above in a shape of the dummy shape 420, and such a difference will be mainly described below.

As illustrated in FIG. 13, the bonding layer 410, the dummy layer 420, and the second reinforcing layer 600b may be disposed between the support layer 400 and the second area A2 of the display panel 100.

The dummy layer 420 of FIG. 13 does not overlap an edge of the support layer 400. Accordingly, in a plan view, the edge of the support layer 400 may surround the dummy layer 420. In addition, in a plan view, the dummy layer 420 may be disposed between the first side surface 410a and the second side surface 410b of the support layer 400. In an embodiment, in a plan view, both side surfaces of the dummy layer 420 may be disposed between the first side surface 410a and the second side surface 410b of the support layer 400, for example.

When the second reinforcing layer 600b is omitted, a gap may be formed between the support layer 400 and the display panel 100 (e.g., the second area A2 of the display panel 100).

The first surface 503 of the board cover 500 may extend downward more than the support layer 400. In an embodiment, the board cover 500 may include an extension portion 513 including the first surface 503 of the board cover 500 and extending downward more than the support layer 400, for example. The extension portion 513 of the board cover 500 is not in contact with the support layer 400. Specifically, when an interface between the first circuit board FPCB and the board cover 500 is defined as a reference surface 502, a height HE1 of the board cover 500 from the reference surface 502 may be greater than a height HE2 of the support layer 400 from the reference surface 502. In other words, when one surface of the board cover 500 disposed farthest from the reference surface 502 in the third reverse direction among surfaces of the board cover 500 is defined as a first outermost surface and a surface of the support layer 400 disposed farthest from the reference surface 502 in the third reverse direction among surfaces of the support layer 400 is defined as a second outermost surface, the height HE1 (or a distance) from the reference surface 502 to the first outermost surface of the board cover 500 may be greater than the height HE2 (or a distance) from the reference surface 502 to the second outermost surface of the support layer 400. Here, the second outermost surface of the support layer 400 may be an outermost surface of the first protrusion pattern BR1 included in the support layer 400, for example.

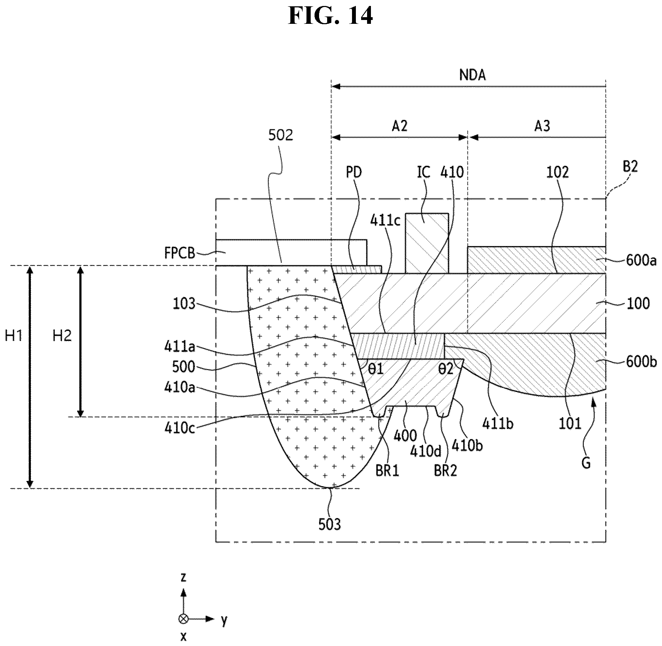

FIG. 14 is an enlarged view of another embodiment of area B2 of FIG. 7 in a display device.

A display device 1 of FIG. 14 is different from the display device 1 of FIG. 11 described above in a shape of the bonding layer 410, and such a difference will be mainly described below.

As illustrated in FIG. 14, a portion of the second surface 410c of the support layer 400 (hereinafter also referred to as a first partial surface) contacts the bonding layer 410, and a remaining (the other) portion of the second surface 410c of the support layer 400 (hereinafter also referred to as a second partial surface) is not in contact with the bonding layer 410. In an embodiment, the second partial surface of the support layer 400 may contact the second reinforcing layer 600b, for example. The bonding layer 410 may be disposed between the first partial surface of the support layer 400 and the display panel 100, and the second reinforcing layer 600b may be disposed between the second partial surface of the support layer 400 and the display panel 100.

When the second reinforcing layer 600b is omitted, a gap may be formed between the support layer 400 and the display panel 100 (e.g., the second area A2 of the display panel 100). In an embodiment, a gap may be formed between the second partial surface of the support layer 400 and the display panel 100, for example.

The first surface 503 of the board cover 500 may extend downward more than the support layer 400. In an embodiment, the board cover 500 may include an extension portion 513 including the first surface 503 of the board cover 500 and extending downward more than the support layer 400, for example. The extension portion 513 of the board cover 500 is not in contact with the support layer 400. Specifically, when an interface between the first circuit board FPCB and the board cover 500 is defined as a reference surface 502, a height HE1 of the board cover 500 from the reference surface 502 may be greater than a height HE2 of the support layer 400 from the reference surface 502. In other words, when one surface of the board cover 500 disposed farthest from the reference surface 502 in the third reverse direction among surfaces of the board cover 500 is defined as a first outermost surface and a surface of the support layer 400 disposed farthest from the reference surface 502 in the third reverse direction among surfaces of the support layer 400 is defined as a second outermost surface, the height HE1 (or a distance) from the reference surface 502 to the first outermost surface of the board cover 500 may be greater than the height HE2 (or a distance) from the reference surface 502 to the second outermost surface of the support layer 400. Here, the second outermost surface of the support layer 400 may be an outermost surface of the first protrusion pattern BR1 included in the support layer 400, for example.

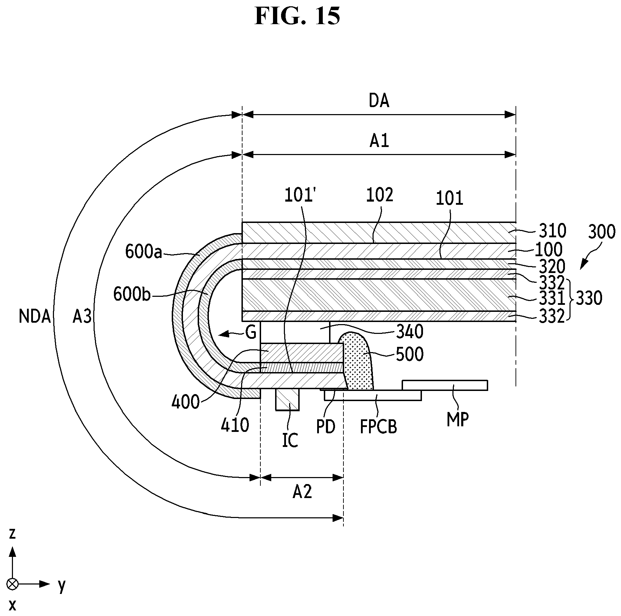

FIG. 15 is a cross-sectional view illustrating a state in which the display device of FIG. 7 is bent, and more specifically, is a cross-sectional view illustrating a state in which the non-display area NDA is bent.

Referring to FIG. 15, the display panel 100 of the display device 1 may be bent in the downward direction of the display panel 100 based on the bending axis BX (refer to FIG. 1) extending along the first direction x in the third area A3.

The gap G overlapping the third area A3 is defined between the panel cover 300 and the support layer 400, and thus, the display panel 100 may be more easily bent. In this case, the support layer 400 is attached to the bending adhesive member 340 of the panel cover 300, and accordingly, the bending position of the display panel 100 is fixed by the bending adhesive member 340.

Here, an alignment state may be changed depending on a position where the support layer 400 is attached to the bending adhesive member 340, and for example, the display panel 100, the support layer 400, and the bonding layer 410 may all be aligned with each other in a line in the vertical direction. In an alternative embodiment, as illustrated in FIG. 11, the support layer 400 is moved to and fixed at the right, and accordingly, the display panel 100, the support layer 400, and the bonding layer 410 may be fixed while forming a step.

A portion of the non-display area NDA of the display panel 100 is bent, and accordingly, an advantage that an area of the non-display area NDA of the display device 1 viewed from the outside may be reduced and an advantage that a bezel width of the display device 1 may be reduced may be implemented. In addition, since the neutral surface adjustment layer 600a overlapping the third area A3 is disposed on the display panel 100, it is possible to prevent a crack from occurring in the conductive layers of the display panel 100 in the third area A3, and accordingly, reliability of the display device 1 may be improved.

When the display panel 100 is bent based on the third area A3 so that the flexible printed circuit board FPCB, the main circuit board MP, the support layer 400, the bonding layer 410, the driving chip IC, and the board cover 500 are disposed on the first surface 101 of the display panel 100, a first surface 101' of the display panel 100 in the second area A2 and the first surface 101 of the display panel 100 in the first area A1 may be disposed in parallel with each other. In an embodiment, since the display panel 100 in the second area A2 is supported by the support layer 400, the first surface 101' of the display panel 100 in the second area A2 and the first surface 101 of the display panel 100 in the first area A1 may be parallel to each other, for example. Accordingly, a bending area may have a shape more similar to a curved line, and a curvature of the bending area may become smaller by the support layer 400 of the second area A2, such that it is possible to make the display device 1 slim.

Hereinafter, a method of manufacturing the display device 1 in an embodiment will be described.

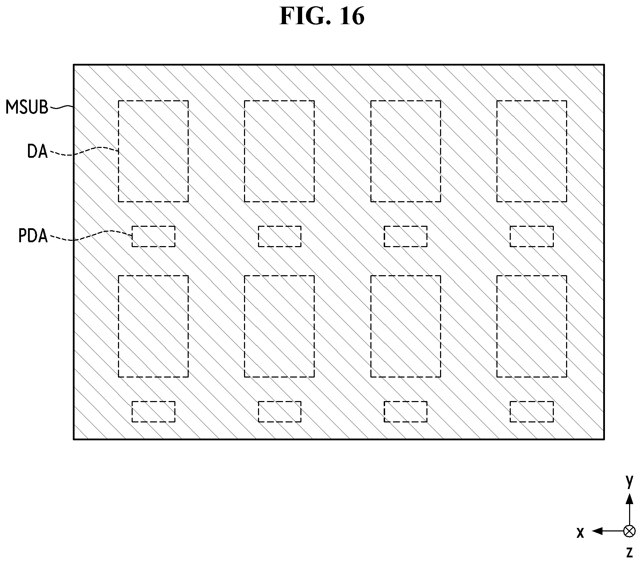

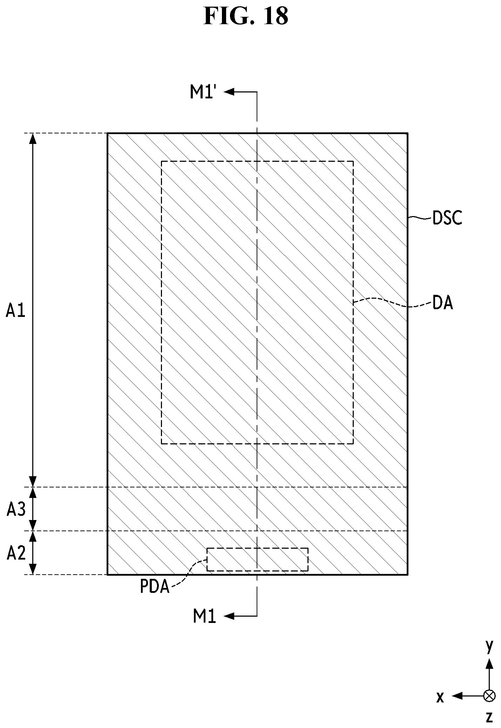

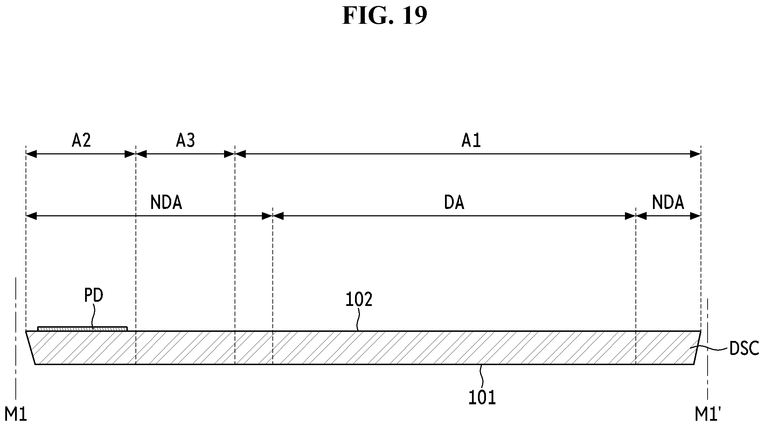

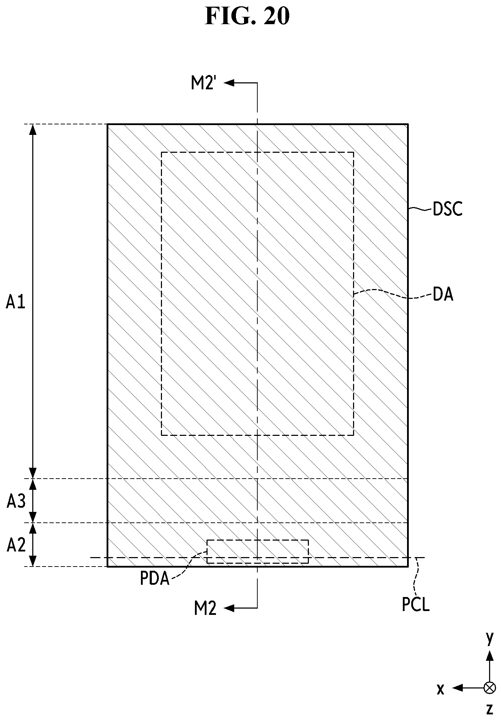

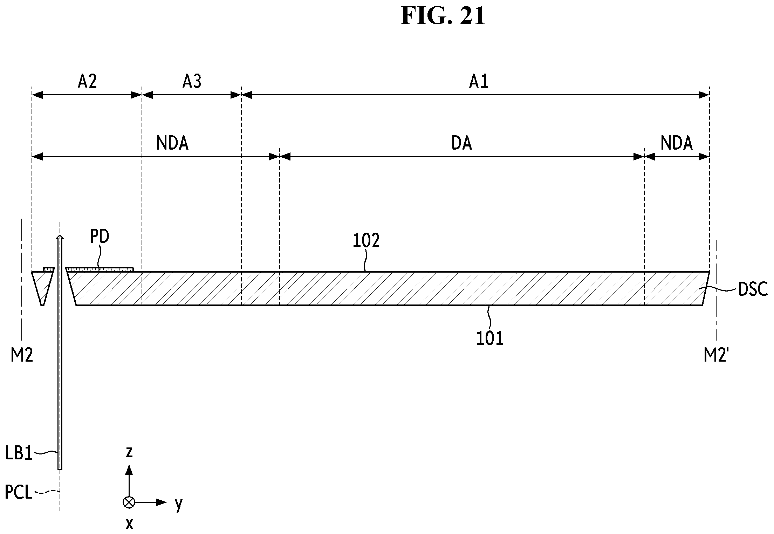

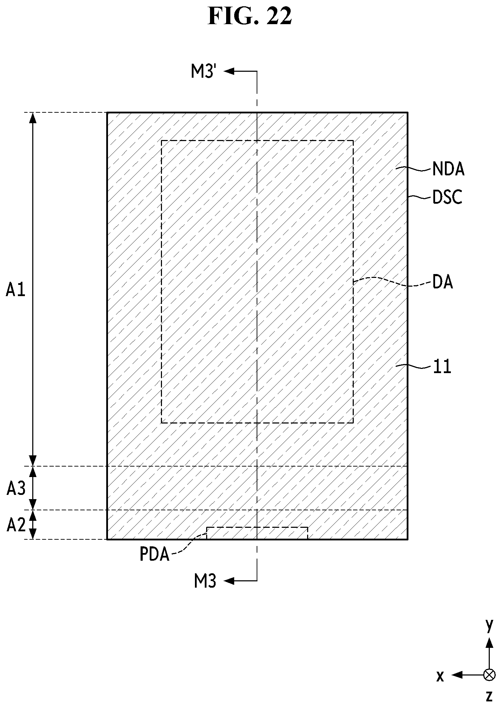

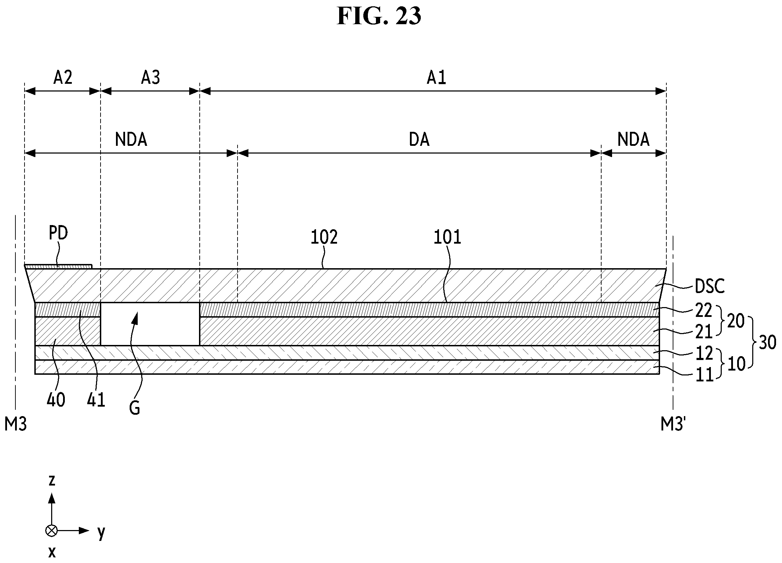

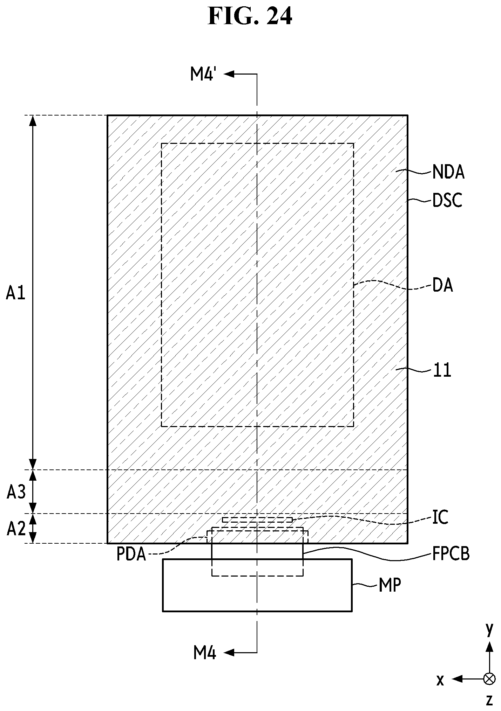

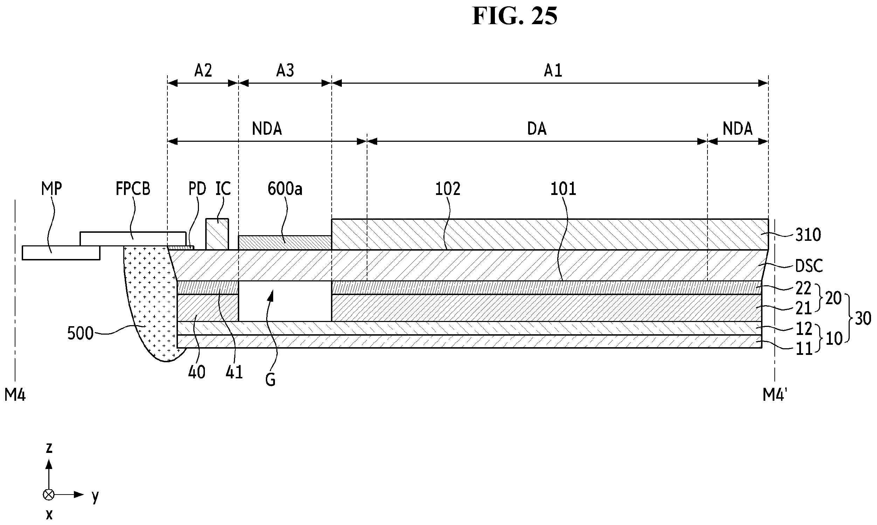

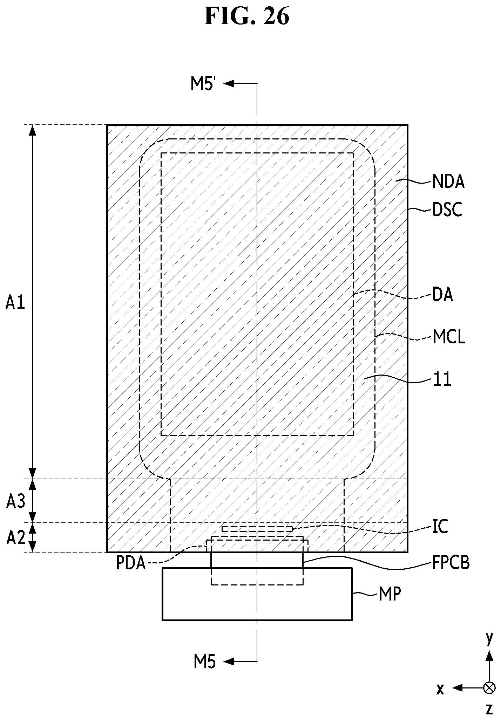

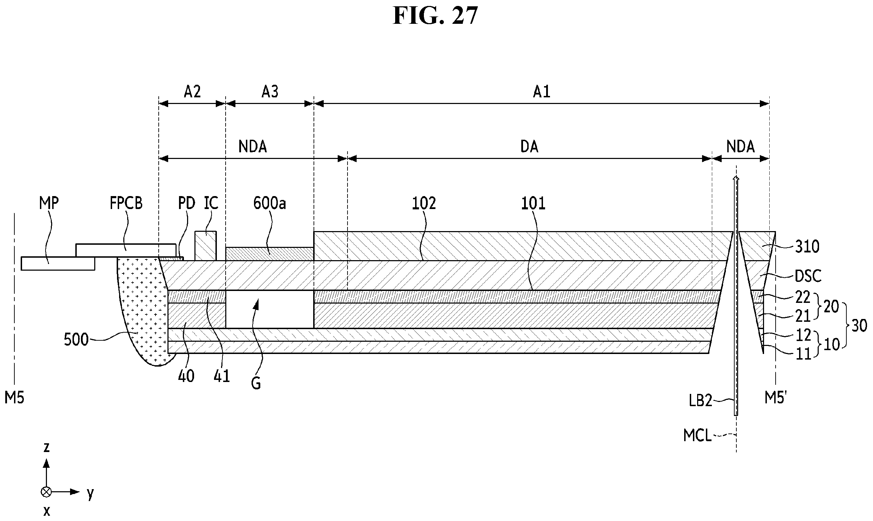

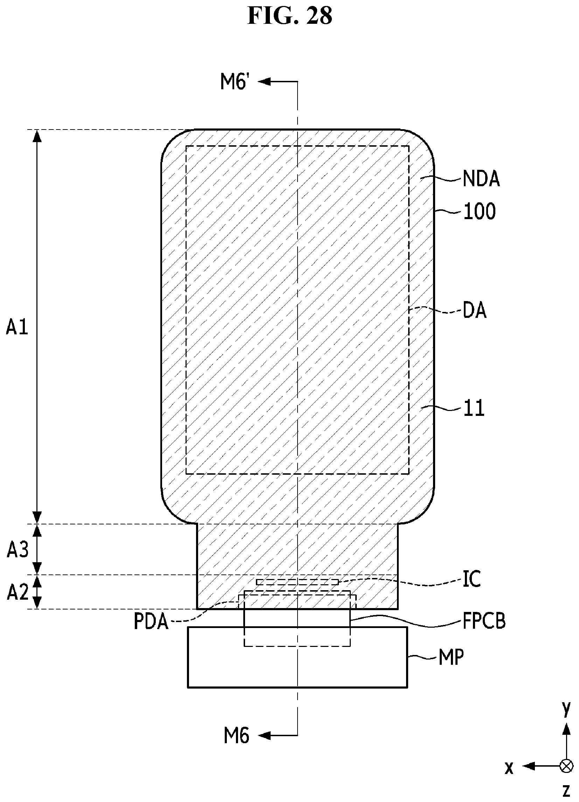

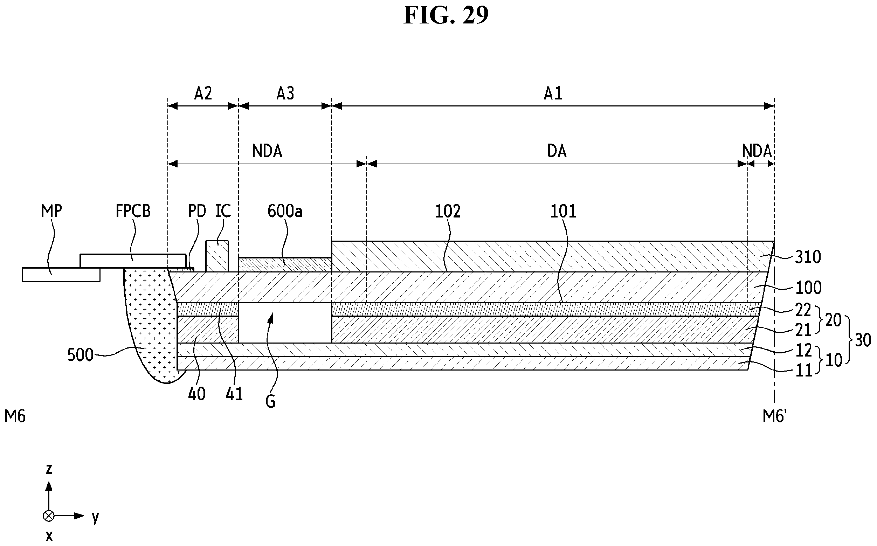

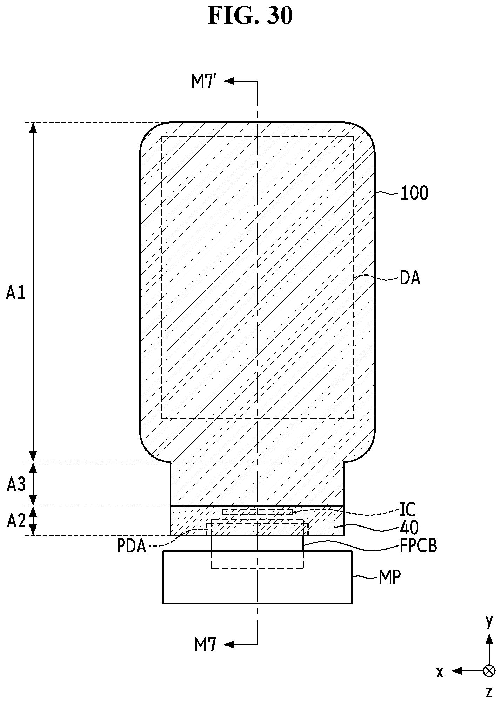

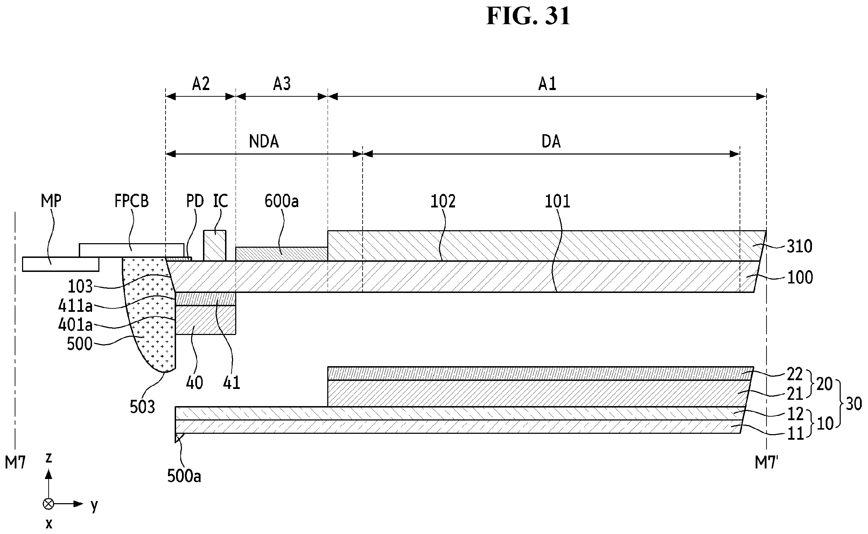

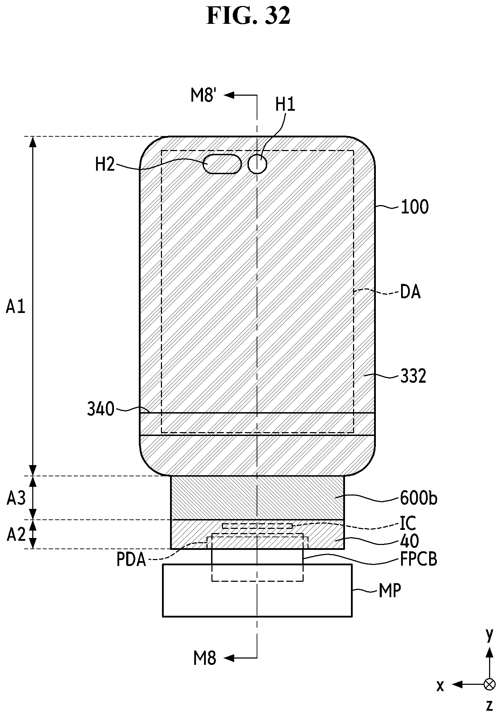

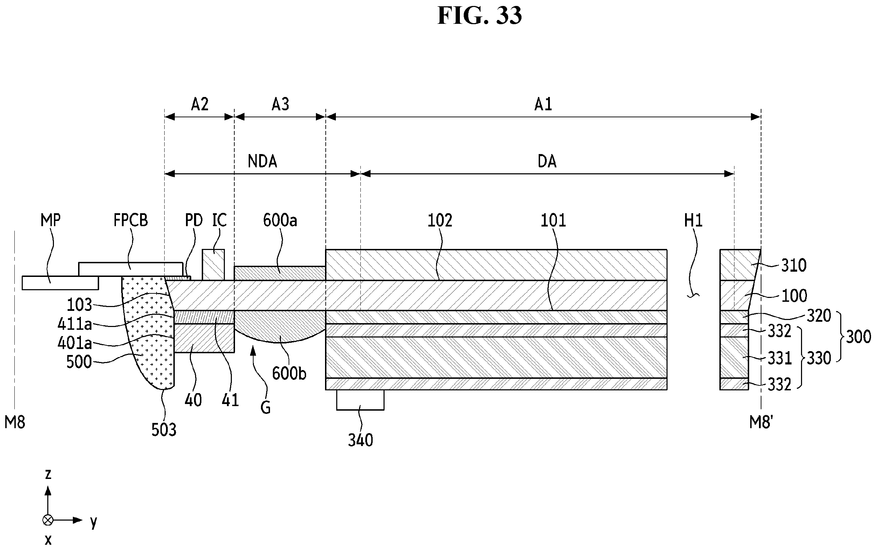

FIGS. 16 to 33 are cross-sectional views for describing an embodiment of processes of a method of manufacturing the display device 1. Here, FIG. 19 is a cross-sectional view taken along line M1-M1' of FIG. 18, FIG. 21 is a cross-sectional view taken along line M2-M2' of FIG. 20, FIG. 23 is a cross-sectional view taken along line M3-M3' of FIG. 22, FIG. 25 is a cross-sectional view taken along line M4-M4' of FIG. 24, FIG. 27 is a cross-sectional view taken along line M5-M5' of FIG. 26, FIG. 29 is a cross-sectional view taken along line M6-M6' of FIG. 28, FIG. 31 is a cross-sectional view taken along line M7-M7' of FIG. 30, and FIG. 33 is a cross-sectional view taken along line M8-M8' of FIG. 32.

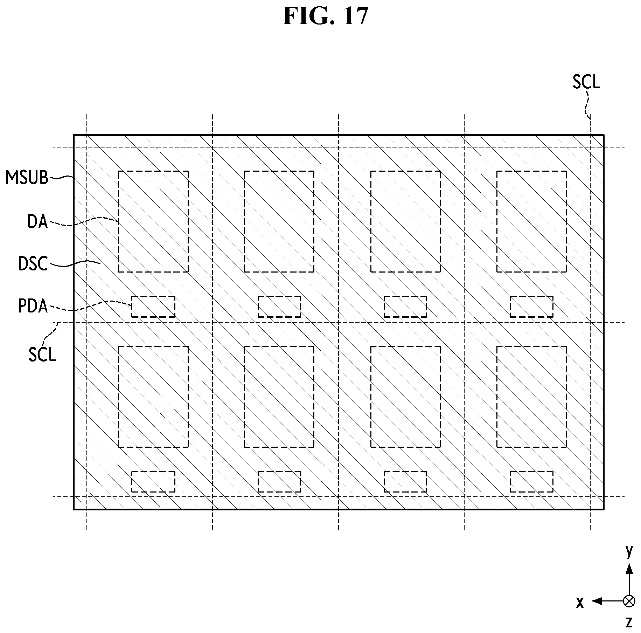

In this case, FIGS. 16 and 17 are views illustrating a rear surface of a mother substrate MSUB, and FIGS. 18, 20, 22, 24, and 26 are views illustrating a rear surface of a display cell DSC, and FIGS. 28, 30, and 32 are views illustrating a rear surface of a display panel 100.

First, as illustrated in FIG. 16, the mother substrate MSUB may be prepared. The mother substrate MSUB may include a plurality of display cells DSC each corresponding to the above-described display panel 100. In an embodiment, the mother substrate MSUB may include a plurality of display cells DSC, for example. Each display cell DSC may include a display area DA and a pad area PDA.

Subsequently, as illustrated in FIG. 17, the mother substrate MSUB may be cut through a substrate cutting process (e.g., a scribing process). In an embodiment, as illustrated in FIG. 17, the plurality of display cells DSC (e.g., display panels 100) may be generated from one mother substrate MSUB by cutting the mother substrate MSUB along a plurality of cutting lines SCL, for example. In other words, the plurality of display cells DSC may be separated from the one mother substrate MSUB through the substrate cutting process.

The substrate cutting process may be performed by a laser device providing a laser beam. The laser beam may be any one of a CO₂ laser, a green laser, an infrared laser, and an ultraviolet laser, for example, but is not limited thereto.

Any one of the display cells DSC of FIG. 17 has been illustrated in FIGS. 18 and 19. The display cell DSC may include the display area DA, the non-display area NDA, the first area A1, the second area A2, and the third area A3 as described above.

In an embodiment, a cross-sectional stacked structure of the display cell DSC of FIG. 18 may be the same as the structure of the display panel 100 illustrated in FIGS. 5 and 6 described above, for example. In other words, the display cell DSC of FIG. 18 may have a different shape from the display panel 100 only in a plan view, and may have the same cross-sectional structure as the display panel 100 described above. In an embodiment, in a plan view, the first area A1, the second area A2, the third area A3, the pad area PDA, and the non-display area NDA of the display cell DSC may have different shapes from the first area A1, the second area A2, the third area A3, the pad area PDA, and the non-display area NDA of the display panel 100 of FIG. 2 (or FIG. 3), for example. In addition, in a plan view, the first area A1, the second area A2, the third area A3, the pad area PDA, and the non-display area NDA of the display cell DSC may have different shapes from the first area A1, the second area A2, the third area A3, the pad area PDA, and the non-display area NDA of the display panel 100 of FIG. 2 (or FIG. 3) described above, respectively. In addition, in a plan view, the first area A1, the second area A2, the third area A3, the pad area PDA, and the non-display area NDA of the display cell DSC may have different areas from the first area A1, the second area A2, the third area A3, the pad area PDA, and the non-display area NDA of the display panel 100 of FIG. 2 (or FIG. 3) described above, respectively. The display area DA of the display cell DSC may have the same shape and size as the display area DA of the display panel 100 illustrated in FIG. 2 (or FIG. 3) described above.

As illustrated in FIG. 19, an edge of the display cell DSC separated from the mother substrate MSUB may include a side surface extending in the oblique direction. In an embodiment, the laser beam from the laser device may be used during the cutting process of the mother substrate MSUB, and thus, the edge of the display cell DSC (e.g., the side surface of the display cell DSC) separated from the mother substrate MSUB may have an oblique shape by contact with the laser beam, for example.

Thereafter, a driving test of the display cell DSC may be performed. In an embodiment, test signals may be applied to the pad area PDA of the display cell DSC. The test signals may be applied to pads PD of the pad area PDA, for example. For the driving test, one sides of the pads PD of the pad area PDA of FIG. 18 may be connected to each other. In other words, the pads PD of the pad area PDA of FIG. 18 are in a state before being separated from each other.

When it is confirmed that the display cell DSC operates normally as a result of the driving test of the display cell DSC, a process of cutting the pad area PDA of the display cell DSC may be performed. In an embodiment, a pad cutting process for the pad area PDA may be performed so that the pads PD of the pad area PDA are separated from each other, for example. In an embodiment, as illustrated in FIGS. 20 and 21, portions of the pads PD of the pad area PDA are cut by an intense light, e.g., a laser beam LB 1, so that the pads PD may be electrically separated from each other, for example. The laser beam LB1 may move along a cutting line PCL crossing the pads PD of the pad area PDA.

As illustrated in FIG. 21, an edge of the pad PD (e.g., a side surface of the pad PD) and the edge of the display cell DSC (e.g., the side surface of the display cell DSC) may have an oblique shape by contact with the laser beam LB1.

Next, as illustrated in FIGS. 22 and 23, a reinforcing film 30 may be attached to a first surface 101 of the display cell DSC. The reinforcing film 30 may overlap the first area A1, the second area A2, and the third area A3 of the display cell DSC.

The reinforcing film 30 may include a carrier member 10 and a support member 20.

The support member 20 may be disposed on the carrier member 10. In an embodiment, the support member 20 may be disposed between the carrier member 10 and the display cell DSC, for example.

The carrier member 10 may include a base layer 11 and a common bonding layer 12.

The base layer 11 may overlap the display cell DSC. In an embodiment, the base layer 11 may overlap the first area A1, the second area A2, and the third area A3 of the display cell DSC, for example. The base layer 11 may include at least one of PET, PC, and PMMA, for example.

The common bonding layer 12 may be disposed on the base layer 11 so as to overlap the first area A1, the second area A2, and the third area A3 of the display cell DSC. In an embodiment, in a plan view, an area of the common bonding layer 12 may be the same as an area of the base layer 11, for example. The common bonding layer 12 may include at least one of a polyester acrylate resin, an unsaturated polyester resin, a polyurethane acrylate resin, an epoxy acrylate resin, an epoxy resin, a polyether acrylate resin, and a polythiol acrylate resin, for example.

The support member 20 may include a plurality of support layers 40 and 21 separated from each other and a plurality of bonding layers 41 and 22 separated from each other. In an embodiment, the support member 20 may include a first support layer 21, a second support layer 40, a first bonding layer 22, and a second bonding layer 41, for example.

The first support layer 21 and the second support layer 40 may be disposed on the common bonding layer 12 of the carrier member 10. In an embodiment, the first support layer 21 may be disposed on the common bonding layer 12 in the first area A1 of the display cell DSC, and the second support layer 40 may be disposed on the common bonding layer 12 in the second area A2 of the display cell DSC, for example. Specifically, the first support layer 21 may be disposed between the common bonding layer 12 and the first bonding layer 22 in the first area A1, and the second support layer 40 may be disposed between the common bonding layer 12 and the second bonding layer 41 in the second area A2. The first support layer 21 of the first area A1 and the second support layer 40 of the second area A2 may be disposed with the third area A3 of the display cell DSC interposed therebetween. In other words, the first support layer 21 and the second support layer 40 may be spaced apart from each other by a gap G of the third area A3. Accordingly, the first support layer 21 and the second support layer 40 may be disposed on the common bonding layer 12 without direct contact with each other in the same layer. In plan view, the first support layer 21 and the second support layer 40 may have different areas. In an embodiment, an area of the first support layer 21 may be greater than an area of the second support layer 40, for example. Each of the first support layer 21 and the second support layer 40 may include at least one of PET, PC, and PMMA.

The first bonding layer 22 may be disposed on the first support layer 21, and the second bonding layer 41 may be disposed on the second support layer 40. In an embodiment, the first bonding layer 22 may be disposed on the first support layer 21 in the first area A1 of the display cell DSC, and the second bonding layer 41 may be disposed on the second support layer 40 in the second area A2 of the display cell DSC, for example. Specifically, the first bonding layer 22 may be disposed between the first support layer 21 and the display cell DSC in the first area A1, and the second bonding layer 41 may be disposed between the second support layer 40 and the display cell DSC in the second area A2. The first bonding layer 22 of the first area A1 and the second bonding layer 41 of the second area A2 may be disposed with the third area A3 of the display cell DSC interposed therebetween. Accordingly, the first bonding layer 22 and the second bonding layer 41 may be disposed on the first support layer 21 and the second support layer 40, respectively, without direct contact with each other in the same layer. In plan view, the first bonding layer 22 and the second bonding layer 41 may have different areas. In an embodiment, an area of the first bonding layer 22 may be greater than an area of the second bonding layer 41, for example. In plan view, the area of the first bonding layer 22 may be the same as the area of the first support layer 21, and the area of the second bonding layer 41 may be the same as the area of the second support layer 40. However, the invention is not limited thereto, and in a plan view, the first bonding layer 22 and the first support layer 21 may have different areas, and the second bonding layer 41 and the second support layer 40 may have different areas. Each of the first bonding layer 22 and the second bonding layer 41 may include at least one of a polyester acrylate resin, an unsaturated polyester resin, a polyurethane acrylate resin, an epoxy acrylate resin, an epoxy resin, a polyether acrylate resin, and a polythiol acrylate resin, for example.

In an embodiment, the support member 20 may have different adhesive strengths from each other for each area at an interface between the support member 20 and the carrier member 10. In an embodiment, at the interface between the support member 20 and the carrier member 10, the support member 20 of the second area A2 may have a smaller adhesive strength than the support member 20 of the first area A1, for example. To this end, in an embodiment, an adhesive strength between the second support layer 40 of the support member 20 in the second area A2 and the common bonding layer 12 of the carrier member 10 may be smaller than an adhesive strength between the first support layer 21 of the support member 20 in the first area A1 and the common bonding layer 12 of the carrier member 10. To this end, in an embodiment, an interface (hereinafter also referred to as a first interface) between the first support layer 21 and the common bonding layer 12 and an interface (hereinafter also referred to as a second interface) between the second support layer 40 and the common bonding layer 12 may have different characteristics. In an embodiment, surface characteristics of the second support layer 40 at the second interface and surface characteristics of the first support layer 21 at the first interface may be different from each other so that the adhesive strength between the second support layer 40 and the common bonding layer 12 may be smaller than the adhesive strength between the first support layer 21 and the common bonding layer 12, for example. To this end, in an embodiment, a surface of the second support layer 40 at the second interface may have higher hydrophobicity than a surface of the first support layer 21 at the first interface. Accordingly, during a peeling process of the reinforcing film 30 (e.g., the carrier member 10 of the reinforcing film 30), the second support layer 40 of the support member 20 and the common bonding layer 12 of the carrier member 10 may be easily separated from each other with the same peeling force (e.g., release force), whereas the first support layer 21 of the support member 20 and the common bonding layer 12 of the carrier member 10 may not be easily separated from each other with the same peeling force.

In addition, in an embodiment, the support member 20 may have different adhesive strengths from each other for each area at an interface between the support member 20 and the display cell DSC. In an embodiment, at the interface between the support member 20 and the display cell DSC, the support member 20 of the second area A2 may have a greater adhesive strength than the support member 20 of the first area A1, for example. To this end, in an embodiment, an adhesive strength between the second bonding layer 41 of the support member 20 in the second area A2 and display cell DSC may be greater than an adhesive strength between the first bonding layer 22 of the support member 20 in the first area A1 and the display cell DSC. To this end, in an embodiment, the first bonding layer 22 and the second bonding layer 41 may include different materials from each other. Accordingly, during a peeling process of the reinforcing film 30 (e.g., the carrier member 10 of the reinforcing film 30), the second bonding layer 41 of the support member 20 and the display cell DSC may not be easily separated from each other with the same peeling force, whereas the first bonding layer 22 of the support member 20 and the display cell DSC may be easily separated from each other with the same peeling force.

Therefore, during the peeling process of the reinforcing film 30 (e.g., the carrier member 10 of the reinforcing film 30), only the first support layer 21 and the first bonding layer 22 of the first area A1 may be separated (or removed, or peeled) from the display cell DSC, and the second support layer 40 and the second bonding layer 41 of the second area A2 may not be separated (or removed, or peeled) from the display cell DSC. In other words, after the peeling process of the reinforcing film 30, only the second support layer 40 and the second bonding layer 41 of components of the reinforcing film 30 may remain in a state in which they are attached to the second area A2 of the display cell DSC.

Thereafter, as illustrated in FIGS. 24 and 25, a polarizing plate 310, a first reinforcing layer 600a, a driving chip IC, a flexible printed circuit board FPCB, a main circuit board MP, and a board cover 500 may be formed on the display cell DSC.

In an embodiment, the polarizing plate 310 may be disposed in the third direction z on a second surface 102 of the display cell DSC in the first area A1, the flexible printed circuit board FPCB may be disposed in the third direction z on the second surface 102 of the display cell DSC in the second area A2, the main circuit board MP may be connected to the flexible printed circuit board FPCB, and the first reinforcing layer 600a may be disposed in the third direction z on the second surface 102 of the display cell DSC in the third area A3, for example. In addition, the board cover 500 in contact with a first surface of the reinforcing film 30 (e.g., a first surface of the carrier member 10), a side surface of the reinforcing film 30 (e.g., a side surface of the base layer 11, a side surface of the common bonding layer 12, a side surface of the second support layer 40 and a side surface of the second bonding layer 41), the side surface of the display cell DSC, the side surface of the pad PD, and a first surface of the flexible printed circuit board FPCB may be formed in the third reverse direction on the first surface of the reinforcing film 30.

Subsequently, as illustrated in FIGS. 26 and 27, a processing process for the display cell DSC may be performed. Such a processing process may be performed by a laser device providing an intense light, e.g., a laser beam LB2. In an embodiment, as illustrated in FIGS. 26 and 27, the laser beam LB2 from the laser device may be irradiated from the lower side of the reinforcing film 30 toward the display cell DSC, and such a laser beam LB2 may move along a processing line MCL that is preset, for example. Accordingly, the display cell DSC may be cut along the processing line MCL, and in this case, the display cell DSC may be manufactured into a display panel 100 having a desired shape. In an embodiment, the display cell DSC may be processed to have the display panel 100 with a shape as illustrated in FIG. 2 (or FIG. 3) described above, for example. As a predetermined example, by such a processing process, shapes and areas of the non-display area NDA, the first area A1, the second area A2, and the third area A3 of the display cell DSC may be changed to be the same as shapes and areas of the non-display area NDA, the first area A1, the second area A2, and the third area A3 of the display panel 100 illustrated in FIG. 2 (or FIG. 3) described above.

During the processing process for the display cell DSC described above, the reinforcing film 30, the first reinforcing layer 600a, and the polarizing plate 310 may also be cut together along the processing line MCL. In this case, the driving chip IC, the flexible printed circuit board FPCB, the main circuit board MP, and the board cover 500 do not cross the processing line MCL, and thus, may not be cut.

The processed display cell DSC may be substantially the same as the display panel 100 as illustrated in the FIG. 2 (or FIG. 3) described above. Accordingly, a shape of the processed display cell DSC may be the same as the shape of the display panel 100 as illustrated in the FIG. 2 (or FIG. 3) described above. Accordingly, the display area DA, the non-display area NDA, the first area A1, the second area A2, and the third area A3 of the processed display cell DSC may have the same shapes and areas as the display area DA, the non-display area NDA, the first area A1, the second area A2, and the third area A3 of the display panel 100 illustrated in FIG. 2 (or FIG. 3) described above, respectively.

The processed display cell DSC (e.g., the display panel 100) has been illustrated in FIGS. 28 and 29. Hereinafter, the processed display cell DSC will be also referred to as a display panel 100.

Subsequently, as illustrated in FIGS. 30 and 31, the peeling process of the reinforcing film 30 may be performed.

The reinforcing film 30 may include the carrier member 10 and the support member 20. In this case, as described above, the support member 20 of the second area A2 may have a smaller adhesive strength than the support member 20 of the first area A1 at the interface between the support member 20 and the carrier member 10, and the support member 20 of the second area A2 may have a greater adhesive strength than the support member 20 of the first area A1 at the interface between the support member 20 and the display cell DSC (e.g., the display panel 100).

Accordingly, during the peeling process of the reinforcing film 30, only the first support layer 21 and the first bonding layer 22 of the first area A1 may be separated (or removed, or peeled) from the display panel 100, and the second support layer 40 and the second bonding layer 41 of the second area A2 may not be separated (or removed, or peeled) from the display panel 100. In other words, after the peeling process of the reinforcing film 30, only the second support layer 40 and the second bonding layer 41 of the components of the reinforcing film 30 may remain in a state in which they are attached to the second area A2 of the display panel 100.

In an embodiment, during the peeling process of the reinforcing film 30, a portion of the board cover 500 may be removed. In an embodiment, as illustrated in FIG. 31, a portion of the board cover 500 (hereinafter also referred to as a dummy cover layer 500a) disposed on the first surface of the carrier member 10 may be removed together with the carrier member 10 during the peeling process of the reinforcing film 30, for example. In other words, the dummy cover layer 500a formed on the carrier member 10 may be removed from the board cover 500. Accordingly, the board cover 500 may be formed to contact a side surface 401a of the second support layer 40, a side surface 411a of the second bonding layer 41, a side surface 103 of the display panel 100, the side surface of the pad PD, and the first surface of the flexible printed circuit board FPCB. In addition, a first surface 503 of the board cover 500 may extend downward more than the second support layer 40.

The second support layer 40 and the second bonding layer 41 may be the same as the support layer 400 and the bonding layer 410 of FIG. 10 described above, respectively. In other words, the support layer 400 and the bonding layer 410 of FIG. 10 may be formed by the peeling process of the reinforcing film 30 described with reference to FIGS. 30 and 31.

Subsequently, as illustrated in FIGS. 32 and 33, an adhesive member 320, a heat dissipation member 330, and a bending adhesive member 340 may be disposed on the first surface 101 of the display panel 100 in the first area A1. The heat dissipation member 330 may be attached to the first surface 101 of the display panel 100 by the adhesive member 320. The bending adhesive member 340 may be attached to a first surface of the heat dissipation member (e.g., a first surface of a plating layer 332).

Thereafter, a second reinforcing layer 600b may be disposed on the first surface 101 of the display panel 100 in the third area A3. In an embodiment, the second reinforcing layer 600b may be formed by applying a raw material of the second reinforcing layer 600b to the first surface 101 of the display panel 100 in the third area A3 by an inkjet method and then curing the raw material of the second reinforcing layer 600b, for example.

Next, a first hole H1 penetrating through the polarizing plate 310, the display panel 100, the adhesive member 320, and the heat dissipation member 330 in the display area DA of the display panel 100 may be defined or formed. In addition, a second hole H2 penetrating through the adhesive member 320 and the heat dissipation member 330 in the display area DA of the display panel 100 may be defined or formed.

The first hole H1 may be defined, e.g., by irradiating the polarizing plate 310, the display panel 100, the adhesive member 320, and the heat dissipation member 330 in the display area DA with a laser beam from the laser device described above.

The second hole H2 may be defined, e.g., by irradiating the adhesive member 320 and the heat dissipation member 330 in the display area DA with a laser beam from the laser device described above.

Next, as illustrated in FIG. 15, the display panel 100 may be bent toward the first surface 101 of the display panel 100 or the bending adhesive member 340 based on the bending axis BX (refer to FIG. 1) extending along the first direction x in the third area A3.

Subsequently, as illustrated in FIGS. 7 and 8, the first electronic component 551 may be disposed on the lower side of the heat dissipation member 330 so as to overlap the first hole H1, and the second electronic component 552 may be disposed on the lower side of the heat dissipation member 330 so as to overlap the second hole H2.

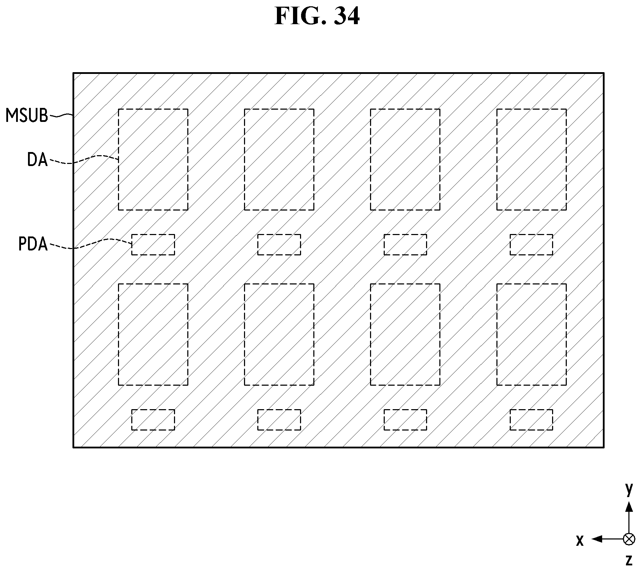

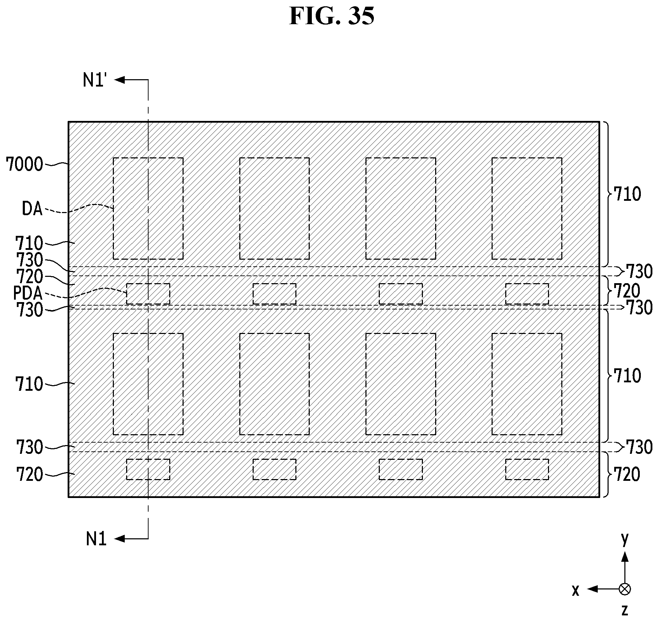

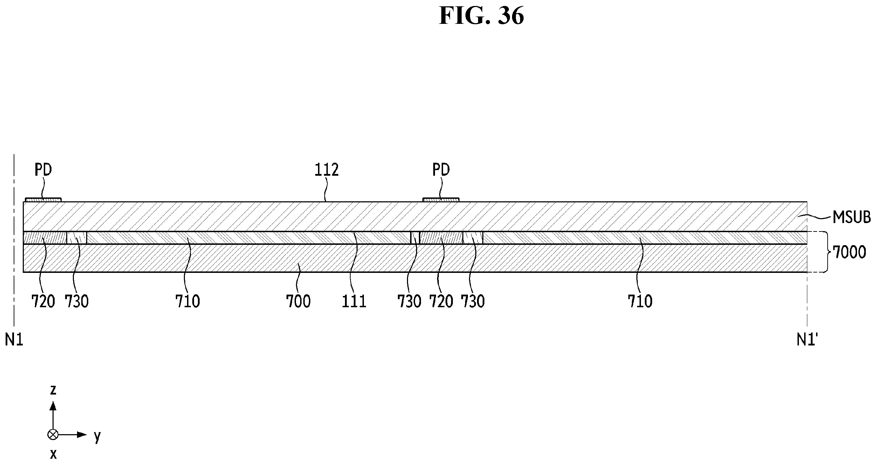

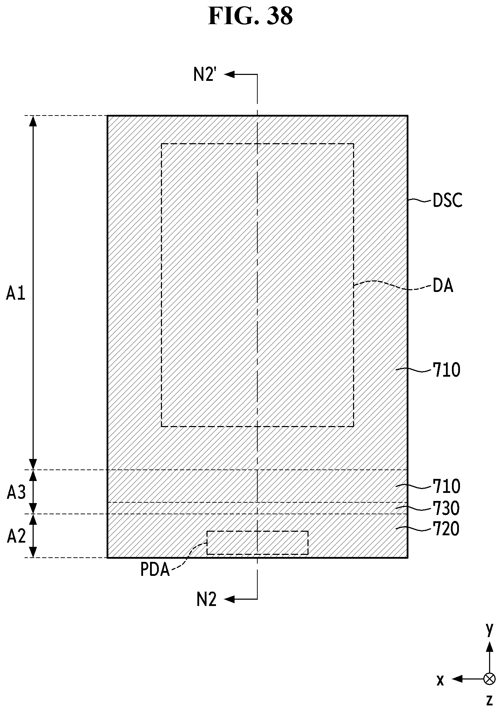

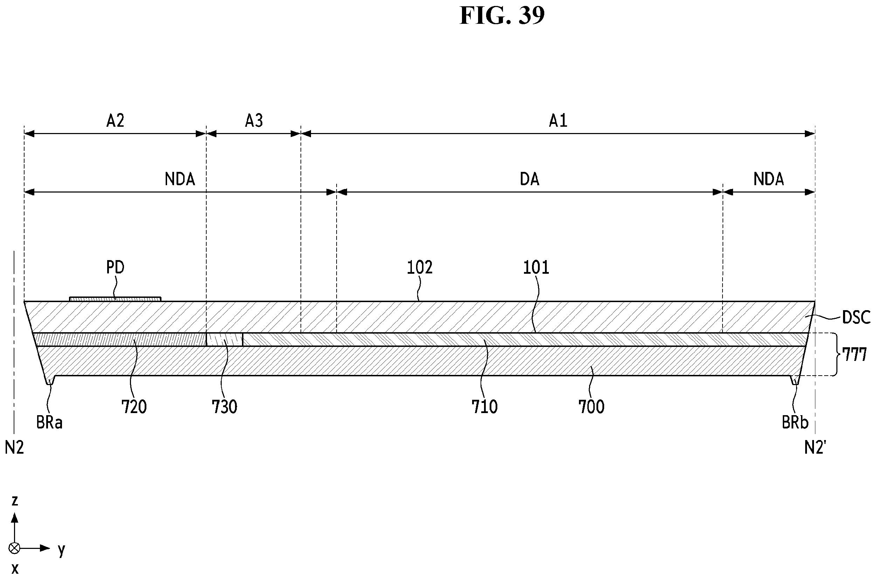

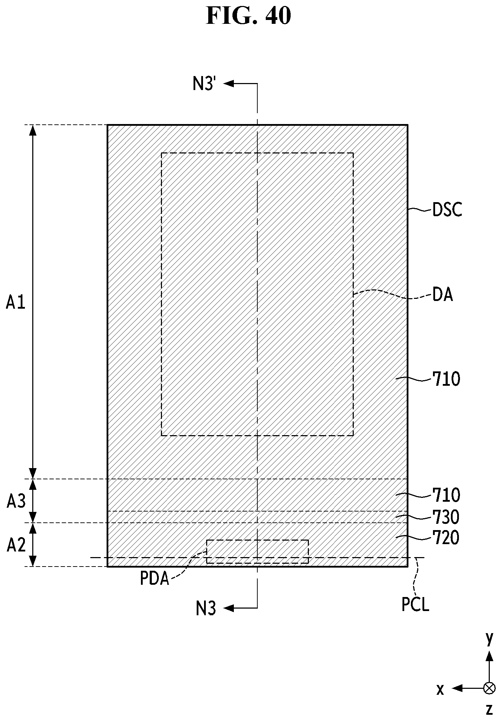

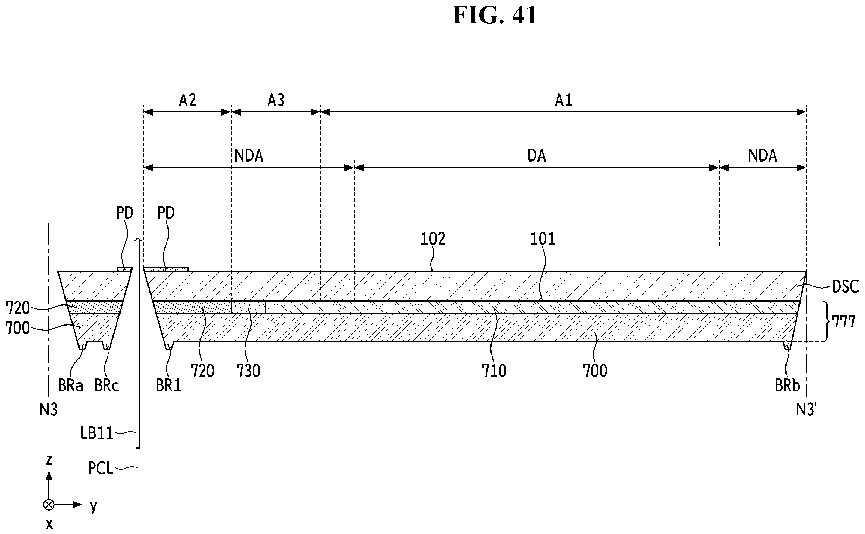

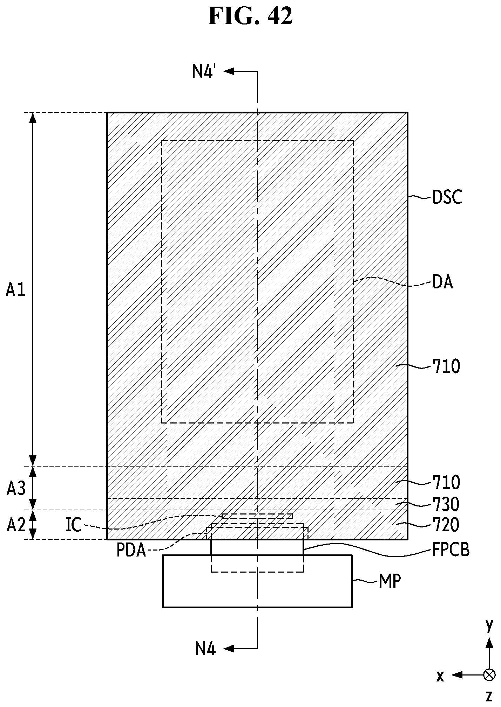

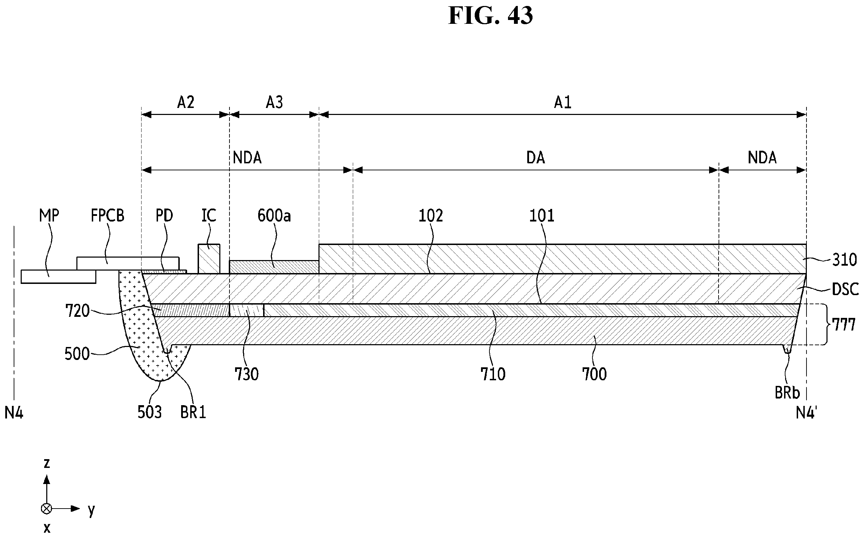

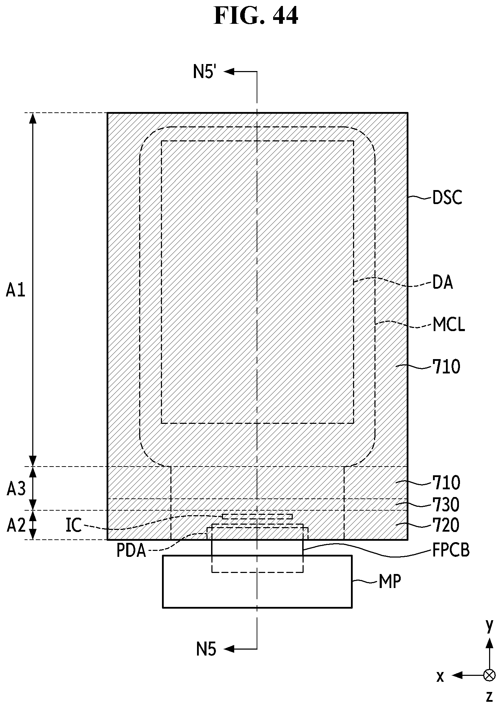

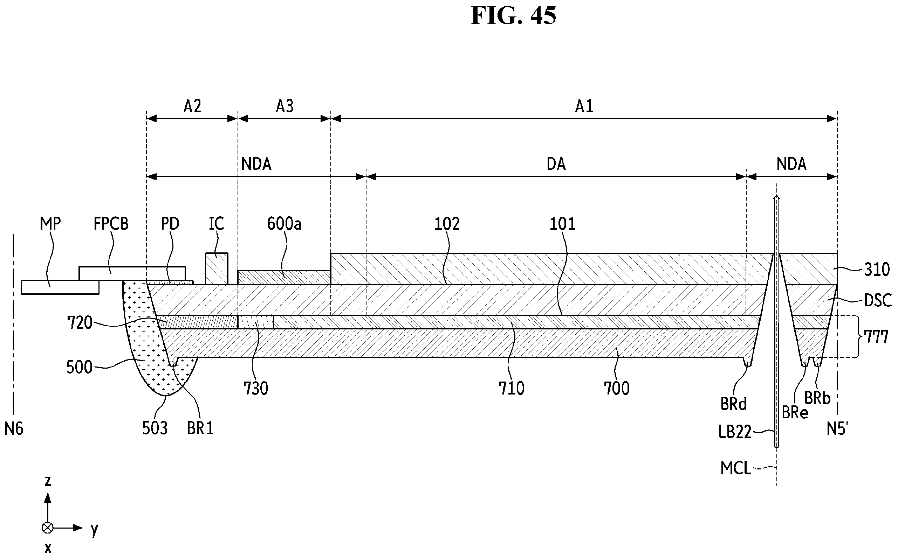

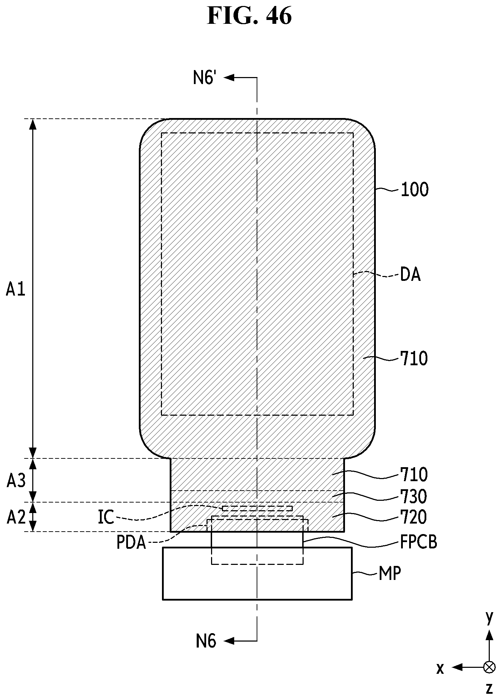

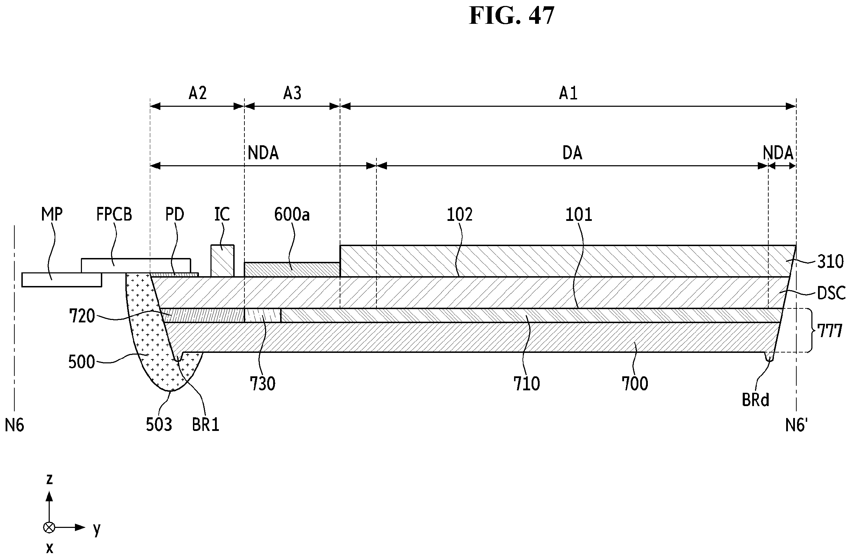

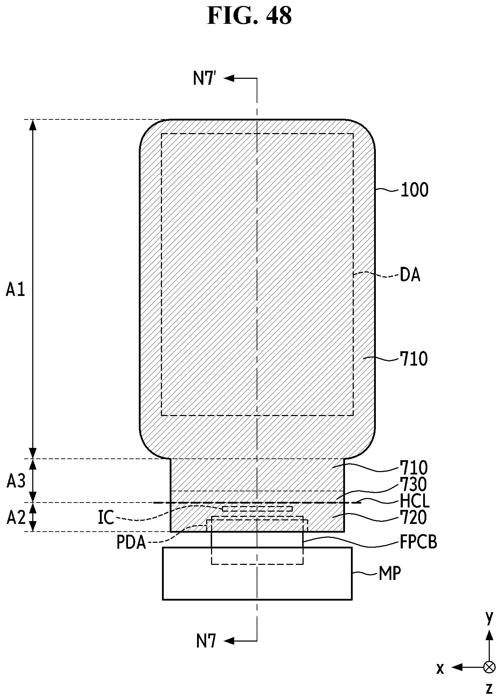

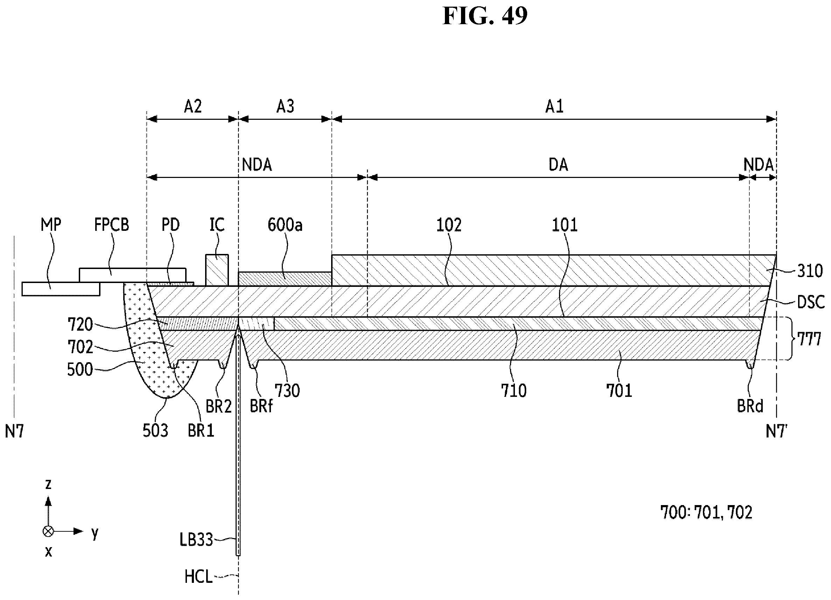

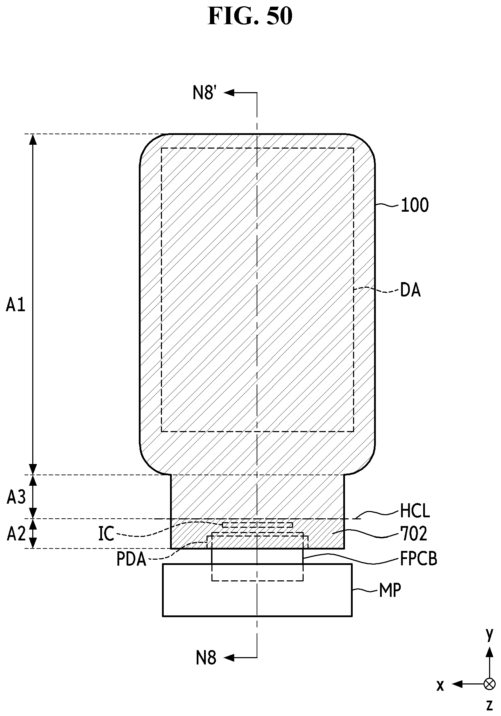

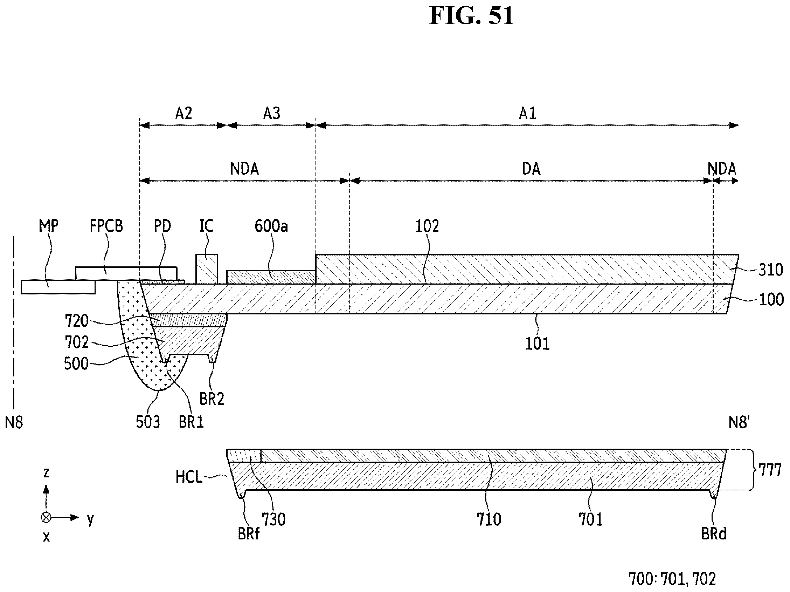

FIGS. 34 to 51 are cross-sectional views for describing another embodiment of processes of a method of manufacturing a display device. Here, FIG. 36 is a cross-sectional view taken along line N1-N1' of FIG. 35, FIG. 39 is a cross-sectional view taken along line N2-N2' of FIG. 38, FIG. 41 is a cross-sectional view taken along line N3-N3' of FIG. 40, FIG. 43 is a cross-sectional view taken along line N4-N4' of FIG. 42, FIG. 45 is a cross-sectional view taken along line N5-N5' of FIG. 44, FIG. 47 is a cross-sectional view taken along line N6-N6' of FIG. 46, FIG. 49 is a cross-sectional view taken along line N7-N7' of FIG. 48, and FIG. 51 is a cross-sectional view taken along line N8-N8' of FIG. 50. In this case, FIGS. 34, 35, and 37 are views illustrating a rear surface of a mother substrate MSUB, FIGS. 38, 40, 42, and 44 are views illustrating a rear surface of a display cell DSC, and FIGS. 46, 48, and 50 are views illustrating a rear surface of a display panel 100.

First, as illustrated in FIG. 34, the mother substrate MSUB may be prepared. The mother substrate MSUB may include a plurality of display cells DSC each corresponding to the above-described display panel 100. In an embodiment, the mother substrate MSUB may include a plurality of display cells DSC, for example. Each display cell DSC may include a display area DA and a pad area PDA. Here, a plurality of display areas DA, a plurality of pad areas PDA, and a plurality of pads PD may be disposed on a second surface 112 of the mother substrate MSUB.

Subsequently, as illustrated in FIGS. 35 and 36, a base reinforcing film 7000 may be prepared and then attached to a first surface 111 of the mother substrate MSUB. In plan view, an area of the base reinforcing film 7000 may be the same as an area of the mother substrate MSUB. In such a case, when the base reinforcing film 7000 is attached to the first surface of the mother substrate MSUB, an edge of the base reinforcing film 7000 may overlap an edge of the mother substrate MSUB in a plan view. However, the invention is not limited thereto, and an area of the mother substrate MSUB and an area of the base reinforcing film 7000 may be different from each other.

The base reinforcing film 7000 may include a support layer 700, first bonding layers 710, second bonding layers 720, and third bonding layers 730. The base reinforcing film 7000 may be manufactured by applying a raw material of the first bonding layer 710 and a raw material of the second bonding layer 720 onto the support layer 700 by an inkjet method and then curing the material of the first bonding layer 710 and the raw material of the second bonding layer 720, for example. In this case, the raw material of the first bonding layer 710 and the raw material of the second bonding layer 720 are mixed with each other at an interface between the first bonding layer 710 and the second bonding layer 720, such that the third bonding layer 730 may be formed. The first bonding layers 710 of the base reinforcing film 7000 may overlap the plurality of display areas DA of the mother substrate MSUB, the second bonding layers 720 of the base reinforcing film 7000 may overlap the plurality of pad areas PDA and the plurality of pads PD of the mother substrate MSUB, and the third bonding layers 730 of the base reinforcing film 7000 may be disposed between the plurality of display areas DA and the plurality of pad areas PDA of the mother substrate MSUB.

The support layer 700 may overlap the mother substrate MSUB. In plan view, an area of the support layer 700 may be the same as the area of the base reinforcing film 7000 described above.

As illustrated in FIG. 36, the first bonding layers 710, the second bonding layers 720, and the third bonding layers 730 may be disposed on the support layer 700. The first bonding layers 710, the second bonding layers 720, and the third bonding layers 730 may be sequentially disposed and repeatedly disposed along the second direction y on the support layer 700. Each of the first bonding layers 710, the second bonding layers 720, and the third bonding layers 730 may extend along the first direction x.

In plan view, the third bonding layer 730 may be disposed between the first bonding layer 710 and the second bonding layer 720 next (adjacent) thereto. In plan view, an area of the second bonding layer 720 may be smaller than an area of the first bonding layer 710 and greater than an area of the third bonding layer 730.

Each of the first bonding layer 710, the second bonding layer 720, and the third bonding layer 730 may be disposed between the support layer 700 and the mother substrate MSUB. Here, the first bonding layer 710, the second bonding layer 720, and the third bonding layer 730 may be disposed in the same layer. In other words, the first bonding layer 710, the second bonding layer 720, and the third bonding layer 730 may be disposed between the support layer 700 and the mother substrate MSUB, on the support layer 700.

The first bonding layer 710 may overlap a first area A1, a display area DA, a non-display area NDA, and a third area A3 of a display cell DSC to be described later. The first bonding layer 710 may be disposed between the support layer 700 and the first area A1 and between the support layer 700 and the third area A3. The first bonding layer 710 may include at least one of a polyester acrylate resin, an unsaturated polyester resin, a polyurethane acrylate resin, an epoxy acrylate resin, an epoxy resin, a polyether acrylate resin, and a polythiol acrylate resin, for example.

The second bonding layer 720 may overlap a second area A2 and a non-display area NDA of a display cell DSC to be described later. The second bonding layer 720 may be disposed between the support layer 700 and the second area A2. The second bonding layer 720 may include at least one of a polyester acrylate resin, an unsaturated polyester resin, a polyurethane acrylate resin, an epoxy acrylate resin, an epoxy resin, a polyether acrylate resin, and a polythiol acrylate resin, for example.

The third bonding layer 730 may overlap a third area A3 and a non-display area NDA of a display cell DSC to be described later. The third bonding layer 730 may be disposed between the support layer 700 and the third area A3. The third bonding layer 730 may include at least one of a polyester acrylate resin, an unsaturated polyester resin, a polyurethane acrylate resin, an epoxy acrylate resin, an epoxy resin, a polyether acrylate resin, and a polythiol acrylate resin, for example.

The first bonding layer 710, the second bonding layer 720, and the third bonding layer 730 may have different adhesive strengths from each other. In an embodiment, an adhesive strength of the second bonding layer 720 may be greater than an adhesive strength of the first bonding layer 710, and an adhesive strength of the third bonding layer 730 may be greater than the adhesive strength of the first bonding layer 710 and smaller than the adhesive strength of the second bonding layer 720, for example.

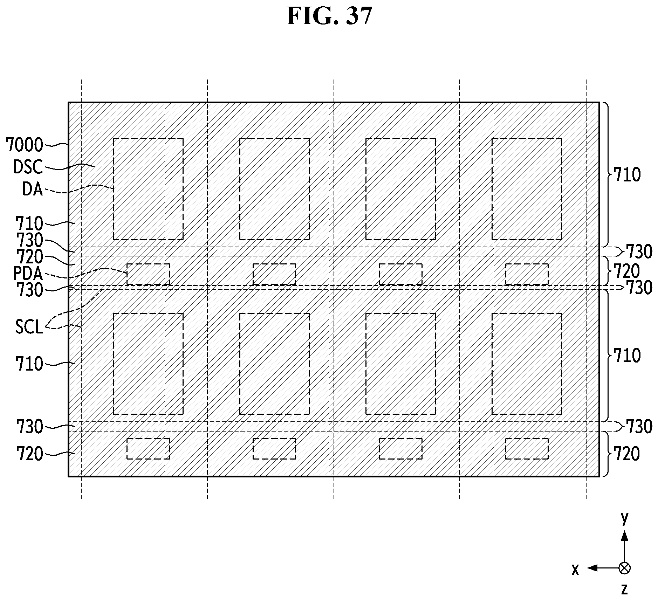

Next, as illustrated in FIG. 37, the mother substrate MSUB may be cut through a substrate cutting process (e.g., a scribing process). In an embodiment, as illustrated in FIG. 37, the plurality of display cells DSC (e.g., display panels 100) may be generated from one mother substrate MSUB by cutting the mother substrate MSUB along a plurality of cutting lines SCL, for example. In other words, the plurality of display cells DSC may be separated from the one mother substrate MSUB through the substrate cutting process. In this case, during the substrate cutting process, the base reinforcing film 7000 may also be cut so as to have the same shape as that of the display cell DSC. In other words, a plurality of unit reinforcing films 777 may be separated from one base reinforcing film 7000 through the substrate cutting process. Each unit reinforcing film 777 may be attached to a first surface of each display cell DSC.

Any one of the display cells DSC of FIG. 37 and one unit reinforcing film 777 attached to the display cell DSC have been illustrated in FIGS. 38 and 39. The display cell DSC may include the display area DA, the non-display area NDA, the first area A1, the second area A2, and the third area A3 as described above.

In an embodiment, a cross-sectional stacked structure of the display cell DSC of FIG. 38 may be the same as the structure of the display panel 100 illustrated in FIGS. 5 and 6 described above, for example. In other words, the display cell DSC of FIG. 38 may have a different shape from the display panel 100 only in a plan view, and may have the same cross-sectional structure as the display panel 100 described above. In an embodiment, in a plan view, the first area A1, the second area A2, the third area A3, the pad area PDA, and the non-display area NDA of the display cell DSC may have different shapes from the first area A1, the second area A2, the third area A3, the pad area PDA, and the non-display area NDA of the display panel 100 of FIG. 2 (or FIG. 3), for example. In addition, in a plan view, the first area A1, the second area A2, the third area A3, the pad area PDA, and the non-display area NDA of the display cell DSC may have different shapes from the first area A1, the second area A2, the third area A3, the pad area PDA, and the non-display area NDA of the display panel 100 of FIG. 2 (or FIG. 3) described above, respectively. In addition, in a plan view, the first area A1, the second area A2, the third area A3, the pad area PDA, and the non-display area NDA of the display cell DSC may have different areas from the first area A1, the second area A2, the third area A3, the pad area PDA, and the non-display area NDA of the display panel 100 of FIG. 2 (or FIG. 3) described above, respectively. The display area DA of the display cell DSC may have the same shape and size as the display area DA of the display panel 100 illustrated in FIG. 2 (or FIG. 3) described above.

As illustrated in FIG. 39, the unit reinforcing film 777 may be disposed on a first surface 101 of the display cell DSC. The unit reinforcing film 777 may be attached to the first surface 101 of the display cell DSC. The unit reinforcing film 777 may include a support layer 700, a first bonding layer 710, a second bonding layer 720, and a third bonding layer 730. The first bonding layer 710 may be disposed between the support layer 700 and the first area A1 of the display cell DSC, the second bonding layer 720 may be disposed between the support layer 700 and the second area A2 of the display cell DSC, and the third bonding layer 730 may be disposed between the support layer 700 and the third area A3. Here, the first bonding layer 710 may further extend to the third area A3. In other words, a portion of the first bonding layer 710 may be further disposed between the support layer 700 and the third area A3 of the display cell DSC. When a size of the third bonding layer 730 is sufficiently small, the first bonding layer 710 may overlap the entirety of the first area A1 and almost the entirety of the third area A3 of the display cell DSC.

As illustrated in FIG. 39, an edge of the display cell DSC separated from the mother substrate MSUB may include a side surface extending in the oblique direction. In an embodiment, a laser beam from a laser device may be used during a cutting process of the mother substrate MSUB, and thus, the edge of the display cell DSC (e.g., the side surface of the display cell DSC) separated from the mother substrate MSUB may have an oblique shape by contact with the laser beam, for example.

In addition, as illustrated in FIG. 39, an edge of the unit reinforcing film 777 separated from the base reinforcing film 7000 may include a side surface extending in the oblique direction. In an embodiment, a laser beam from the laser device may be used during a cutting process of the mother substrate MSUB and the base reinforcing film 7000, and thus, the edge of the unit reinforcing film 777 (e.g., the side surface of the unit reinforcing film 777) separated from the base reinforcing film 7000 may have a oblique shape by contact with the laser beam, for example. In this case, protrusion patterns BRa and BRb may be formed along edges of the support layer 700 (e.g., portions of the support layer 700 in contact with the laser beam) on a first surface of the support layer 700 included in the base reinforcing film 7000. In an embodiment, such protrusion patterns BRa and BRb may be formed by melting portions of the support layer 700 by thermal energy of the laser beam, for example.

Thereafter, a driving test of the display cell DSC may be performed. In an embodiment, test signals may be applied to the pad area PDA of the display cell DSC. The test signals may be applied to pads PD of the pad area PDA, for example. For the driving test, one sides of the pads PD of the pad area PDA of FIG. 38 may be connected to each other. In other words, the pads PD of the pad area PDA of FIG. 38 are in a state before being separated from each other.

When it is confirmed that the display cell DSC operates normally as a result of the driving test of the display cell DSC, a process of cutting the pad area PDA of the display cell DSC may be performed. In an embodiment, a pad cutting process for the pad area PDA may be performed so that the pads PD of the pad area PDA are separated from each other, for example. In an embodiment, as illustrated in FIGS. 40 and 41, portions of the pads PD of the pad area PDA are cut by an intense light, e.g., a laser beam LB11, so that the pads PD may be electrically separated from each other, for example. The laser beam LB11 may move along a cutting line PCL crossing the pads PD of the pad area PDA.

As illustrated in FIG. 41, an edge of the pad PD (e.g., a side surface of the pad) may have an oblique shape by contact with the laser beam LB11.

In addition, as illustrated in FIG. 41, the edge of the unit reinforcing film 777 (e.g., the side surface of the unit reinforcing film 777) may have the oblique shape by contact with the laser beam LB11. In this case, protrusion patterns BRc and BR1 may be formed along edges of the support layer 700 (e.g., portions of the support layer 700 in contact with the laser beam LB11) on a first surface of the support layer 700 included in the unit reinforcing film 777. Here, the protrusion pattern BR1 may be the same as the first protrusion pattern BR1 of FIGS. 11 to 14 described above. In other words, the first protrusion pattern BR1 of FIGS. 11 to 14 may be formed by the laser beam LB11 irradiated during the cutting process of the pads PD described with reference to FIGS. 40 and 41.

Thereafter, as illustrated in FIGS. 42 and 43, a polarizing plate 310, a first reinforcing layer 600a, a driving chip IC, a flexible printed circuit board FPCB, a main circuit board MP, and a board cover 500 may be formed on the display cell DSC.

In an embodiment, the polarizing plate 310 may be disposed in the third direction z on a second surface 102 of the display cell DSC in the first area A1, the flexible printed circuit board FPCB may be disposed in the third direction z on the second surface 102 of the display cell DSC in the second area A2, the main circuit board MP may be connected to the flexible printed circuit board FPCB, and the first reinforcing layer 600a may be disposed in the third direction z on the second surface 102 of the display cell DSC in the third area A3, for example. In addition, the board cover 500 in contact with a first surface of the unit reinforcing film 777 (e.g., the first surface of the support layer 700), the side surface of the unit reinforcing film 777 (e.g., a side surface of the support layer 700 and a side surface of the second bonding layer 720), the side surface of the display cell DSC, the side surface of the pad PD, and a first surface of the flexible printed circuit board FPCB may be formed in the third reverse direction on the first surface of the flexible printed circuit board FPCB. In this case, a first surface 503 of the board cover 500 may cover the protrusion pattern BR1.

Subsequently, as illustrated in FIGS. 44 and 45, a processing process for the display cell DSC may be performed. Such a processing process may be performed by a laser device providing an intense light, e.g., a laser beam LB22. In an embodiment, as illustrated in FIGS. 44 and 45, the laser beam LB22 from the laser device may be irradiated from the lower side of the unit reinforcing film 777 toward the display cell DSC, and such a laser beam LB22 may move along a processing line MCL that is preset, for example. In an embodiment, protrusion patterns BRd and BRe may be formed on the first surface of the support layer 700 included in the unit reinforcing film 777 by contact with the laser beam LB22. Accordingly, the display cell DSC may be cut along the processing line MCL, and in this case, the display cell DSC may be manufactured into a display panel 100 having a desired shape. In an embodiment, the display cell DSC may be processed to have the display panel 100 with a shape as illustrated in FIG. 2 (or FIG. 3) described above, for example. As a predetermined example, by such a processing process, shapes and areas of the non-display area NDA, the first area A1, the second area A2, and the third area A3 of the display cell DSC may be changed to be the same as shapes and areas of the non-display area NDA, the first area A1, the second area A2, and the third area A3 of the display panel 100 illustrated in FIG. 2 (or FIG. 3) described above.

During the processing process for the display cell DSC described above, the unit reinforcing film 777, the first reinforcing layer 600a, and the polarizing plate 310 may also be cut together along the processing line MCL. In this case, the driving chip IC, the flexible printed circuit board FPCB, the main circuit board MP, and the board cover 500 do not cross the processing line MCL, and thus, may not be cut.

The processed display cell DSC may be substantially the same as the display panel 100 as illustrated in the FIG. 2 (or FIG. 3) described above. Accordingly, a shape of the processed display cell DSC may be the same as the shape of the display panel 100 as illustrated in the FIG. 2 (or FIG. 3) described above. Accordingly, the display area DA, the non-display area NDA, the first area A1, the second area A2, and the third area A3 of the processed display cell DSC may have the same shapes and areas as the display area DA, the non-display area NDA, the first area A1, the second area A2, and the third area A3 of the display panel 100 illustrated in FIG. 2 (or FIG. 3) described above, respectively.

The processed display cell DSC (e.g., the display panel 100) has been illustrated in FIGS. 46 and 47. Hereinafter, the processed display cell DSC will be also referred to as a display panel 100.

Subsequently, as illustrated in FIGS. 48 and 49, a process of cutting a portion of the unit reinforcing film 777 may be performed. To this end, in an embodiment, the unit reinforcing film 777 corresponding to an interface between the second area A2 and the third area A3 may be irradiated with an intense light, e.g., a laser beam LB33. In other words, the laser beam LB33 may be irradiated along a cutting line HCL extending along the interface between the second area A2 and the third area A3. In an embodiment, in order to prevent the display panel 100 from being damaged by the laser beam LB33, the unit reinforcing film 777 may be cut in a half-cut manner. In an embodiment, an interface between the second bonding layer 720 and the third bonding layer 730 corresponding to the interface between the second area A2 and the third area A3 may be cut in a half-cut manner, for example. Accordingly, the unit reinforcing film 777 may be cut by about half in the thickness direction at the interface between the second bonding layer 720 and the third bonding layer 730. In an embodiment, even after the cutting process of the unit reinforcing film 777, a portion of the second bonding layer 720 and a portion of the third bonding layer 730 may remain attached to each other, for example.

In this case, a surface of the unit reinforcing film 777 at the interface between the second bonding layer 720 and the third bonding layer 730 may have an oblique shape by contact with the laser beam LB33. In addition, protrusion patterns BR2 and BRf may be formed on the first surface of the support layer 700 included in the unit reinforcing film 777 by contact with the laser beam LB33. Here, the protrusion pattern BR2 may be the same as the second protrusion pattern BR2 of FIGS. 11 to 14 described above. In other words, the second protrusion pattern BR2 of FIGS. 11 to 14 may be formed by the laser beam LB33 irradiated during the cutting process of the unit reinforcing film 777 described with reference to FIGS. 48 and 49.

The support layer 700 may be separated into two portions (or completely separated) based on the half-cut portion of the unit reinforcing film 777. In an embodiment, the support layer 700 may be separated into a first support layer 701 and a second support layer 702, for example. Here, the first support layer 701 may overlap the first area A1 and the third area A3, and the second support layer 702 may overlap the second area A2. The unit reinforcing film 777 is cut in the half-cut manner, and accordingly, a portion corresponding to a partial thickness of a total thickness of the third bonding layer 730 may be removed and a portion corresponding to the remaining thickness of the total thickness of the third bonding layer 730 may remain, at the interface (e.g., the half-cut portion) between the second area A2 and the third area A3.

Next, as illustrated in FIGS. 50 and 51, a peeling process of the unit reinforcing film 777 may be performed. In this case, as described above, the adhesive strength of the second bonding layer 720 in the second area A2 may be greater than the adhesive strength of the first bonding layer 710 and may also be greater than the adhesive strength of the third bonding layer 730.

Accordingly, during the peeling process of the unit reinforcing film 777, based on the cut portion of the unit reinforcing film 777 (e.g., the portion of the unit reinforcing film 777 cut in the half-cut manner along the cutting line HCL), only the first support layer 701 and the bonding layers 710 and 730 of the first area A1 may be separated (or removed, or peeled) from the display panel 100, and the second support layer 702 and the second bonding layer 720 of the second area A2 may not be separated (or removed, or peeled) from the display panel 100. In other words, after the peeling process of the unit reinforcing film 777, only the second support layer 702 and the second bonding layer 720 of the components of the unit reinforcing film 777 may remain in a state in which they are attached to the second area A2 of the display panel 100. In an embodiment, when the unit reinforcing film 777 is separated (or peeled) from the display panel 100, a portion of the third bonding layer 730, the first support layer 701, and the first bonding layer 710 of the unit reinforcing film 777 may be selectively, that is exclusively, separated, and a remaining (the other) portion of the third bonding layer 730 and the second support layer 702 of the unit reinforcing film 777 may not be separated from the display panel 100 and may remain in the second area A2 of the display panel 100, for example.

The second support layer 702 and the second bonding layer 720 of FIG. 51 may be the same as the support layer 400 and the bonding layer 410 of FIGS. 11 to 14 described above, respectively. In other words, the support layer 400 and the bonding layer 410 of FIGS. 11 and 14 may be formed by the peeling process of the unit reinforcing film 777 described with reference to FIGS. 50 and 51.

Subsequently, as illustrated in FIGS. 32 and 33, an adhesive member 320, a heat dissipation member 330, a bending adhesive member 340, and a second reinforcing layer 600b may be formed on a first surface 101 of the display panel 100 of FIG. 51.

Thereafter, as illustrated in FIGS. 32 and 33 described above, a first hole H1 and a second hole H2 may be defined in the display panel 100. In addition, a first electronic component 551 may be disposed on the lower side of the heat dissipation member 330 so as to overlap the first hole H1, and a second electronic component 552 may be disposed on the lower side of the heat dissipation member 330 so as to overlap the second hole H2.

Next, as illustrated in FIG. 15, the display panel 100 may be bent toward the first surface 101 of the display panel 100 or the bending adhesive member 340 based on the bending axis BX (refer to FIG. 1) extending along the first direction x in the third area A3.

Subsequently, as illustrated in FIGS. 7 and 8, the first electronic component 551 may be disposed on the lower side of the heat dissipation member 330 so as to overlap the first hole H1, and the second electronic component 552 may be disposed on the lower side of the heat dissipation member 330 so as to overlap the second hole H2.

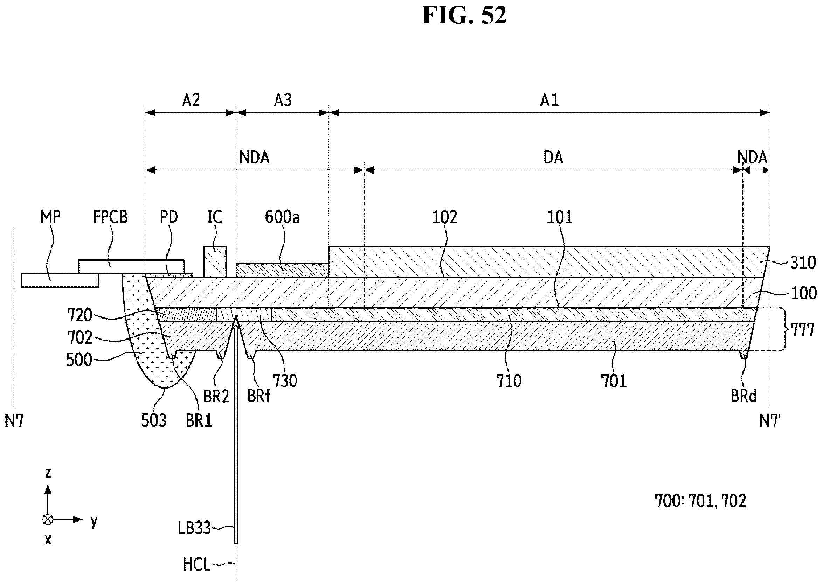

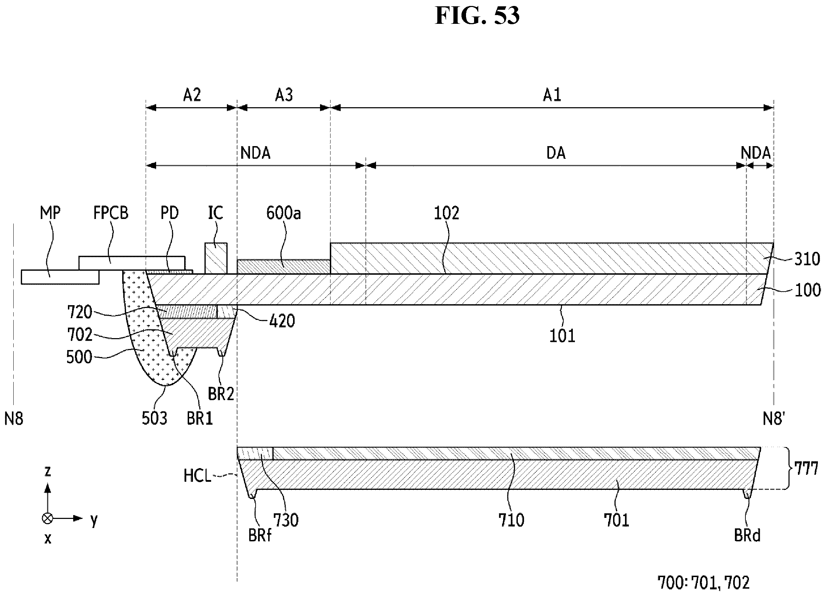

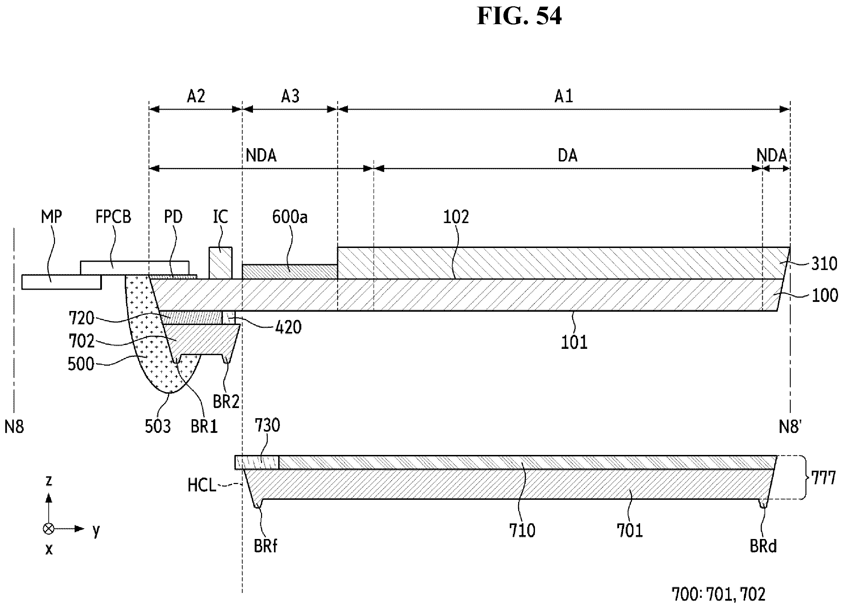

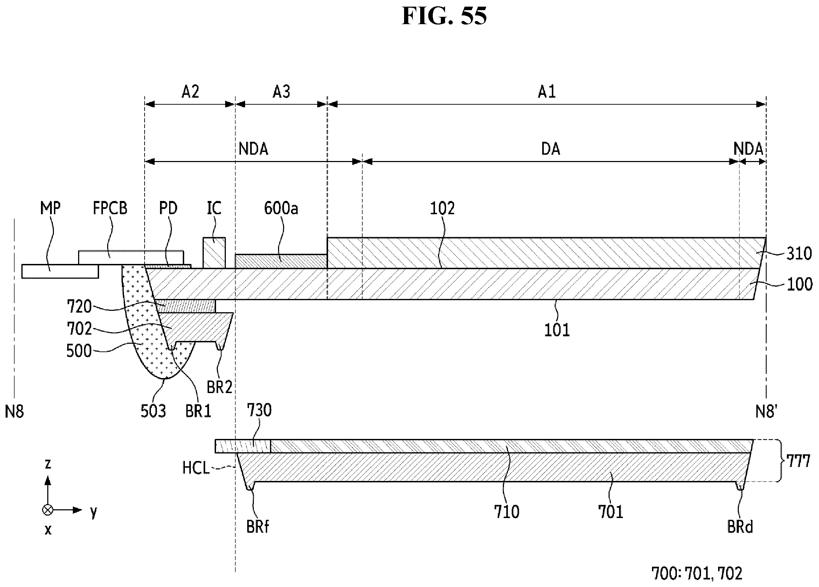

FIG. 52 is a view for describing another embodiment of a method of manufacturing a display device, FIG. 53 is a view for describing an embodiment of a shape of a dummy layer by a peeling process after a process of FIG. 52, FIG. 54 is a view for describing another embodiment of a shape of a dummy layer by a peeling process after a process of FIG. 52, and FIG. 55 is a view for describing another embodiment of a shape of a dummy layer by a peeling process after a process of FIG. 52.

A display device of FIG. 52 is different from the display device of FIG. 49 described above in a position of the interface between the second bonding layer 720 and the third bonding layer 730, and such a difference will be mainly described below.

Depending on an alignment state of the mother substrate MSUB and the base reinforcing film 7000 in FIG. 35, as illustrated in FIG. 52, the interface between the second bonding layer 720 and the third bonding layer 730 may not coincide with the interface between the second area A2 and the third area A3 of the display panel 100. Since the laser beam LB33 is irradiated based on the interface between the second area A2 and the third area A3 of the display panel 100 during a half-cut process of the unit reinforcing film 777, when a portion of the third bonding layer 730 is disposed at the interface between the second area A2 and the third area A3 as illustrated in FIG. 52, the third bonding layer 730 may be cut in a half-cut manner. When the above-described peeling process is performed after the process of FIG. 52, the display device may have a configuration as illustrated in FIGS. 12 to 14 described above.

In an embodiment, when the third bonding layer 730 is accurately removed based on a half-cut portion as illustrated in FIG. 53 during the peeling process after the process of FIG. 52, the display device 1 may include a dummy layer 420 having a shape as illustrated in FIGS. 12 and 53, for example.

In addition, when the third bonding layer 730 is removed more based on a half-cut portion as illustrated in FIG. 54 during the peeling process after the process of FIG. 52, the display device 1 may include a dummy layer 420 having a shape as illustrated in FIGS. 13 and 54.

In addition, when the third bonding layer 730 is completely removed as illustrated in FIG. 55 during the peeling process after the process of FIG. 52, the display device 14 may not include a dummy layer as illustrated in FIGS. 14 and 55.

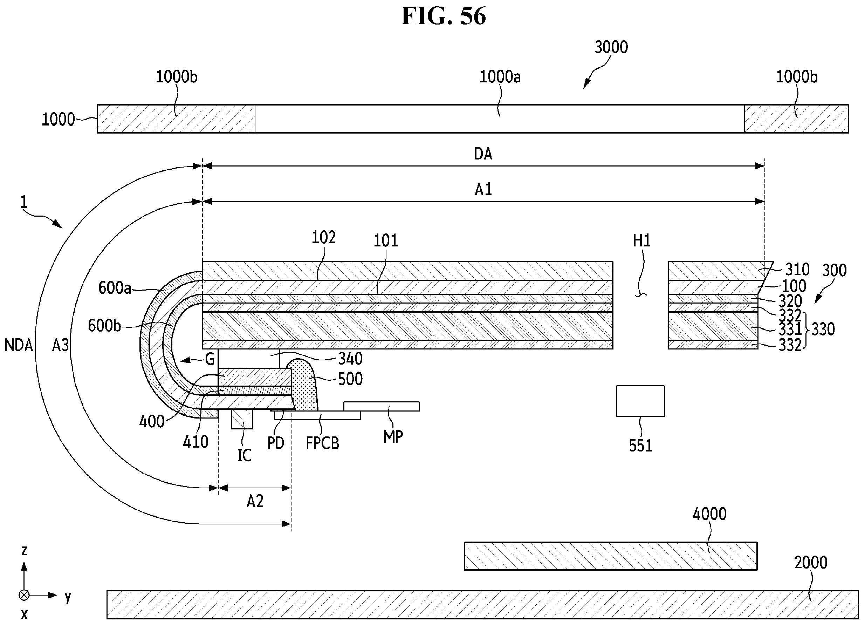

FIG. 56 is a cross-sectional view of an embodiment of an electronic device.

An electronic device 3000 in an embodiment may include a lower cover 2000, a display device 1, a battery 4000, and a cover window 1000, as illustrated in FIG. 56.

The lower cover 2000 may form an appearance of a first surface of the electronic device 3000. The lower cover 2000 may include plastic, metal, or both plastic and metal.

The display device 1 may be disposed on the lower cover 2000. In an embodiment, the display device 1 may be disposed between the lower cover 2000 and the cover window 1000, for example. The display device 1 of FIG. 51 may be the same as any one of the display devices 1 as illustrated in FIGS. 1 to 15 described above.

The cover window 1000 may be disposed above the display device 1 in the third direction z so as to cover a second surface of the display device 1. The cover window 1000 may serve to protect the second surface of the display device 1.

The cover window 1000 may include a transmitting portion 1000a corresponding to the display area DA of the display device 1 and a light-blocking portion 1000b corresponding to the non-display area NDA of the display device 1. The light-blocking portion 1000b may be formed opaquely. In an alternative embodiment, the light-blocking portion 1000b may be formed as a decorative layer on which a pattern that may be viewed to a user is formed when an image is not displayed.

The battery 4000 may supply power to the display device 1. The battery 4000 may be disposed on the lower cover 2000. In an embodiment, the battery 4000 may be disposed between the lower cover 2000 and the display device 1, for example. As a predetermined example, the battery 4000 may be disposed between the lower cover 2000 and the display device 1 so as to overlap the first area A1 of the display panel 100. The battery 4000 does not overlap the support layer 400.

In an embodiment, the support layer 400 and the bonding layer 410 are disposed only in the second area A2 of the display panel 100. Accordingly, when the display panel 100 is bent toward the first surface 101 of the display panel 100, a bending area may have a shape more similar to a curved line by the support layer 400 of the second area A2. In addition, a curvature of the bending area may become smaller by the support layer 400 of the second area A2, such that it is possible to make the display device 1 slim. Further, since the bending area of the display panel 100 is supported by the support layer 400, bending work of the display panel 100 may become easier. Further, since the bending area of the display panel 100 is supported by the support layer 400, even though the curvature of the bending area becomes small, damage to the display panel 100 may be prevented.

In an embodiment, the support layer 400 and the bonding layer 410 are not disposed in the first area A1 of the display panel 100. Accordingly, a thickness of the display device 1 in the first area A1 may be reduced. Accordingly, an extra space between the display device 1 and the lower cover 2000 may be sufficiently secured. A space in which the battery 4000 is to be disposed may be sufficiently secured through such an extra space. In an alternative embodiment, a great battery 4000 with a greater capacity may be disposed (e.g., mounted) through such an extra space.

With the method of manufacturing a display device according to the invention as described above, a manufacturing cost may be reduced, and a display device whose thickness may be reduced may be provided.

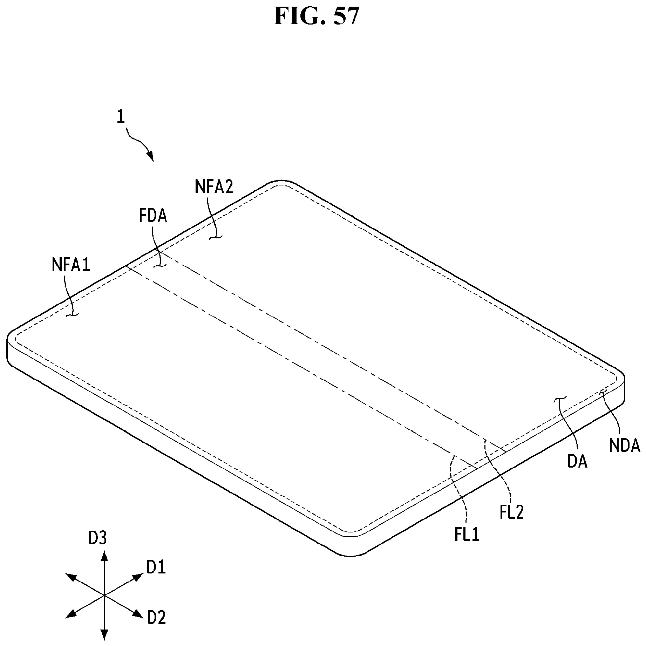

The display device in an embodiment may be a foldable display device, which will be described below with reference to FIGS. 57 to 60.

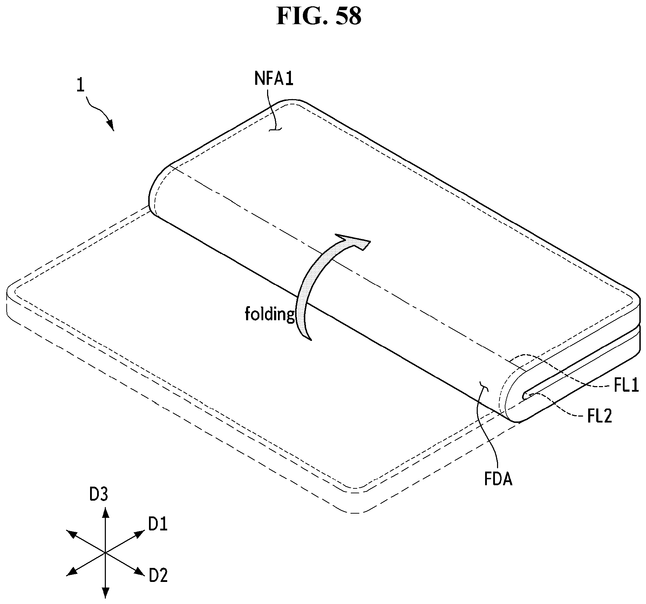

FIG. 57 is a perspective view illustrating an embodiment of an unfolded state of a display device 1 according to the invention. FIG. 58 is a perspective view illustrating an embodiment of a folded state of the display device 1 according to the invention.

Referring to FIGS. 57 and 58, a first state of a display device 1 that is not bent at folding lines FL1 and FL2 and is unfolded is illustrated in FIG. 57, and a second state of the display device 1 that is bent at the folding lines FL1 and FL2 is illustrated in FIG. 58.

The display device 1 in an embodiment of the invention is a device that displays a moving image or a still image, and may be used as a display screen of each of various products such as televisions, laptop computers, monitors, billboards, and the Internet of Things ("IoT") as well as portable electronic devices such as mobile phones, smartphones, tablet personal computers, smart watches, watch phones, mobile communication terminals, electronic notebooks, electronic books, portable multimedia players ("PMPs"), navigation devices, and ultra mobile personal computers ("UMPCs"). In an alternative embodiment, the display device 1 may be used as a display screen applied to a center fascia of a vehicle. Hereinafter, it will be mainly described that the display device 1 in an embodiment is a smartphone, but the invention is not limited thereto.

The display device 1 may be a light-emitting display device such as an organic light-emitting display using organic light-emitting diodes, a quantum dot light-emitting display including quantum dot emission layers, an inorganic light-emitting display including inorganic semiconductors, and a micro light-emitting display using micro light-emitting diodes (micro LEDs). Hereinafter, it will be mainly described that the display device 1 is the organic light-emitting display, but the invention is not limited thereto.

In FIGS. 57 and 58, a first direction D1 is a direction parallel to one side of the display device 1 in a plan view, and may be a transverse direction of the display device 1, for example. A second direction D2 is a direction parallel to another side of the display device 1 in contact with one side of the display device1 in a plan view, and may be a longitudinal direction of the display device 1. A third direction D3 may be a thickness direction of the display device 1.

The display device 1 may have a quadrangular shape such as a quadrangular shape, e.g., rectangular shape in a plan view. Each of corners of the display device 1 may have a right-angle shape in a plan view or a round shape in a plan view. A front surface of the display device 1 may include two short sides disposed in the first direction D1 and two long sides disposed in the second direction D2.

The display device 1 may include a display area DA and a non-display area NDA. A shape of the display area DA in a plan view may follow the shape of the display device 1 in a plan view. In an embodiment, when the shape of the display device 1 in a plan view is the quadrangular shape, e.g., rectangular shape, the shape of the display area DA in a plan view may also be a quadrangular shape, e.g., rectangular shape.

The display area DA may be an area displaying an image by including a plurality of pixels PX (refer to FIG. 2). The non-display area NDA may be an area that does not display an image because it does not include pixels PX. The non-display area NDA may be disposed around the display area DA. The non-display area NDA may be disposed to surround the display area DA, but the invention is not limited thereto. The display area DA may be partially surrounded by the non-display area NDA.

The display device 1 may be maintained in both a first state, which is an unfolded state, and a second state, which is a bent state. The display device 1 may be folded in an in-folding manner so that the display areas DA face each other, as illustrated in FIG. 58. In this case, front surfaces of the display device 1 may face each other when the display device 1 is folded. In an alternative embodiment, the display device 1 may be folded in an out-folding manner so that rear surfaces thereof face each other.

The display device 1 may include a folding area FDA, a first non-folding area NFA1, and a second non-folding area NFA2. The folding area FDA may be an area where the display device 1 is bent or folded, and the first non-folding area NFA1 and the second non-folding area NFA2 may be areas where the display device 1 is not bent or folded. In an embodiment, the first non-folding area NFA1 and the second non-folding area NFA2 may be flat areas of the display device 1.

The first non-folding area NFA1 may be disposed on one side, e.g., the left side, of the folding area FDA. The second non-folding area NFA2 may be disposed on an opposite side, e.g., the right side, of the folding area FDA. The folding area FDA is an area defined by a first folding line FL1 and a second folding line FL2, and may be an area where the display device 1 is bent with a predetermined curvature. The first folding line FL1 may be a boundary between the folding area FDA and the first non-folding area NFA1, and the second folding line FL2 may be a boundary between the folding area FDA and the second non-folding area NFA2.

The first folding line FL1 and the second folding line FL2 may extend in the second direction D2 as illustrated in FIGS. 57 and 58, and in this case, the display device 1 may be folded along the first direction D1. For this reason, a length of the display device 1 in the first direction D1 may be reduced by approximately half, and thus, a user may conveniently carry the display device 1.

When the first folding line FL1 and the second folding line FL2 extend in the second direction D2 as illustrated in FIGS. 57 and 58, a length of the folding area FDA in the second direction D2 may be greater than a length of the folding area FDA in the first direction D1. In addition, a length of the first non-folding area NFA1 in the second direction D2 may be greater than a length of the first non-folding area NFA1 in the first direction D1. A length of the second non-folding area NFA2 in the second direction D2 may be greater than a length of the second non-folding area NFA2 in the first direction D1.

Each of the display area DA and the non-display area NDA may overlap at least one of the folding area FDA, the first non-folding area NFA1, and the second non-folding area NFA2. It has been illustrated in FIGS. 57 and 58 that each of the display area DA and the non-display area NDA overlaps the folding area FDA, the first non-folding area NFA1, and the second non-folding area NFA2.

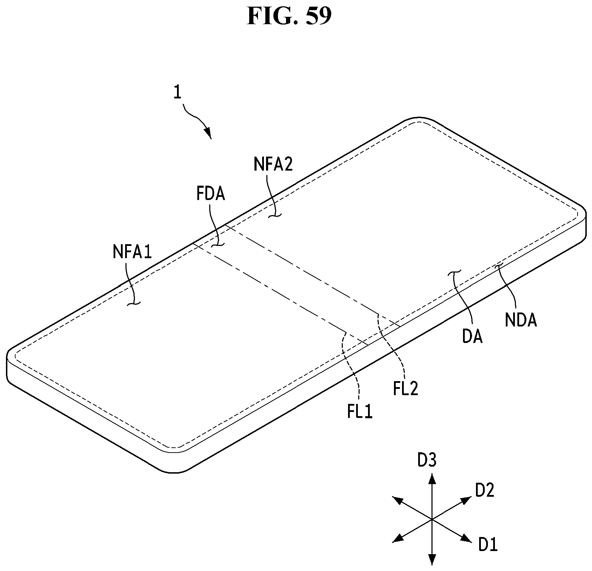

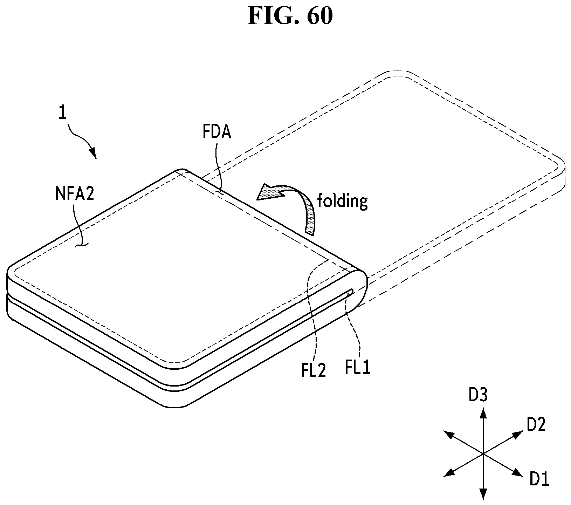

FIG. 59 is a perspective view illustrating another embodiment of an unfolded state of a display device 1. FIG. 60 is a perspective view illustrating another embodiment of a folded state of the display device 1.

Another embodiment of FIGS. 59 and 60 is different from an embodiment of FIGS. 57 and 58 in that the first folding line FL1 and the second folding line FL2 extend in the first direction D1, and the display device 1 is folded in the second direction D2, and thus, a length of the display device 1 in the second direction D2 is reduced by approximately half. Therefore, in FIGS. 59 and 60, a description of contents overlapping those of an embodiment of FIGS. 57 and 58 will be omitted.

Referring to FIGS. 59 and 60, a first state of a display device 1 that is not bent at folding lines FL1 and FL2 and is unfolded is illustrated in FIG. 59, and a second state of the display device 1 that is bent at the folding lines FL1 and FL2 is illustrated in FIG. 60.

In the first state in which the display device 1 is unfolded, long sides of the display device 1 may extend along the second direction D2, and short sides of the display device 1 may extend along the first direction D1.

The first folding line FL1 and the second folding line FL2 may extend in the first direction D1 as illustrated in FIGS. 59 and 60, and in this case, the display device 1 may be folded along the second direction D2.

The first non-folding area NFA1 may be disposed on one side, e.g., the lower side, of the folding area FDA. The second non-folding area NFA2 may be disposed on an opposite side, e.g., the upper side, of the folding area FDA.

When the first folding line FL1 and the second folding line FL2 extend in the first direction D1 as illustrated in FIGS. 59 and 60, a length of the folding area FDA in the first direction D1 may be greater than a length of the folding area FDA in the second direction D2. In addition, a length of the first non-folding area NFA1 in the second direction D2 may be greater than a length of the first non-folding area NFA1 in the first direction D1. A length of the second non-folding area NFA2 in the second direction D2 may be greater than a length of the second non-folding area NFA2 in the first direction D1.

The display device in the embodiment may be applied to various electronic devices. The electronic device in an embodiment includes the display device described above and may further include modules or devices having additional functions in addition to the display device.

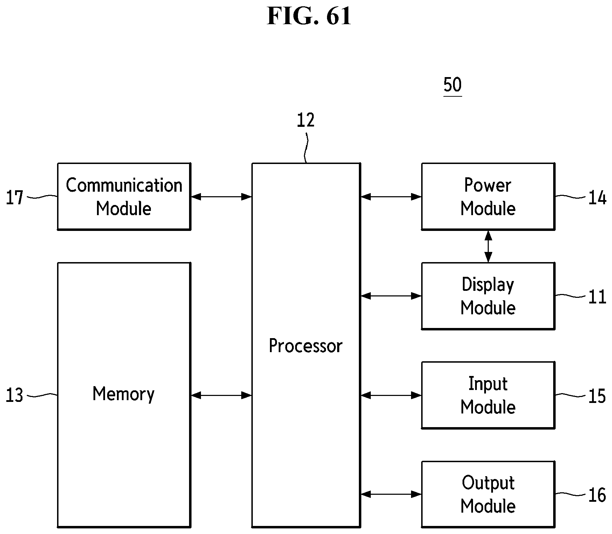

FIG. 61 is a block diagram of an embodiment of an electronic device. Referring to FIG. 61, the electronic device 50 in an embodiment may include a display module 11, a processor 12, a memory 13, and a power module 14. The electronic device 50 may further include an input module 15, a non-image output module (also referred to as an output module) 16 and/or a communication module 17.

The electronic device 50 may output various information in the form of images through the display module 11. When the processor 12 executes an application stored in the memory 13, image information provided by the application may be provided to the user through the display module 11. The power module 14 may include a power supply module such as a power adapter or a battery device, and a power conversion module that converts the power supplied by the power supply module to generate power desired for the operation of the electronic device 50. The input module 15 may provide input information to the processor 12 and/or the display module 11. The non-image output module 16 may receive information other than images transmitted from the processor 12, such as sound, haptics, and light, and provide the information to the user. The communication module 17 is a module that is responsible for transmitting and receiving information between the electronic device 50 and an external device, and may include a receiving unit and a transmitting unit.

At least one of the components of the electronic device 50 described above may be included in the display device in the embodiments described above. In addition, some of the individual modules functionally included in one module may be included in the display device, and others may be provided separately from the display device. In an embodiment, the display device includes a display module 11, and the processor 12, memory 13, and power module 14 may be provided in the form of other devices within the electronic device 50 other than the display device, for example.

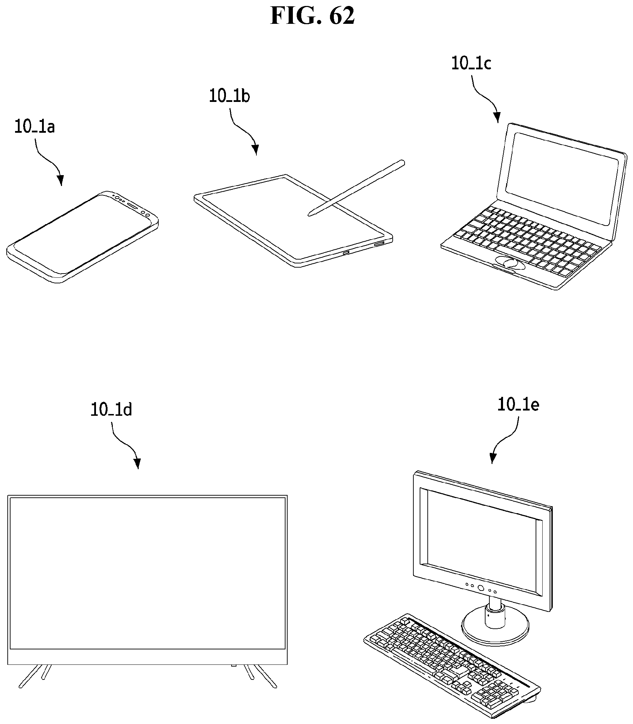

FIGS. 62, 63, and 64 are schematic diagrams of electronic devices according to various embodiments. FIGS. 61 to 64 illustrate embodiments of various electronic devices to which the display device is applied.

FIG. 62 illustrates a smartphone 10_1a, a tablet personal computer 10_1b, a laptop 10_1c, a television ("TV") 10_1d, and a desk monitor 10_1e as embodiments of electronic devices.

In addition to the display module 11, the smartphone 10_1a may include an input module such as a touch sensor and a communication module. The smartphone 10_1a may process information received through the communication module or other input modules and display the information through the display module of the display device.

In the case of tablet PCs 10_1b, laptops 10_1c, TVs 10_1d, and desk monitors 10_1e, they also include display modules and input modules similar to smartphones 10_1, and may additionally include communication modules in some cases.

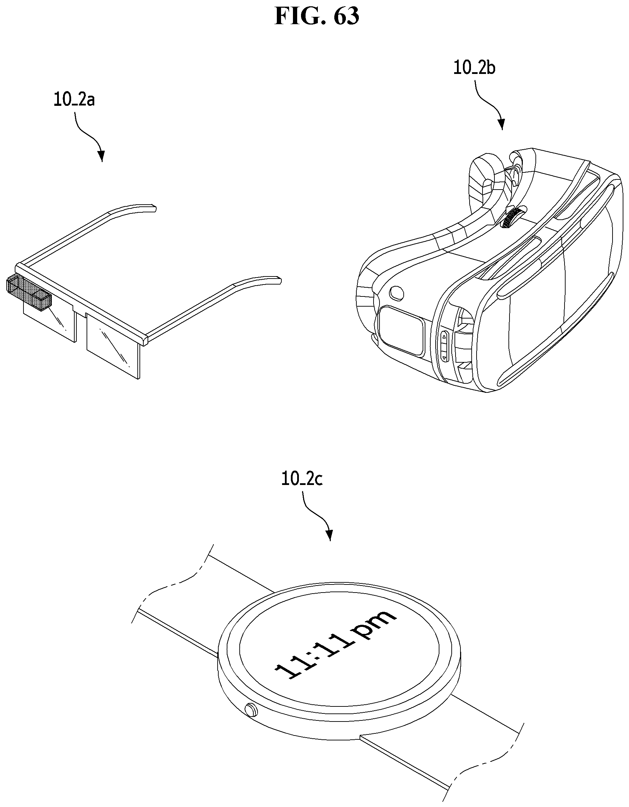

Fig. 63 shows an embodiment of an electronic device including a display module being applied to a wearable electronic device. The wearable electronic device may be a smart glasses 10_2a, a head-mounted display 10_2b, a smart watch 10_2c, etc.

The smart glasses 10_2a and the head-mounted display 10_2b may include a display module that emits a display image and a reflector that reflects the emitted display screen and provides it to the user's eyes, thereby providing a virtual reality or augmented reality screen to the user.

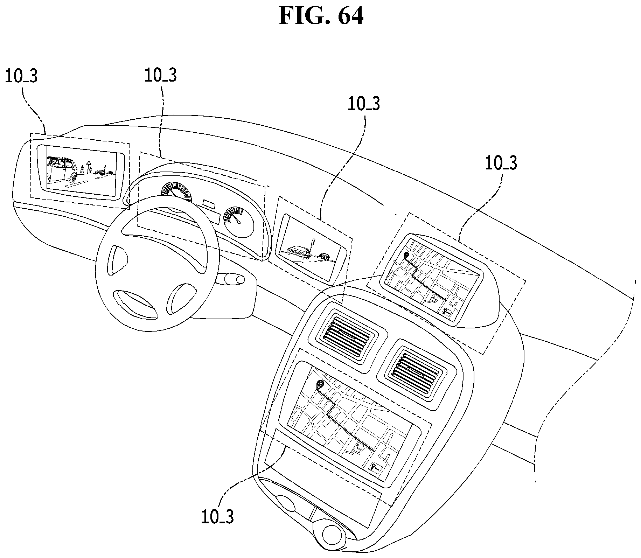

The smart watch 10_2c includes a biometric sensor as an input device, and may provide biometric information recognized by the biometric sensor to the user through the display module. Fig. 64 illustrates a case where an electronic device including a display module is applied to a vehicle. In an embodiment, the electronic device 10_3 may be applied to a dashboard, center fascia, etc., of a vehicle, or may be applied to a center information display ("CID") placed on a dashboard of a vehicle, or a room mirror display replacing a side mirror, for example.

In concluding the detailed description, those skilled in the art will appreciate that many variations and modifications may be made to the preferred embodiments without substantially departing from the principles of the invention. Therefore, the disclosed preferred embodiments of the invention are used in a generic and descriptive sense only and not for purposes of limitation.

## Claims

1. A display device (1) comprising:
a display panel (100) including:
a first surface (101);
a second surface (102) opposite to the first surface (101);
a display panel side surface (103) extending to the first surface (101) and the second surface (102); and
a base substrate (110) including:
a first area (A1) including a display area (DA);
a second area (A2); and
a third area (A3) disposed between the first area (A1) and the second area (A2);
a pixel (PX) disposed on the second surface (102) of the display panel (100) in the display area (DA);
a pad (PD) disposed on the second surface (102) of the display panel (100) in the second area (A2);
a first circuit board (FPCB) connected to the pad (PD), the first circuit board (FPCB) including:
a first circuit board surface;
a support layer (400) disposed on the first surface (101) of the display panel (100), the support layer (400) including:
a support layer side surface (401a, 410a); and
a board cover (500) disposed on the display panel side surface (103), the support layer side surface (401a, 410a), and the first circuit board surface,
wherein the support layer (400) is disposed on the first surface (101) of the display panel (100) in the second area (A2), and
the board cover (500) extends downward more than the support layer (400).

2. The display device (1) of claim 1, wherein a first hole (H1) is defined through the display panel (100) in the display area (DA).

3. The display device (1) of claim 2, wherein the support layer (400) does not overlap the first area (A1) and the third area (A3).

4. The display device (1) of claim 2 or 3, further comprising:
a heat dissipation member (330) disposed on the first surface (101) of the display panel (100) in the first area (A1),
wherein a second hole (H2) is defined through the heat dissipation member (330) in the display area (DA) of the first area (A1),
the first hole (H1) further penetrates through the heat dissipation member (330) in the display area (DA), and
the support layer (400) does not overlap the first hole (H1) and the second hole (H2).

5. The display device (1) of at least one of claims 1 to 4, wherein when an interface between the first circuit board (FPCB) and the board cover (500) is defined as a reference surface (502), a height (HE1) of the board cover (500) from the reference surface (502) is greater than a height (HE2) of the support layer (400) from the reference surface (502).

6. The display device (1) of at least one of claims 1 to 5, wherein a first surface (503) of the board cover (500) extends downward more than a first support layer surface (410d).

7. The display device (1) of claim 6, wherein the board cover (500) includes an extension portion (513) including the first surface (503) of the board cover (500) and extending downward more than the support layer (400), and
the extension portion (513) of the board cover (500) is not in contact with the support layer (400).

8. The display device (1) of claim 6 or 7, wherein an angle (θa) between the display panel side surface (103) in contact with the board cover (500) and the second surface (102) of the display panel (100) is smaller than an angle (θb) between the support layer side surface (401a, 410a) in contact with the board cover (500) and the second surface (102) of the display panel (100).

9. The display device (1) of at least one of claims 1 to 8, further comprising a bonding layer (410) disposed between the support layer (400) and the display panel (100),
wherein the bonding layer (410) is exclusively disposed between the support layer (400) and the first surface (101) of the display panel (100) in the second area (A2).

10. The display device (1) of at least one of claims 1 to 9, wherein when the display panel (100) is bent based in the third area (A3) so that the first circuit board (FPCB) and the support layer (400) are disposed on the first surface (101) of the display panel (100), the first surface (101) of the display panel (100) in the second area (A2) and the first surface (101) of the display panel (100) in the first area (A1) are parallel to each other.

11. The display device (1) of at least one of claims 1 to 10, further comprising an adhesive member (320) disposed on the first surface (101) of the display panel (100) in the first area (A1),
wherein when a direction crossing an arrangement direction of the first area (A1), the third area (A3), and the second area (A2) is defined as a horizontal direction, a size of the adhesive member (320) in the horizontal direction in the first area (A1) is smaller than a size of the display panel (100) in the horizontal direction in the first area (A1).

12. The display device (1) of claim 11, wherein in a plan view, both edges of the adhesive member (320) opposing each other in the horizontal direction are disposed between both edges of the display panel (100) opposing each other in the horizontal direction.

13. The display device (1) of at least one of claims 1 to 12, wherein the support layer (400) includes a first protrusion pattern (BR1) and a second protrusion pattern (BR2) which protrudes from a first support layer surface (410d).

14. The display device (1) of claim 13, wherein the first protrusion pattern (BR1) and the second protrusion pattern (BR2) are formed by melting portions of the support layer (400) by thermal energy of light.

15. The display device (1) of claim 13 or 14, wherein the first protrusion pattern (BR1) is disposed close to a first support layer side surface (410a) at one edge of the first support layer surface (410d), and
the second protrusion pattern (BR2) is disposed close to a second support layer side surface (410b) at an opposed edge of the first support layer surface (410d).
